(19) Europäisches Patentamt / European Patent Office / Office européen des brevets

(11) **EP 3 295 201 B1**

(12) **FASCICULE DE BREVET EUROPEEN**

(45) Date de publication et mention
de la délivrance du brevet:
**01.12.2021 Bulletin 2021/48**

(51) Int Cl.:
*G01R 33/54* [(2006.01)]     *G01R 33/561* [(2006.01)]
*G01R 33/563* [(2006.01)]     *G01R 33/44* [(2006.01)]
*G01R 33/50* [(2006.01)]

(21) Numéro de dépôt: **16725787.2**

(22) Date de dépôt: **12.05.2016**

(86) Numéro de dépôt international:
**PCT/EP2016/060777**

(87) Numéro de publication internationale:
**WO 2016/180947 (17.11.2016 Gazette 2016/46)**

(54) **PROCEDE ET DISPOSITIF D'IMAGERIE PAR RESONANCE MAGNETIQUE**

VERFAHREN UND VORRICHTUNG ZUR BILDGEBUNG MITTELS MAGNETRESONANZ

METHOD AND DEVICE FOR IMAGING BY MAGNETIC RESONANCE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.05.2015 FR 1554358**

(43) Date de publication de la demande:
**21.03.2018 Bulletin 2018/12**

(73) Titulaires:
• **Université Paris-Saclay
91190 Gif-sur-Yvette (FR)**
• **Centre National de la Recherche Scientifique
75016 Paris (FR)**

(72) Inventeur: **DE ROCHEFORT, Ludovic Marie Xavier
13007 Marseille (FR)**

(74) Mandataire: **IPAZ
Parc Les Algorithmes, Bâtiment Platon
CS 70003 Saint-Aubin
91192 Gif-sur-Yvette Cedex (FR)**

(56) Documents cités:
**US-A1- 2006 152 219**

• **SAMUEL A. HURLEY ET AL: "Simultaneous
variable flip angle-actual flip angle imaging
method for improved accuracy and precision of
three-dimensional T1 and B1 measurements",
MAGNETIC RESONANCE IN MEDICINE., vol. 68,
no. 1, 2 décembre 2011 (2011-12-02), pages 54-64,
XP055250908, US ISSN: 0740-3194, DOI:
10.1002/mrm.23199 cité dans la demande**
• **MATTHIAS C SCHABEL ET AL: "Uncertainty in
T1 mapping using the variable flip angle method
with two flip angles; Uncertainty in VFA T
mapping", PHYSICS IN MEDICINE AND
BIOLOGY, INSTITUTE OF PHYSICS PUBLISHING,
BRISTOL GB, vol. 54, no. 1, 7 janvier 2009
(2009-01-07), pages N1-N8, XP020149779, ISSN:
0031-9155, DOI: 10.1088/0031-9155/54/1/N01 cité
dans la demande**
• **GILAD LIBERMAN ET AL: "T1 Mapping using
variable flip angle SPGR data with flip angle
correction", JOURNAL OF MAGNETIC
RESONANCE IMAGING, vol. 40, no. 1, 25
novembre 2013 (2013-11-25), pages 171-180,
XP055250913, US ISSN: 1053-1807, DOI:
10.1002/jmri.24373 cité dans la demande**
• **H. BRUDER ET AL: "A new steady-state imaging
sequence for simultaneous acquisition of two MR
images with clearly different contrasts",
MAGNETIC RESONANCE IN MEDICINE., vol. 7,
no. 1, 1 mai 1988 (1988-05-01), pages 35-42,
XP055250919, US ISSN: 0740-3194, DOI:
10.1002/mrm.1910070105 cité dans la demande**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

- **CARL GANTER ET AL: "B1+-mapping with the transient phase of unbalanced steady-state free precession", MAGNETIC RESONANCE IN MEDICINE., vol. 70, no. 6, 4 février 2013 (2013-02-04), pages 1515-1523, XP055250918, US ISSN: 0740-3194, DOI: 10.1002/mrm.24598 cité dans la demande**
- **PAULO LOUREIRO DE SOUSA ET AL: "Factors controlling T2 mapping from partially spoiled SSFP sequence: Optimization for skeletal muscle characterization", MAGNETIC RESONANCE IN MEDICINE., vol. 67, no. 5, 16 août 2011 (2011-08-16), pages 1379-1390, XP055250921, US ISSN: 0740-3194, DOI: 10.1002/mrm.23131 cité dans la demande**
- **OLIVER BIERI ET AL: "Quantitative in vivo diffusion imaging of cartilage using double echo steady-state free precession", MAGNETIC RESONANCE IN MEDICINE., vol. 68, no. 3, 12 décembre 2011 (2011-12-12), pages 720-729, XP055250920, US ISSN: 0740-3194, DOI: 10.1002/mrm.23275 cité dans la demande**
- **DAN MA ET AL: "Magnetic resonance fingerprinting", NATURE, vol. 495, no. 7440, 13 mars 2013 (2013-03-13), pages 187-192, XP055183037, ISSN: 0028-0836, DOI: 10.1038/nature11971 cité dans la demande**

**Description**

**Domaine technique**

La présente invention concerne un procédé d'imagerie par résonance magnétique (IRM). Elle concerne aussi un dispositif mettant en œuvre ce procédé.

Un tel procédé ou dispositif peut permettre par exemple de préférence à un utilisateur la génération et l'exploitation d'images co-localisées, de même résolution spatiale, de même temps d'écho (TE) et de répétition (TR) pour l'aimantation nucléaire, les temps de relaxation longitudinal (T1) et transverse (T2), le coefficient de diffusion (D), de l'amplitude du champ radiofréquence (B1) et des inhomogénéités du champ magnétique principal B0.

**Etat de la technique antérieure**

L'IRM est une modalité d'imagerie clinique et préclinique utilisée en routine dans le diagnostic médical radiologique ou pour l'évaluation de modèles animaux. Son aspect non invasif et les multiples contrastes disponibles la rendent indispensable dans l'évaluation de nombreuses maladies. Un examen typique d'IRM contient un protocole d'acquisition de plusieurs séquences d'imagerie ayant chacune un objectif différent. Les séquences dites 'en densité de proton' vont renseigner sur la quantité d'eau libre dans le tissu. Les séquences dites 'pondérées-T1' servent en général à l'évaluation anatomique car elles génèrent un bon contraste entre les tissus biologiques. Les séquences 'pondérées-T1' servent également à visualiser des agents de contraste qui peuvent être injectés en angiographie ou pour la caractérisation tumorale. Les séquences dites 'pondérées-T2' ont globalement la propriété de permettre de bien distinguer les contenus liquidiens et renseignent par exemple sur la présence d'œdèmes. Là encore, des agents de contraste dit T2 peuvent être utilisés pour moduler la pondération T2 pour certaines applications. La diffusion, qui influence également le contraste des images générées avec des séquences particulières dite 'pondérées en diffusion' sont également utilisées pour pousser la caractérisation tissulaire, par exemple pour distinguer les zones viables des zones nécrotiques dans les tumeurs, une distinction pas toujours possible avec les autres types de pondération, ou pour faire de la tractographie de fibres cérébrales basée sur la direction privilégiée de la diffusion de l'eau. En fonction de la maladie étudiée et de la zone anatomique, plusieurs séquences sont appliquées lors d'un examen. Celles-ci sont appliquées de manière séquentielle, ce qui nécessité déjà un temps de paramétrage des manipulateurs en électroradiologie pour adapter chaque séquence à la zone étudiée. Pour des contraintes de temps d'acquisition, de type de pondération et localisation, les différentes informations ne sont en général pas acquises avec les mêmes résolutions spatiales, ne couvrent pas les mêmes champs de vue et peuvent même souffrir de déformations spatiales différentes en fonction notamment des temps d'écho et des bandes passantes d'acquisition différents. On citera par exemple la nécessité dans certains cas d'avoir recours à une correction des images a posteriori ou à des techniques de recalage d'image pour compenser partiellement ces effets. Ces aspects concourent à rendre l'IRM soit limitée à une interprétation exclusivement basée sur des comparaisons visuelles, soit à introduire des biais ou des imprécisions résultant des algorithmes de correction. Pour améliorer le diagnostic, Il y a donc un besoin de pouvoir colocaliser exactement à l'échelle des mêmes voxels d'imagerie les différentes informations. Par ailleurs, le choix des séquences appliquées et le paramétrage des séquences incombent à chaque centre de radiologie, et les implémentations des séquences peuvent varier entre les constructeurs. Il n'existe pas de standard de séquence et de paramètres associés applicables dans tous les cas. Ces éléments rendent difficiles la comparaison multi-centriques des résultats d'imagerie et ralentissent, voire empêchent, l'établissement de consensus sur les séquences et sur leur paramétrage. Pour fiabiliser le diagnostic, la quantification directe des paramètres physiques tels que l'aimantation nucléaire, les T1 et T2, et le coefficient de diffusion est une possibilité permettant de standardiser les résultats d'imagerie.

Là encore, pour quantifier les différents paramètres T1, T2 et le coefficient de diffusion, de multiples séquences existent, chacune adaptée au paramètre à quantifier. On citera par exemple la séquence d'inversion-récupération avec plusieurs temps d'inversion pour quantifier T1, la séquence d'écho de spin avec plusieurs temps d'écho de spin pour quantifier T2, la séquence d'écho de spin pondéré en diffusion pour quantifier le coefficient de diffusion. Ces différents motifs de sensibilisation peuvent ensuite être combinés avec différentes séquences permettant la localisation avec tous les désavantages précités de déformation spatiale entre les acquisitions, de champ de vue ou zone couvertes différents, réduisant la possibilité de coupler voxel à voxel les paramètres extraits.

Une séquence standard rapide d'acquisition est basée sur l'écho de gradient rapide. Cette séquence d'imagerie consiste à répéter tous les TR un motif incluant une excitation d'amplitude fixe, éventuellement combinée à un gradient dit 'de sélection' pour réaliser une sélection spatiale, suivie de gradients d'imagerie (de lecture et de codages de phase). De multiples variantes de cette séquence ont été proposées. Pour synthétiser les différences entre les variantes, on notera les éléments suivants :

- la compensation totale des aires de gradient entre les répétitions (séquence dite balancée), ou au contraire la non-compensation de cette aire de gradient (séquence dite non-balancée). Cette dernière variante non-balancée créée des ordres de cohérence différents qui peuvent éventuellement être exploités. Un ordre de cohérence est noté k. C'est un nombre entier qui correspond à l'ordre de la série de Fourier discrète qui peut être utilisée pour décrire les états de configuration de l'aimantation, comme proposé et utilisé dans l'art.

- Le cyclage particulier de la phase $\theta_n$ de l'impulsion radiofréquence à la répétition $n$ sans changer son amplitude avec $\theta_{n+1} = \theta_n + (n + 1)\Delta$. Les variantes travaillent soit à phase fixe en fonction des répétitions ($\Delta = 0$), soit avec un cyclage quadratique de la phase ($\Delta \neq 0$), équivalent à un incrément $\Delta$ constant et non nul d'une répétition à l'autre. $\Delta$ est bien entendu défini modulo $2\pi$

- La mesure entre les impulsions de 1 ou plusieurs échos, notamment correspondant aux ordres de cohérence de phase (k=0, en général le seul acquis, et/ou k=-l et/ou k=1 qui peuvent l'être également)

- L'ajout ou non de gradients supplémentaires entre les impulsions pour sensibiliser de manière différente à la diffusion

- L'acquisition du signal pendant la phase transitoire ou pendant la phase stationnaire. Pour la phase transitoire, l'aimantation de départ peut être l'état d'équilibre thermique ou un état préparé à l'aide de motifs de préparation et l'information utilisée pour l'analyse est la variation du signal en fonction des répétitions. L'acquisition stationnaire est, au contraire, basée sur l'acquisition d'un équilibre dynamique atteint à la suite de plusieurs répétitions.

Rappelons ici que l'aimantation est décomposable en une composante alignée sur le champ magnétique principal B0, appelé composante longitudinale, et d'une composante transverse, cette dernière pouvant être détectée par induction dans un détecteur radiofréquence et pouvant être modulée spatialement avec les gradients. Rappelons que l'effet d'une impulsion radiofréquence appliquée à résonance et d'amplitude B1(t), de phase phi (par rapport à une référence interne des synthétiseurs RF) et appliquée pendant une durée T est de basculer l'aimantation d'un angle $\alpha$ avec B0, l'angle étant proportionnel à l'intégrale du champ RF pendant la durée T, l'axe de rotation est lui déphasé de $\theta = phi + \pi / 2$ radians par rapport au référentiel tournant à la résonance. Rappelons que les composantes longitudinale et transverse relaxent avec un temps caractéristique T1 et T2, respectivement, temps dépendant de l'environnement local et éventuellement influencés par le transfert d'aimantation. Rappelons enfin que les atomes ou molécules porteurs de l'aimantation nucléaire diffusent au cours du temps, ce qui est macroscopiquement décrit par les équations de Bloch-Torrey.

Une complexité importante dans les séquences rapides (avec en général TR<T2), est que la composante transverse qui est déphasée avec les gradients et avec les inhomogénéités de champ est « recyclée » par l'excitation suivante transférant une partie en longitudinal et réciproquement. Ce déphasage restant entre deux impulsions, combiné avec la non-suppression de l'aimantation par les phénomènes purement dispersif de relaxation et de diffusion, est à l'origine de différents états k comme évoqué précédemment. Il est alors difficile de décrire l'aimantation en incluant les effets de relaxation, de diffusion, d'angle, et l'homme de l'art évoque également souvent l'impossibilité de décrire les effets ou la limitation sous certaines conditions restrictives de validité ou même la confusion sur la création d'états de cohérence lorsque la phase est modulée ou enfin la négation des effets de diffusion.

Le but de la présente invention est de résoudre au moins un des problèmes suivants de l'état de l'art :

- proposer un nouveau type de séquence ou de nouvelles formes d'état d'équilibres, et/ou

- faciliter une détermination, par rapport à l'angle de Ernst, de l'effet de l'impulsion radiofréquence produisant l'angle de bascule, et/ou

- déterminer de manière quasi simultanée plusieurs paramètres parmi une aimantation nucléaire, un angle de bascule de l'aimantation, un coefficient de diffusion, un taux ou temps de relaxation longitudinal R1 ou T1, et un taux ou temps de relaxation transversal R2 ou T2 d'un même point de l'espace, et/ou

- améliorer la prise en compte de la diffusion.

## Exposé de l'invention

Cet objectif est atteint avec un procédé d'imagerie par résonance magnétique, tel que défini par la revendication indépendante 1 qui a été délimitée par rapport au document US 2006/152219 A1, le procédé comprenant :

- une application (de préférence continue) d'un champ magnétique principal B0 selon un axe Z sur un échantillon, et

- au moins un ensemble d'applications répétées, sur l'échantillon et selon une période TR, d'une séquence, ladite séquence comprenant :

   ◦ une impulsion radiofréquence d'amplitude et/ou de phase variable à chaque répétition, et
   ◦ après l'impulsion radiofréquence de la séquence, un gradient spatial de la composante selon l'axe Z du champ magnétique,

caractérisé en ce que, au cours des applications répétées de l'impulsion radiofréquence et du gradient spatial de champ magnétique de la séquence d'un même ensemble :

- l'impulsion radiofréquence suit, entre ses différentes applications répétées, une suite périodique :

  ◦ pour son amplitude et
  ◦ pour $u_{n+1} = v_{n+1} - v_n$, où n est un entier supérieur ou égal à 1 représentant le numéro de la répétition de la séquence pour cet ensemble, et où $u_{n+1}$ est une suite de nombres entiers relatifs qui permet de définir la suite $v_n$ à une constante arbitraire près $v_1$ tel que $\varphi_n = v_n \times \Delta$ et $\varphi_n = \theta_n - \theta_{n-1}$ avec $\Delta$ qui est un nombre réel constant pour toutes les applications répétées de la séquence de cet ensemble et $\varphi_n$ qui est l'incrément entre la phase $\theta_n$ de l'impulsion radiofréquence à sa $n^{\text{ième}}$ répétition dans cet ensemble et la phase $\theta_{n-1}$ de l'impulsion radiofréquence à sa $(n-1)^{\text{ième}}$ répétition dans cet ensemble, avec $\theta_0$ une valeur arbitraire, et

- chaque application répétée du gradient spatial de champ magnétique de la séquence a, selon une direction spatiale de gradient dite direction de codage identique pour chaque application de gradient de cet ensemble, une intégrale temporelle égale à A non nulle (et de préférence identique pour chaque application de gradient de cet ensemble).

Le procédé selon l'invention comprend en outre une acquisition, pendant au moins une des répétitions de la séquence, d'au moins un signal de résonance magnétique nucléaire.

Selon l'invention, l'on acquiert le signal de résonance magnétique nucléaire à différents états d'équilibre dynamiques entrelacés et/ou séquentiels de l'aimantation de l'échantillon, et :

- au cours des applications répétées de l'impulsion radiofréquence et du gradient spatial de champ magnétique de la séquence d'un même ensemble :

  ◦ la suite $u_{n+1} = v_{n+1} - v_n$ est une suite périodique non constante, et/ou

  ◦ l'amplitude de l'impulsion radiofréquence suit une suite périodique non constante,

  de manière à obtenir ces différents états d'équilibre de l'aimantation de l'échantillon entrelacés au sein de cet ensemble respectivement pour différentes valeurs périodiques de la suite $u_{n+1} = v_{n+1} - v_n$ et/ou de l'amplitude de l'impulsion radiofréquence, et en ce que l'on acquiert le signal de résonance magnétique nucléaire à ces différents états d'équilibre entrelacés, et/ou

- on émet séquentiellement plusieurs ensembles, avec :

  ◦ $\Delta$ dont la valeur diffère entre les différents ensembles, et/ou
  ◦ l'amplitude de l'impulsion radiofréquence qui suit une suite périodique qui diffère entre les différents ensembles,

  de manière à obtenir ces différents états d'équilibres de l'aimantation de l'échantillon séquentiels pour différentes valeurs de $\Delta$ et/ou de l'amplitude dont au moins un état d'équilibre par ensemble, et en ce que l'on acquiert le signal de résonance magnétique nucléaire à ces différents états d'équilibre séquentiels.

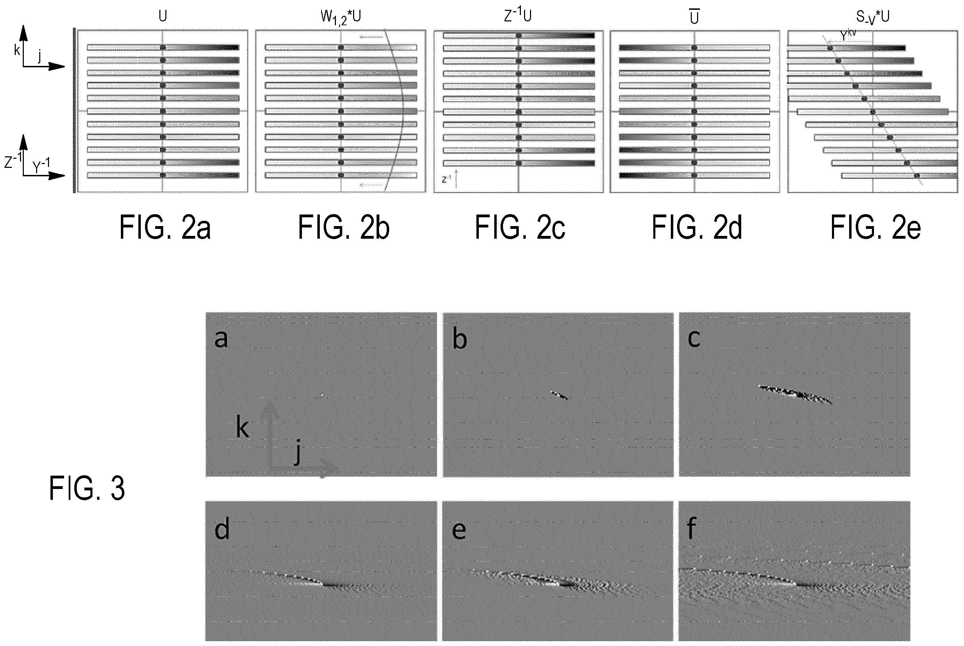

Le document US 2006/152219 A1 (voir la figure 3c par exemple) divulgue un procédé selon le préambule de la revendication 1 pour la génération de deux états d'équilibre entrelacés en utilisant une séquence avec un gradient Gx non balancé et selon le cas particulier d'une impulsion d'amplitude et phase suivant des suites périodiques constantes.

Au cours des applications répétées de l'impulsion radiofréquence et du gradient spatial de champ magnétique de la séquence d'un même ensemble, la suite $u_{n+1} = v_{n+1} - v_n$ peut être une suite périodique non constante.

Au cours des applications répétées de l'impulsion radiofréquence et du gradient spatial de champ magnétique de la séquence d'un même ensemble, l'amplitude de l'impulsion radiofréquence peut suivre une suite périodique non constante.

Au cours des applications répétées de l'impulsion radiofréquence et du gradient spatial de champ magnétique de la séquence d'un même ensemble :

- la suite $u_{n+1} = v_{n+1} - v_n$ peut être une suite périodique non constante, et/ou
- l'amplitude de l'impulsion radiofréquence peut suivre une suite périodique non constante,

de manière à obtenir différents états d'équilibre de l'aimantation de l'échantillon entrelacés au sein de cet ensemble respectivement pour différentes valeurs périodiques de la suite $u_{n+1} = v_{n+1} - v_n$ et/ou de l'amplitude de l'impulsion radiofréquence, et on acquiert de préférence le signal de résonance magnétique nucléaire à ces différents états d'équilibre entrelacés.

On peut émettre séquentiellement plusieurs ensembles, avec :

- $\Delta$ dont la valeur diffère entre les différents ensembles, et/ou
- l'amplitude de l'impulsion radiofréquence qui suit une suite périodique qui diffère entre les différents ensembles,

de manière à obtenir différents états d'équilibres de l'aimantation de l'échantillon séquentiels pour différentes valeurs de $\Delta$ et/ou de l'amplitude dont au moins un état d'équilibre par ensemble, et on acquiert de préférence le signal de résonance magnétique nucléaire à ces différents états d'équilibre séquentiels.

Le procédé selon l'invention peut comprendre :

- une acquisition d'un signal pour deux états d'équilibres correspondants à deux amplitudes de l'impulsion radiofréquence identiques mais deux $\Delta$ différents,
- une comparaison du signal pour ces deux états d'équilibres, et
- une déduction, à partir de cette comparaison, de si l'amplitude de l'impulsion radiofréquence produit un angle de bascule effectif plus grand que ou plus petit que ou égal à l'angle de Ernst pour l'échantillon ;

dans ce cas, un des deux $\Delta$ différents est de préférence égal à zéro.

Le procédé selon l'invention peut comprendre :

- une acquisition d'un signal pour des états d'équilibres correspondants à des amplitudes différentes de l'impulsion radiofréquence et/ou des $\Delta$ différents et/ou différentes valeurs de la suite $u_{n+1} = v_{n+1} - v_n$ périodique constante ou non, et
- pour au moins un point dans l'échantillon, une détermination d'au moins une donnée (de préférence au moins trois, de préférence toutes) parmi une aimantation nucléaire, un angle de bascule de l'aimantation, un coefficient de diffusion, un taux ou temps de relaxation longitudinal R1 ou T1, et un taux ou temps de relaxation transversal R2 ou T2, à partir du signal acquis pour ces états d'équilibres ;
  dans ce cas :

  - la détermination étant de préférence effectuée, soit par comparaison avec un dictionnaire pré-calculé soit par estimation itérative, selon une minimisation d'une norme de la différence entre le signal acquis exprimé sous forme complexe avec une partie réelle et une partie imaginaire et un modèle du signal exprimé sous forme complexe avec une partie réelle et une partie imaginaire. La minimisation peut comprendre un algorithme de minimisation au sens des moindres carrés, de préférence en utilisant l'algorithme de Gauss-Newton appliqué aux problèmes non-linéaires ; et/ou
  - le procédé selon l'invention peut comprendre une acquisition d'un signal pour des états d'équilibres correspondants à des $\Delta$ différents, dont :

    - plusieurs points pour une valeur absolue de $\Delta$ entre $\Delta=0°$ inclus et $\Delta=32°$ inclus modulo 360°, et/ou
    - plusieurs points pour une valeur absolue de $\Delta$ entre $\Delta=164°$ inclus et $\Delta= 196°$ inclus modulo 360°, et/ou
    - plusieurs points pour une valeur absolue de $\Delta$ entre $\Delta=112°$ inclus et $\Delta=128°$ inclus modulo 360°, et/ou
    - plusieurs points, pour une valeur absolue de $\Delta$ parmi 45°, 60°, 72°, 90°, et 144° modulo 360° ; et/ou

  - l'amplitude de l'impulsion radiofréquence correspond de préférence toujours à un angle de bascule de l'aimantation :

    - supérieur à l'angle de Ernst pour un temps de relaxation longitudinal T1 égal à 2000 millisecondes, et/ou
    - inférieur ou égal à 90° ; et/ou

  - la détermination peut comprendre une condition de continuité spatiale de chaque donnée déterminée parmi l'aimantation nucléaire, l'angle de bascule de l'aimantation, le coefficient de diffusion, le taux ou temps de relaxation longitudinal R1 ou T1, et le taux ou temps de relaxation transversal R2 ou T2 entre différents points de l'échantillon.

On peut émettre séquentiellement plusieurs ensembles, avec :

- la direction de codage qui diffère entre différents ensembles, et/ou

- la valeur de A qui diffère entre différents ensembles, et/ou
- la forme du gradient de champ magnétique selon la direction de codage qui diffère entre différents ensembles ;

dans ce cas, le procédé selon l'invention comprend de préférence en outre :

- une quantification d'un coefficient de diffusion dans l'échantillon ou
- une détermination d'une direction privilégiée de diffusion dans l'échantillon ou
- une pondération de la diffusion dans l'échantillon,

par exploitation de la différence de A et/ou direction de codage et/ou de forme du gradient entre les différents ensembles.

Suivant encore un autre aspect de l'invention, il est proposé un dispositif d'imagerie par résonance magnétique, tel que défini par la revendication indépendante 16, comprenant :

- des moyens pour appliquer, de préférence de manière continue, un champ magnétique principal B0 selon un axe Z sur une zone d'échantillon, et
- des moyens pour émettre un gradient de champ magnétique et des moyens pour émettre une impulsion radiofréquence, et des moyens de commande agencés pour commander les moyens pour émettre un gradient de champ magnétique et les moyens pour émettre une impulsion radiofréquence, les moyens de commande étant agencés pour ou programmés pour réaliser au moins un ensemble d'applications répétées, sur la zone d'échantillon et selon une période TR, d'une séquence, ladite séquence comprenant :

  ◦ une impulsion radiofréquence d'amplitude et/ou de phase variable à chaque répétition, et
  ◦ après l'impulsion radiofréquence de la séquence, un gradient spatial de la composante selon l'axe Z du champ magnétique,

caractérisé en ce que les moyens de commande sont agencés pour ou programmés pour que, au cours des applications répétées de l'impulsion radiofréquence et du gradient spatial de champ magnétique de la séquence d'un même ensemble :

- l'impulsion radiofréquence suive, entre ses différentes applications répétées, une suite périodique :

  ◦ pour son amplitude et
  ◦ pour $u_{n+1} = v_{n+1} - v_n$, où n est un entier supérieur ou égal à 1 représentant le numéro de la répétition de la séquence pour cet ensemble, et où $u_{n+1}$ est une suite de nombres entiers relatifs qui permet de définir la suite $v_n$ à une constante arbitraire près $v_1$ tel que $\varphi_n = v_n \times \Delta$ et $\varphi_n = \theta_n - \theta_{n-1}$ avec $\Delta$ qui est un nombre réel constant pour toutes les applications répétées de la séquence de cet ensemble et $\varphi_n$ qui est l'incrément entre la phase $\theta_n$ de l'impulsion radiofréquence à sa n-ième répétition dans cet ensemble et la phase $\theta_{n-1}$ de l'impulsion radiofréquence à sa (n-1)-ième répétition dans cet ensemble, avec $\theta_0$ une valeur arbitraire, et

- chaque application répétée du gradient spatial de champ magnétique de la séquence a, selon une direction spatiale de gradient dite direction de codage identique pour chaque application de gradient de cet ensemble, une intégrale temporelle égale à A non nulle (et de préférence identique pour chaque application de gradient de cet ensemble).

Le dispositif selon l'invention comprend en outre des moyens pour acquérir, pendant au moins une des répétitions de la séquence, au moins un signal de résonance magnétique nucléaire.

Les moyens de commande sont en outre agencés pour ou programmés pour commander les moyens d'acquisition de manière à acquérir le signal de résonance magnétique nucléaire à différents états d'équilibre dynamiques entrelacés et/ou séquentiels de l'aimantation dans la zone d'échantillon, et :

- les moyens de commande sont agencés pour ou programmés pour que, au cours des applications répétées de l'impulsion radiofréquence et du gradient spatial de champ magnétique de la séquence d'un même ensemble :

  ◦ la suite $u_{n+1} = v_{n+1} - v_n$ soit une suite périodique non constante, et/ou
  ◦ l'amplitude de l'impulsion radiofréquence suive une suite périodique non constante,

de manière à obtenir ces différents états d'équilibre entrelacés de l'aimantation dans la zone d'échantillon au sein de cet ensemble respectivement pour différentes valeurs périodiques de la suite $u_{n+1} = v_{n+1} - v_n$ et/ou de l'amplitude de l'impulsion radiofréquence, les moyens de commande étant en outre agencés pour ou programmés pour commander les moyens d'acquisition de manière à acquérir le signal de résonance magnétique nucléaire à ces différents états d'équilibre entrelacés, et/ou

- les moyens de commande sont agencés pour ou programmés pour que l'on émette séquentiellement plusieurs ensembles, avec :

  ◦ Δ dont la valeur diffère entre les différents ensembles, et/ou
  ◦ l'amplitude de l'impulsion radiofréquence qui suit une suite périodique qui diffère entre les différents ensembles,

de manière à obtenir ces différents états d'équilibres séquentiels de l'aimantation dans la zone d'échantillon pour différentes valeurs de Δ et/ou de l'amplitude dont au moins un état d'équilibre par ensemble, les moyens de commande étant en outre agencés pour ou programmés pour commander les moyens d'acquisition de manière à acquérir le signal de résonance magnétique nucléaire à ces différents états d'équilibre séquentiels.

Les moyens de commande peuvent être agencés pour ou programmés pour que, au cours des applications répétées de l'impulsion radiofréquence et du gradient spatial de champ magnétique de la séquence d'un même ensemble, la suite $u_{n+1} = v_{n+1} - v_n$ soit une suite périodique non constante.

Les moyens de commande peuvent être agencés pour ou programmés pour que, au cours des applications répétées de l'impulsion radiofréquence et du gradient spatial de champ magnétique de la séquence d'un même ensemble, l'amplitude de l'impulsion radiofréquence suive une suite périodique non constante.

Les moyens de commande peuvent être agencés pour ou programmés pour que, au cours des applications répétées de l'impulsion radiofréquence et du gradient spatial de champ magnétique de la séquence d'un même ensemble :

- la suite $u_{n+1} = v_{n+1} - v_n$ soit une suite périodique non constante, et/ou

- l'amplitude de l'impulsion radiofréquence suive une suite périodique non constante,

de manière à obtenir différents états d'équilibre entrelacés de l'aimantation dans la zone d'échantillon au sein de cet ensemble respectivement pour différentes valeurs périodiques de la suite $u_{n+1} = v_{n+1} - v_n$ et/ou de l'amplitude de l'impulsion radiofréquence, les moyens de commande étant en outre de préférence agencés pour ou programmés pour commander les moyens d'acquisition de manière à acquérir le signal de résonance magnétique nucléaire à ces différents états d'équilibre entrelacés.

Les moyens de commande peuvent être agencés pour ou programmés pour que l'on émette séquentiellement plusieurs ensembles, avec :

- Δ dont la valeur diffère entre les différents ensembles, et/ou
- l'amplitude de l'impulsion radiofréquence qui suit une suite périodique qui diffère entre les différents ensembles,

de manière à obtenir différents états d'équilibres séquentiels de l'aimantation dans la zone d'échantillon pour différentes valeurs de Δ et/ou de l'amplitude dont au moins un état d'équilibre par ensemble, les moyens de commande étant de préférence en outre agencés pour ou programmés pour commander les moyens d'acquisition de manière à acquérir le signal de résonance magnétique nucléaire à ces différents états d'équilibre séquentiels.

Les moyens de commande peuvent être agencés pour ou programmés pour commander les moyens d'acquisition de manière à acquérir un signal pour deux états d'équilibres correspondants à deux amplitudes de l'impulsion radiofréquence identiques mais deux Δ différents,
le dispositif comprenant en outre des moyens de calcul agencés pour ou programmés pour :

- comparer le signal pour ces deux états d'équilibres, et
- déduire, à partir de cette comparaison, de si l'amplitude de l'impulsion radiofréquence produit un angle de bascule effectif plus grand que ou plus petit que ou égal à l'angle de Ernst dans la zone d'échantillon ;

dans ce cas, un des deux Δ différents est de préférence égal à zéro.

Les moyens de commande peuvent être agencés pour ou programmés pour commander les moyens d'acquisition de manière à acquérir un signal pour des états d'équilibres correspondants à des amplitudes différentes de l'impulsion radiofréquence et/ou des Δ différents et/ou différentes valeurs de la suite $u_{n+1} = v_{n+1} - v_n$ périodique constante ou non,
le dispositif comprenant de préférence en outre des moyens de calcul agencés pour ou programmés pour, pour au moins un point dans la zone d'échantillon, déterminer au moins une donnée (de préférence au moins trois, de préférence toutes) parmi une aimantation nucléaire, un angle de bascule de l'aimantation, un coefficient de diffusion, un taux ou temps de relaxation longitudinal R1 ou T1, et un taux ou temps de relaxation transversal R2 ou T2, à partir du signal acquis pour ces états d'équilibres ;

dans ce cas :

- les moyens de calcul sont de préférence agencés pour ou programmés pour effectuer cette détermination, soit par comparaison avec un dictionnaire pré-calculé soit par estimation itérative, selon une minimisation d'une norme de la différence entre le signal acquis exprimé sous forme complexe avec une partie réelle et une partie imaginaire et un modèle du signal exprimé sous forme complexe avec une partie réelle et une partie imaginaire. La minimisation peut comprendre un algorithme de minimisation au sens des moindres carrés, de préférence en utilisant l'algorithme de Gauss-Newton appliqué aux problèmes non-linéaires ; et/ou

- les moyens de commande peuvent être agencés pour ou programmés pour commander les moyens d'acquisition de manière à acquérir un signal pour des états d'équilibres correspondants à des $\Delta$ différents, dont :

  ∘ plusieurs points pour une valeur absolue de $\Delta$ entre $\Delta=0°$ inclus et $\Delta=32°$ inclus modulo 360°, et/ou
  ∘ plusieurs points pour une valeur absolue de $\Delta$ entre $\Delta=164°$ inclus et $\Delta=196°$ inclus modulo 360°, et/ou
  ∘ plusieurs points pour une valeur absolue de $\Delta$ entre $\Delta=112°$ inclus et $\Delta=128°$ inclus modulo 360°, et/ou
  ∘ plusieurs points, pour une valeur absolue de $\Delta$ parmi 45°, 60°, 72°, 90°, et 144° modulo 360° ; et/ou

- les moyens de commande sont de préférence agencés pour ou programmés pour que l'amplitude de l'impulsion radiofréquence corresponde toujours à un angle de bascule de l'aimantation :

  ∘ supérieur à l'angle de Ernst pour un temps de relaxation longitudinal T1 égal à 2000 millisecondes, et/ou
  ∘ inférieur ou égal à 90°, et/ou

- les moyens de calcul peuvent être agencés pour ou programmés pour que la détermination comprenne une condition de continuité spatiale de chaque donnée déterminée parmi l'aimantation nucléaire, l'angle de bascule de l'aimantation, le coefficient de diffusion, le taux ou temps de relaxation longitudinal R1 ou T1, et le taux ou temps de relaxation transversal R2 ou T2 entre différents points de la zone d'échantillon.

Les moyens de commande peuvent être agencés pour ou programmés pour émettre séquentiellement plusieurs ensembles, de sorte que :

- la direction de codage diffère entre différents ensembles, et/ou
- la valeur de A diffère entre différents ensembles, et/ou
- la forme du gradient de champ magnétique selon la direction de codage diffère entre différents ensembles ;

dans ce cas, le dispositif selon l'invention peut comprendre en outre des moyens de calcul agencés pour ou programmés pour:

- quantifier un coefficient de diffusion dans la zone d'échantillon ou
- déterminer une direction privilégiée de diffusion dans la zone d'échantillon ou
- pondérer la diffusion dans la zone d'échantillon,

par exploitation de la différence de A et/ou direction de codage et/ou de forme du gradient entre les différents ensembles.

**Description des figures et modes de réalisation**

D'autres avantages et particularités de l'invention apparaîtront à la lecture de la description détaillée de mises en œuvre et de modes de réalisation nullement limitatifs, et des dessins annexés suivants :

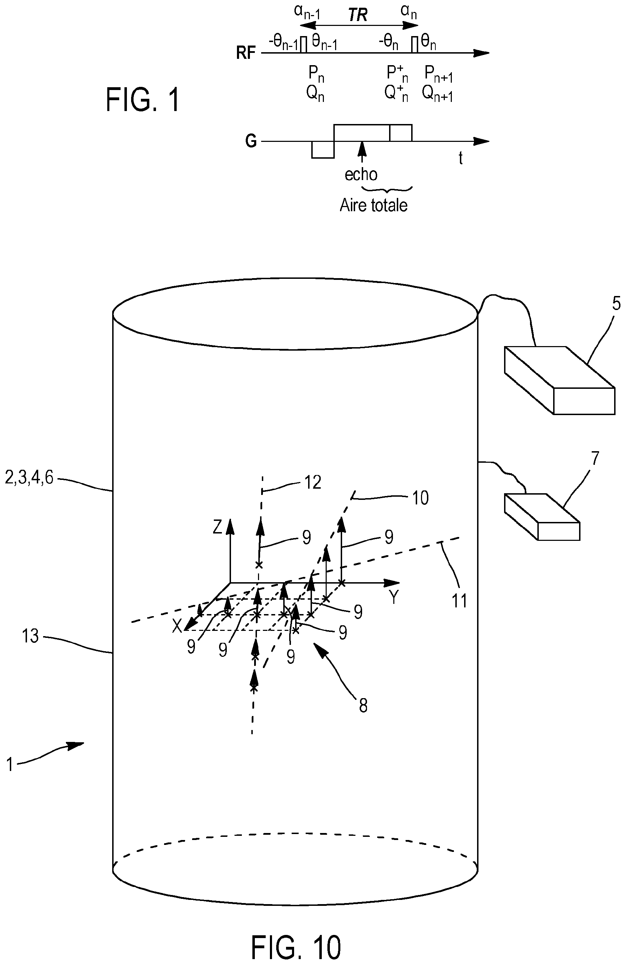

- la figure 1 illustre schématiquement, pour un premier mode de réalisation de procédé selon l'invention, la séquence d'impulsions RF répétées tous les TR (*n* est le numéro de la répétition) modulée en amplitude ($\alpha_n$) et en phase ($\theta_n$). Les composantes longitudinale ($P_n$) et transversale ($Q_n$) de l'aimantation après l'impulsion numéro *n*-1 évolue jusqu'à $P_n^+$ et $Q_n^+$ juste avant l'impulsion numéro *n*. La forme du gradient (G) est représentée ici selon la direction de la lecture ce qui laisse une aire de gradient non-nulle entre chaque répétition.
- la figure 2 illustre un résumé de différents opérateurs et de leur action respective représentée graphiquement :

a) Pour un polynôme noté U (a) qui décrit une des composantes (longitudinale ou transversale) de l'aimantation sous forme d'états de configuration dont le détail est décrit plus loin, l'index $j$ est représenté le long de lignes horizontales selon $Y^{-1}$, différents index k étant illustré par différentes lignes superposées verticalement selon $Z^{-1}$.

b) La convolution avec les polynômes de pondération $W_1$ ou $W_2$ est équivalent à une multiplication terme à terme des coefficients selon $Z^{-1}$

c) La multiplication par $Z^{-1}$ décale les coefficients d'un cran dans cette direction,

d) l'opération de conjugaison correspond à une symétrie centrale

e) La convolution avec $S_{-v}$ penche les différentes lignes selon $Y^{-1}$ et $Z^{-1}$ par un coefficient qui varie linéairement avec k. Son action est représentée sur une gamme limitée et, en fonction de la discrétisation selon $Y^{-1}$, le repliement d'un côté à l'autre doit être implémenté. Le calcul itératif est ensuite effectué en combinant ces opérations de base.

- la figure 3 est une représentation de la composante transversale de l'aimantation $Q_n$ en termes de coefficients selon des états de configuration, pour $\alpha=30°$, TR/T1=TR/T2=0.05 et $E_d$=0.995 (a, correspond à n=1 avec seulement un coefficient non nul au centre), n=4 (b); n=8 (c), n=16 (d), état stationnaire (e). Progressivement, le plan de taille $N_y$=180 (index $j$, selon $Y^{-1}$), $N_z$=128 (index $k$, selon $Z^{-1}$) est remplit par des coefficients non-nuls qui tendent vers l'état stationnaire. En comparaison, l'état d'équilibre sans diffusion (f) possède bien plus de coefficients non-nuls illustrant les effets atténuant importants de la diffusion (en comparaison avec e).

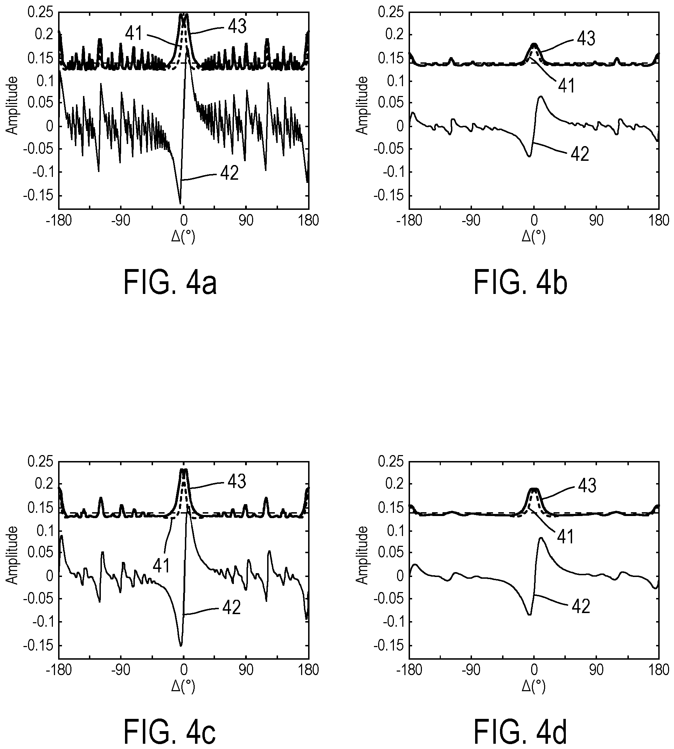

- la figure 4 illustre un résultat de simulation de l'influence de T2 et de la diffusion sur l'aimantation transversale à l'état stationnaire pour l'ordre $k$=0 et pour $\Delta$ compris entre -180° et 180° avec une suite $u_n$=1 constante ainsi qu'une amplitude constante. L'aimantation transversale est représentée après une transformée de Fourier selon $Y^{-1}$: la partie réelle (ligne référencée 41), la partie imaginaire (ligne référencée 42) et la valeur absolue (ligne référencée 43) pour $\alpha$ = 30°, $TR/T_1$ = 0.05 et $N_y$ = 720. L'équilibre de Ernst est tracé à l'aide de la ligne en pointillés. Plusieurs cas sont présentés : l'aimantation obtenue sans diffusion et avec $TR/T_2$ = 0.05 (a), sans diffusion et avec $TR/T_2$ = 0.25 (b), avec une diffusion faible ($E_d$= 0.995, ce qui correspond à $b$=2,39 s.mm$^{-2}$ si D=2,1 10$^{-9}$ m$^2$.s$^{-1}$) et $TR/T_2$ = 0.05 (c), avec une diffusion importante ($E_d$= 0.95, ce qui correspond à $b$=24,4 s.mm$^{-2}$ si D=2,1 10$^{-9}$ m$^2$.s$^{-1}$) et $TR/T_2$ = 0.05 (d). La relaxation transversale $T_2$ et la diffusion ont toutes deux tendances à lisser le profil de l'aimantation en fonction de $\Delta$, ce qui limite la formation d'échos stimulés. L'état stationnaire prend des valeurs plus petites et plus grandes que l'équilibre de Ernst qui n'est jamais atteint exactement.

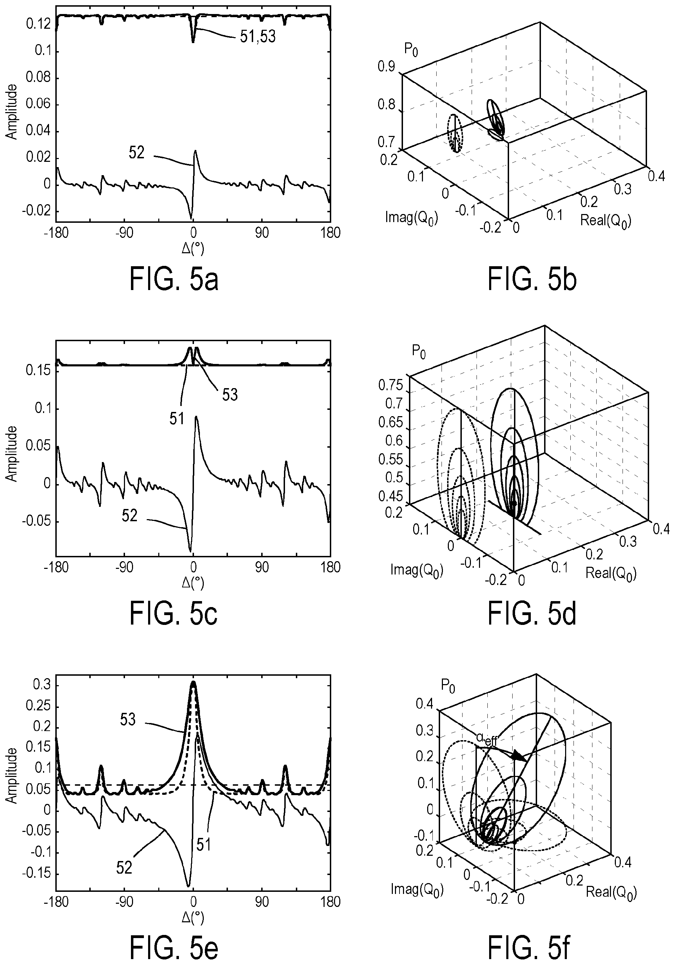

- la figure 5 illustre un résultat de simulation des effets de l'angle de basculement sur l'aimantation à l'état stationnaire pour k=0 avec un cyclage quadratique de phase (suite $u_n$=1 constante, amplitude constante). L'aimantation transversale $Q_0$ (a, c, e) est représentée après avoir effectué une transformée de Fourier selon $Y^{-1}$ : la partie réelle (ligne référencée 51), la partie imaginaire (ligne référencée 52) et la valeur absolue (ligne référencée 53) pour $TR/T_1$ = $TR/T_2$ = 0.05, $E_d$= 0.995 et $N_y$ = 720. L'équilibre de Ernst est représenté à l'aide de la ligne en pointillés. De haut en bas sont présentés les résultats pour différents angles de basculement : pour $\alpha$ = 9° (a), pour l'angle de Ernst $\alpha$ = 18° (c), et pour $\alpha$ = 75° (e). La colonne de droite représentent les composantes longitudinale et transversale en 3D (b, d, f) pour respectivement les angles correspondants à (a, c, e). L'aimantation est contenue dans un plan qui passe par l'équilibre de Ernst et qui est orienté avec un angle effectif $\alpha_{eff}$ par rapport à $B_0$ et tel que $\tan(\alpha_{eff})$=$(E_1-c)/s$. Quand $\Delta$ varie, l'aimantation tourne dans ce plan autour de l'équilibre de Ernst.

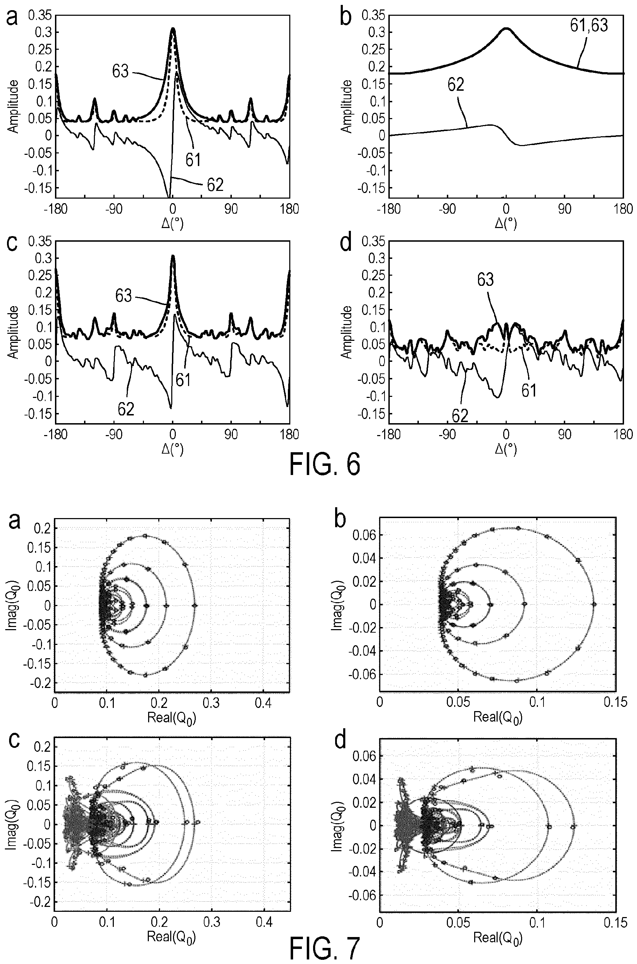

- la figure 6 illustre une simulation d'état stationnaire pour k=0. L'aimantation transversale $Q_0$ (a, d, e) est présentée après avoir effectué une transformée de Fourier selon $Y^{-1}$ : partie réelle (ligne référencée 61), partie imaginaire (ligne référencée 62) et valeur absolue (ligne référencée 63) pour $TR/T_1$ = $TR/T_2$ = 0.05, $E_d$= 0.995 et $N_y$ = 720. Le cas standard avec une série constante ($\alpha$ = 75° et décalage apparent de fréquence constants $u_n$=1) (a) est donné pour référence. L'application d'un angle constant en amplitude ($\alpha$ = 75°) avec une alternance du décalage apparent de fréquence avec $u_n$ (+1, -1) (b) qui crée des états stationnaires complexes conjugués (un seul état présenté ici) avec une dépendance relativement lisse en fonction de $\Delta$. Pour des amplitudes alternées (75°, 37.5°) et un décalage apparent de fréquence constant $u_n$=1, des équilibres entrelacés (c après 75°, d après 37.5°) avec une dépendance complexe en fonction de $\Delta$.

- la figure 7 illustre des résultats expérimentaux obtenus après ajustement des signaux moyens sur les tubes. Les signaux ont été normalisés par la valeur d'aimantation ajustée M, et sont représentés dans le plan complexe. 'Real' et 'Imag' représentent les parties réelles et imaginaires, respectivement. Le point ayant la partie réelle la plus grande correspond à $\Delta$=0°. Les points sont présentés tous les 2° d'incréments selon la ligne en pointillée grise. Les mesures (cercles et triangles) sont comparables aux résultats du calcul (lignes et croix). Pour un angle de 45° avec la séquence 1 pour le tube de Gd à 1.25 mM (a, meilleur ajustement avec $T_1/T_2$ = 180/157 ms, Ed = 0.99669 ou D = 2.29 10$^{-9}$ m$^2$s$^{-1}$, $\alpha$ = 44.01°), et pour le tube d'ION à 160 $\mu$M (b, meilleur ajustement avec $T_1/T_2$ = 444/75 ms, Ed = 0.99671 ou D = 2.26 10$^{-9}$ m$^2$s$^{-1}$, $\alpha$ = 44.23°). Les états stationnaires entrelacés pour 45° (ligne pointillée) / 22.5° (ligne pleine) obtenus avec la séquence 2 pour le tube de Gd à 1.25 mM (c, meilleur ajustement avec $T_1/T_2$ = 177/156 ms, Ed =0.9996 ou D = 2.19 10$^{-9}$ m$^2$s$^{-1}$, $\alpha$ = 44.64°), et pour le tube d'ION à 160 $\mu$M (d, meilleur ajustement avec $T_1/T_2$ =

518/73 ms, Ed = 0.9997 ou D = 1.67 $10^{-9}$ $m^2s^{-1}$, $\alpha$ = 44.09°). Les états stationnaires mesurés sont très bien modélisés par les simulations et les paramètres ajustés correspondent aux valeurs attendues.

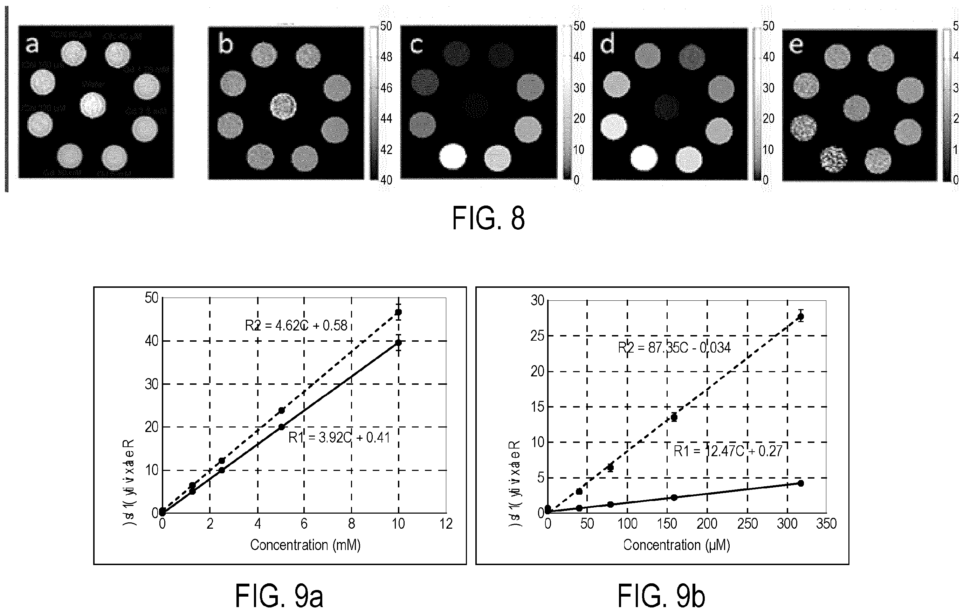

- la figure 8 illustre différentes images multiparamétriques : cartes de M (a), d'angle de basculement (b en °), de $R_1$ (c en $s^{-1}$), de $R_2$ (d en $s^{-1}$) et du coefficient de diffusion (e en $10^{-9}m^2s^{-1}$) obtenus pour 45° avec la séquence 1 traitée avec le problème inverse proposé.
- la figure 9 illustre les relaxivités longitudinale et transversale moyennes estimées sur les tubes pour le Gd (a) et les ION (b) sont représentées avec leur écart-type associé. Les relaxivités molaires sont estimées en ajustant les relaxivités par une droite en fonction de la concentration (équation donnée sur le graphe, C correspond à la concentration en mM). Les relaxivités sont bien linéaires en fonction de la concentration démontrant une mesure fiable de R1 et R2 sur une large gamme de valeurs.
- la figure 10 est une vue schématique en perspective d'un premier mode de réalisation de dispositif selon l'invention.

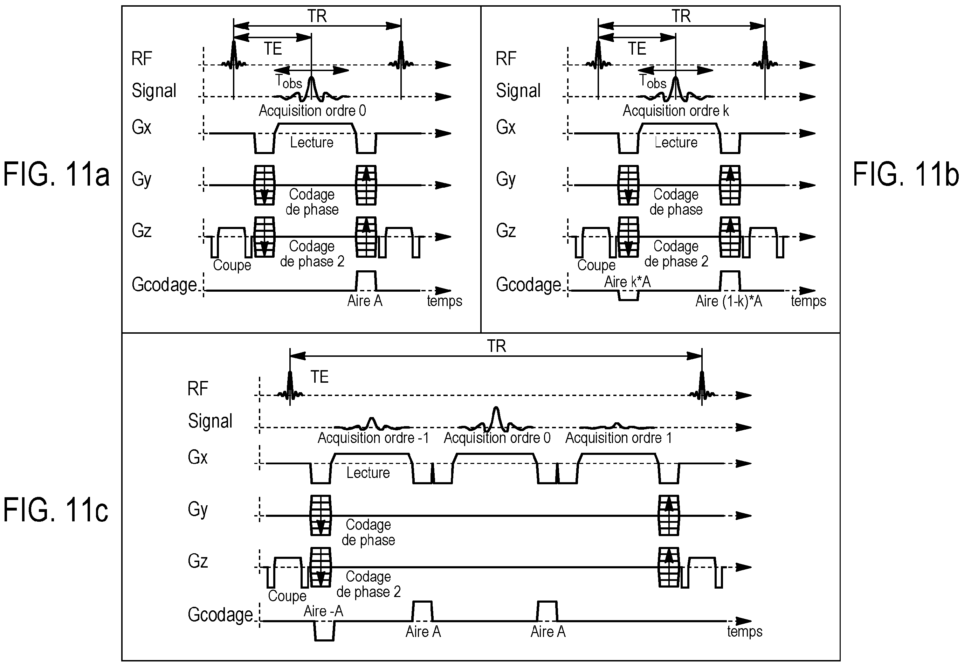

- la figure 11 illustre la séquence contenant l'impulsion RF répétée tous les TR avec une aire de gradient de champ magnétique A restante entre les répétitions selon une direction de codage et inséré dans une séquence en écho de gradient. Les axes logiques de gradients d'imagerie Gx pour la lecture, Gy pour une première direction de codage de phase et Gz pour la sélection de coupe et un éventuel codage de phase supplémentaire sont représentés. Tous ces gradients d'imagerie possèdent une aire nulle entre chaque répétition. La direction de codage peut être appliquée selon n'importe quelle direction Gx, Gy ou Gz aussi bien que selon une direction oblique, ce qui mène naturellement à une optimisation de la combinaison des gradients qui en résulte. Différentes variantes sont représentés pour illustration du type d'acquisition possible : la variante $\alpha$ consiste en l'acquisition de l'ordre 0 seul ; la variante *b* consiste en l'acquisition de l'ordre k seul ; la variante *c* consiste en l'acquisition de 3 ordres lors d'une même répétition.

Ces modes de réalisation étant nullement limitatifs, on pourra notamment considérer des variantes de l'invention ne comprenant qu'une sélection de caractéristiques décrites ou illustrées par la suite isolées des autres caractéristiques décrites ou illustrées (même si cette sélection est isolée au sein d'une phrase comprenant ces autres caractéristiques), tant que cette sélection de caractéristiques entre dans le cadre des revendications annexées.

Par la suite, les numéros de références entre parenthèses seront des numéros de références bibliographiques listées à la fin de la présente description, et les numéros de références sans parenthèses seront des numéros des références numériques des figures.

Malgré la dépendance relativement simple par rapport à $T_1$ et à l'angle de bascule de l'équilibre de Ernst applicable lorsque l'aimantation transversale est complètement éliminée entre deux impulsions radiofréquences (RF) identiques (1), le développement de séquences d'imagerie rapide dans les débuts de l'IRM a rapidement montré qu'il était indispensable de prendre en compte le recyclage de la composante transversale de l'aimantation après des excitations répétées. Les séquences de précession libre à l'état stationnaire (Steady-state free precession, SSFP) ont été proposées comme un moyen efficace de combiner un bon rapport signal-sur-bruit (RSB) et d'obtenir des contrastes mixtes en densité de proton, $T_1$ et $T_2$ (2). Rapidement, le brouillage par cyclage de phase RF (RF spoiling), qui utilise un cyclage quadratique de la phase d'une excitation sur l'autre combinée avec une aire de gradient non-nulle entre les impulsions, a été proposé pour efficacement limiter la formation de cohérence de l'aimantation tranversale (3-5). Des descriptions théoriques et pratiques ont ensuite été introduites pour analyser l'action d'impulsions répétées sur l'aimantation. Ces outils sont basés sur le formalisme des états de configuration appliqué aux composantes longitudinale et transverse de l'aimantation qui sont alors décomposées en série de Fourier discrète, comme c'est le cas dans le graphe étendu de phase (6-9), ou encore à travers la décomposition en polynôme qui a permis de relier la conception d'impulsions RF au filtrage numérique (10,11).

En raison du mélange des composantes longitudinale et transversale, que ce soit sur le signal transitoire (11-14) ou sur l'état stationnaire (SSFP), l'aimantation dépend de manière complexe des paramètres physiques (comme les temps de relaxation et le coefficient de diffusion) et des paramètres de séquences (angle de bascule, amplitudes et phases des impulsions RF, temps de répétition et indice de la répétition, forme et aire totale des gradients). Une large gamme de sensibilisation peut être obtenue et des paramètres extraits de ce type de séquences d'impulsions répétées. En particulier, l'état stationnaire a largement été exploité. D'une part, en considérant un brouillage parfait (obtenu approximativement avec un cyclage quadratique de phase avec des incréments de 117°, ou d'autres valeurs (4,15,16)), des acquisitions séquentielles avec des angles différents (variable flip angles) permet de cartographier $T_1$ et/ou l'angle de bascule (15-21). D'autre part, sans brouillage de la phase, des acquisitions de multitples états de configurations k (22) peuvent être utilisés pour caractériser la relaxation transverse (23-26). Au sujet de la sensibilité à la diffusion, qui est, comme la relaxation transverse, un mécanisme irréversible qui limite la formation d'échos stimulés, son influence sur les équilibres stationnaires SSFP sans cyclage de phase a été traité avec l'aide du formalisme des états de configuration en spectroscopie (27), avant d'être appliqué en imagerie (28-31) jusqu'à l'utilisation de multiples états de configuration k pour permettre la cartographie du coefficient de diffusion (24,32). Entre les cas extrêmes de l'absence de brouillage sans cyclage de la phase et du brouillage parfait éliminant toute l'aimantation transversale, le brouillage partiel à l'aide d'un incrément de phase quadratique de faible valeur autour de 0° a été proposé pour quantifier la relaxation transversale (33-35).

Il est proposé, dans le cadre de la présente description de certains modes de réalisation et variantes selon l'invention, d'unifier ces différentes approches en étendant le formalisme des états de configuration au cyclage de phase RF. En utilisant ce formalisme étendu, un algorithme est proposé pour calculer l'aimantation après des impulsions répétées d'amplitude et de phase quelconques en incluant les effets de relaxation et de diffusion. Dans ce cadre de description, les composantes associées à chaque état de configuration sont des nombres réels et l'action des impulsions RF (modulées en amplitude et en phase) est réduite à des opérations numériques de filtrage linéaires, de combinaisons linéaires et de décalage d'indices, opérations qui ont une représentation graphique simple. Il est déduit que toute série périodique d'amplitude et de décalage apparent de fréquence permet d'obtenir des équilibres stationnaires entrelacés ce qui ouvre la possibilité d'étendre les capacités de sensibilisation du signal aux paramètres physiques et de séquence. Pour le cas particulier d'amplitude d'angle constante avec cyclage quadratique de phase RF (équivalent à un décalage constant de fréquence apparente), le signal SSFP peut être calculé en tenant compte de la relaxation et de la diffusion de manière très efficace. Enfin, basé sur l'acquisition de multiples séries d'amplitude et de schéma de cyclage de phase, un problème inverse est proposé pour reconstruire les cartes des paramètres sous-jacents. La théorie, l'implémentation pratique ainsi que la preuve de concept expérimentale sur un appareil clinique est donnée introduisant de nouveaux procédés pour la cartographie multiparamétrique basée sur des acquisitions avec des séquences rapides incluant des impulsions RF répétées.

On va par la suite décrire l'aimantation après l'application répétée d'impulsions radiofréquences (RF) modulées en amplitude et en phase entrelacées d'une aire constante de gradient, pour ensuite dériver un problème inverse générique pour l'imagerie multiparamétrique permettant la quantification de l'aimantation nucléaire, de l'angle de bascule, des taux de relaxation longitudinal et transverse et du coefficient de diffusion.

Comme on le verra par la suite, le formalisme des états de configuration, qui prend en compte le déphasage dû au gradient (au travers des ordres k), est étendu dans le cadre de la présente description de certains modes de réalisation et variantes de l'invention pour inclure la modulation de la phase des impulsions RF (ordres j). L'action des impulsions répétées est réduite à des opérations de filtrage et possède une représentation graphique simple. La manipulation du contraste dans les séquences de précession libre à l'état stationnaire (SSFP, pour « steady-state free precession ») sont étendues aux cas d'équilibres stationnaires entrelacés. Un algorithme de minimisation au sens des moindres carrés non-linéaires est proposé pour cartographier de multiples paramètres basé sur l'acquisition d'états d'ordre k=0. Des solutions d'agents de contraste sont imagés avec des séquences 3D appliquant les multiples modulations des impulsions RF validant les problèmes direct et inverse proposés. Un calcul rapide des états de l'aimantation après des impulsions répétées est obtenu, aussi bien dans le cas standard du cyclage quadratique de la phase à amplitude constante des impulsions, que dans des cas plus complexes. Le calcul est en parfait accord avec les expériences et la résolution du problème inverse donne accès à l'aimantation nucléaire, à l'angle, aux taux de relaxation et au coefficient de diffusion. Ainsi, par une simplification de la description de l'aimantation à la suite d'impulsions répétées modulées en phase et en amplitude, on étend les possibilités de manipulation du contraste dans ce type de séquences et démontre que les multiples paramètres d'intérêt en IRM peuvent être extraits par ce biais.

### Premier mode de réalisation d'un procédé et d'un dispositif selon l'invention

En référence à la figure 10, le premier mode de réalisation de dispositif 1 selon l'invention comprend :

- des moyens 2 pour appliquer, de manière continue, un champ magnétique principal B0 selon un axe Z sur une zone d'échantillon (comprenant par exemple un aimant permanent ou une bobine supraconductrice ou un solénoïde comme on en trouve dans une machine IRM)
- des moyens 3 pour émettre un gradient de champ magnétique (comprenant par exemple trois bobines conductrices comme on en trouve dans une machine IRM),
- des moyens 4 pour émettre une impulsion radiofréquence (comprenant par exemple une antenne Radio Fréquence dite « Corps » ou « Body » comme on en trouve dans une machine IRM),
- des moyens de commande 5 agencés pour commander les moyens pour émettre un gradient de champ magnétique et les moyens pour émettre une impulsion radiofréquence,
- des moyens 6 pour acquérir au moins un signal de résonance magnétique nucléaire (comprenant par exemple plusieurs antennes réceptrices montées en réseau phasé comme on en trouve dans une machine IRM),
- des moyens de calcul 7.

Les différents moyens 2, 3, 4, 6 sont typiquement dans les parois d'une enceinte 13 (de forme typiquement cylindrique, typiquement de dimensions intérieures : diamètre = 60 cm; longueur = 2 mètres) pour les systèmes cliniques à l'intérieur de laquelle se trouve la zone d'échantillon 8, et ne sont pas illustrés en détails sur la figure 10.

Chacune des étapes du procédé selon l'invention n'est pas réalisée de manière purement abstraite ou purement intellectuelle mais implique l'utilisation d'un moyen technique.

Chacun parmi les moyens de commande 5, les moyens d'acquisition 6 et les moyens de calcul 7 comprend un ordinateur, et/ou une unité centrale ou de calcul, et/ou un circuit électronique analogique (de préférence dédié), et/ou un circuit électronique numérique (de préférence dédié), et/ou un microprocesseur (de préférence dédié), et/ou des moyens logiciels.

Comme on le verra par la suite, chacun parmi les moyens de commande 5, les moyens d'acquisition 6 et les moyens de calcul 7, peut être agencé pour (par exemple en comprenant une carte électronique dédiée) et/ou plus précisément programmé pour (par exemple en comprenant des moyens logiciels) réaliser certaines fonctions ou opérations ou commande ou calcul etc.

En référence aux figures 1, 10 et 11, le premier mode de réalisation de procédé d'imagerie par résonance magnétique mis en œuvre par le premier mode de réalisation de dispositif selon l'invention, comprend :

- une application (par les moyens 2) continue du champ magnétique principal B0 (homogène dans toute la zone d'échantillon 8) selon l'axe Z sur un échantillon disposé dans la zone d'échantillon (par la suite, on parlera d'échantillon ou de zone d'échantillon, ces deux expressions étant interchangeables puisque par exemple un champ émis dans l'échantillon et émis dans la zone d'échantillon et inversement), et

- au moins un ensemble d'applications répétées (par les moyens de commande 5 qui sont agencés pour ou programmés pour réaliser cet au moins un ensemble d'applications répétées), sur l'échantillon et selon une période TR, d'une séquence (de type « non balancée »), ladite séquence comprenant :

  ◦ une impulsion radiofréquence RF éventuellement d'amplitude B1 variable et/ou de phase variable à chaque répétition, et
  ◦ après l'impulsion radiofréquence de la séquence, un gradient spatial de la composante selon l'axe Z du champ magnétique ; typiquement, le gradient spatial de la composante $B_z(x, y, z)$ selon Z du champ magnétique au point de coordonnées (x, y, z) varie le long de trois directions orthogonales (par exemple X, Y, Z), ce gradient peut donc typiquement se décomposer sous la forme $(\dfrac{dB_z(x,y,z)}{dx}; \dfrac{dB_z(x,y,z)}{dy}; \dfrac{dB_z(x,y,z)}{dz})$ et ce gradient correspond typiquement à la somme :

    i) d'un gradient de codage Gcodage selon une direction de codage telle qu'introduite par la suite ; ce gradient Gcodage possède une intégrale temporelle (sur le temps TR) non nulle entre chaque répétition de la séquence.
    ii) d'un gradient de lecture Glecture (égal par exemple à Gx selon l'axe X sur la figure 11) ; ce gradient de lecture possède une intégrale temporelle (sur le temps TR) nulle entre chaque répétition de la séquence.
    iii) d'un gradient de codage de phase Gphasel (égal par exemple à Gy selon l'axe Y sur la figure 11) ; ce gradient de codage de phase possède une intégrale temporelle (sur le temps TR) nulle entre chaque répétition de la séquence.
    iv) d'un gradient de sélection de coupe Gcoupe éventuellement combiné à un deuxième gradient de codage de phase Gphase2 (dont la combinaison est égale par exemple à Gz selon l'axe Z sur la figure 11) ; ces gradients de sélection de coupe et de codage de phase possède une intégrale temporelle (sur le temps TR) nulle entre chaque répétition de la séquence.

les gradients énoncés aux points ii) iii) et iv) de lecture et de codage de phase et de sélection de coupe étant définis le long de trois axes distincts orthogonaux ; l'utilisation des gradients énoncés aux points ii) iii) et iv) de lecture, de codage de phase et de sélection de coupe sont connus de l'état de l'art et ne seront donc pas plus détaillés.

Par « application continue » de B0, on entend dans la présente description une application de valeur constante dans le temps de B0 pendant toute la durée de l'au moins un ensemble d'applications répétées de la séquence.

Comme on le voit sur la figure 10, le champ magnétique 9 est parallèle à l'axe Z dans toute la zone d'échantillon 8. Le gradient spatial $\dfrac{dB_z(x,y,z)}{dx}$ de la composante selon Z du champ magnétique le long de l'axe X est illustré par la droite 10. Le gradient spatial $\dfrac{dB_z(x,y,z)}{dy}$ de la composante selon Z du champ magnétique le long de l'axe Y est illustré par la droite 11. La droite 12 n'illustre pas une pente ou gradient, mais on voit le long de cette droite 12 différentes valeurs de la composante selon Z du champ magnétique qui illustrent bien le gradient spatial $\frac{dB_z(x, y, z)}{dz}$ de la composante selon Z du champ magnétique le long de l'axe Z.

Au cours des applications répétées de l'impulsion radiofréquence et du gradient spatial de champ magnétique de la séquence d'un même ensemble (les moyens de commande 5 étant agencés pour ou programmés pour cela):

- l'impulsion radiofréquence suit, entre ses différentes applications répétées, une suite périodique :

  ◦ pour son amplitude et

  ◦ pour $u_{n+1} = v_{n+1} - v_n$, où n est un entier supérieur ou égal à 1 représentant le numéro de la répétition de la séquence pour cet ensemble, et où $u_{n+1}$ est une suite de nombres entiers relatifs qui permet de définir la suite $v_n$ à une constante arbitraire près $v_1$ tel que $\varphi_n = v_n \times \Delta$ et $\varphi_n = \theta_n - \theta_{n-1}$ avec $\Delta$ qui est un nombre réel constant pour toutes les applications répétées de la séquence de cet ensemble et $\varphi_n$ qui est l'incrément entre la phase $\theta_n$ de l'impulsion radiofréquence à sa n$^{\text{ième}}$ répétition dans cet ensemble et la phase $\theta_{n-1}$ de l'impulsion radiofréquence à sa (n-1)$^{\text{ième}}$ répétition dans cet ensemble, avec $\theta_0$ une valeur arbitraire, et

- chaque application répétée du gradient spatial de champ magnétique de la séquence a, selon une direction spatiale de gradient dite direction de codage identique pour chaque application de gradient de cet ensemble, une intégrale temporelle égale à A non nulle (sur le temps TR) et identique pour chaque application de gradient de cet ensemble ; le gradient selon la direction de codage est, à chaque instant t donné, de préférence le même pour tous les points de l'échantillon ; le gradient selon la direction de codage a aussi de préférence une forme identique pour chaque application de gradient de cet ensemble ; la direction de codage peut être selon la direction de l'axe X, Y ou Z ou n'importe quelle direction oblique à ces axes : le cas de la figure 1 correspond au cas particulier où la direction de codage est parallèle à l'axe X du gradient de lecture Glecture=Gx, et la référence G de la figure 1 est donc égale à la somme :

$$\text{Glecture} + \text{Gcodage} = \text{Gx} + \text{Gcodage}.$$

Le premier mode de réalisation de procédé selon l'invention mis en œuvre par le premier mode de réalisation de dispositif selon l'invention comprend en outre une acquisition (par les moyens d'acquisition 6 qui sont agencés pour ou programmés pour cela), pendant au moins une des répétitions de la séquence, d'au moins un signal de résonance magnétique nucléaire (à un temps d'écho TE (inférieur à TR) entre une application de l'impulsion RF et l'acquisition), de préférence correspondant à au moins un ordre de cohérence obtenu lorsque l'application, pour cette au moins une répétition de séquence, du gradient spatial de champ magnétique dans la direction de codage atteint une intégrale temporelle multiple (par un nombre entier relatif) de A (tel que l'ordre 0 (correspondant à 0*A), l'ordre -1 (correspondant à -1*A), l'ordre 1 (correspondant à 1*A), ou des multiples d'ordre supérieur), de préférence à l'ordre de cohérence égal à zéro. Différentes variantes sont représentées sur la figure 11 : la variante $\alpha$ consiste en l'acquisition de l'ordre 0 seul ; la variante *b* consiste en l'acquisition de l'ordre k seul ; la variante c consiste en l'acquisition de 3 ordres lors d'une même répétition.

Selon la variante considérée de l'invention, au cours des applications répétées de l'impulsion radiofréquence et du gradient spatial de champ magnétique de la séquence d'un même ensemble (les moyens de commande 5 étant agencés pour ou programmés pour cela) :

- la suite $u_{n+1} = v_{n+1} - v_n$ est une suite périodique non constante, et/ou

- l'amplitude de l'impulsion radiofréquence suit une suite périodique non constante.

Si la suite $u_{n+1} = v_{n+1} - v_n$ est non constante, elle a une période $N_u$ qui est un entier naturel :

- supérieur à 1,

Le cas $N_u = 1$ est le cas de la suite constante.

Un exemple de suite $u_{n+1} = v_{n+1} - v_n$ avec $N_u = 3$ est par exemple :

- pour n=1, $u_1$ est égal à une première valeur,

- pour n=2, $u_2$ est égal à une deuxième valeur,

- pour n=3, $u_3$ est égal à une troisième valeur,

- pour n=4, $u_4$ est égal à la première valeur $u_1$,

- pour n=5, $u_5$ est égal à la deuxième valeur $u_2$,

- pour n=6, $u_6$ est égal à la troisième valeur $u_3$,

- etc

Si la suite d'amplitude de l'impulsion radiofréquence est non constante, elle a une période $N_a$ qui est un entier naturel :

- supérieure à 1,

Le cas $N_a=1$ est le cas de la suite constante.
Un exemple de suite d'amplitude de l'impulsion radiofréquence avec $N_a=3$ est par exemple :

- pour n=1, l'amplitude de l'impulsion radiofréquence est égale à une première valeur,
- pour n=2, l'amplitude de l'impulsion radiofréquence est égale à une deuxième valeur,
- pour n=3, l'amplitude de l'impulsion radiofréquence est égale à une troisième valeur,
- pour n=4, l'amplitude de l'impulsion radiofréquence est égale à la première valeur,
- pour n=5, l'amplitude de l'impulsion radiofréquence est égale à la deuxième valeur,
- pour n=6, l'amplitude de l'impulsion radiofréquence est égale à la troisième valeur,
- etc

Dans le premier mode de réalisation de procédé selon l'invention mis en œuvre par le premier mode de réalisation de dispositif selon l'invention, on acquiert le signal de résonance magnétique nucléaire à au moins un état d'équilibre dynamique de l'aimantation de l'échantillon, les moyens de commande 5 étant agencés pour ou programmés pour commander les moyens d'acquisition 6 pour effectuer une telle acquisition. Selon la variante considérée de l'invention :

1) au cours des applications répétées de l'impulsion radiofréquence et du gradient spatial de champ magnétique de la séquence d'un même ensemble (les moyens de commande 5 étant agencés pour ou programmés pour cela):

   ○ la suite $u_{n+1} = v_{n+1} - v_n$ est une suite périodique non constante, et/ou
   ○ l'amplitude de l'impulsion radiofréquence suit une suite périodique non constante,

de manière à obtenir différents états d'équilibre de l'aimantation de l'échantillon entrelacés au sein de cet ensemble respectivement pour différentes valeurs périodiques de la suite $u_{n+1} = v_{n+1} - v_n$ et/ou de l'amplitude de l'impulsion radiofréquence, et on acquiert le signal de résonance magnétique nucléaire à ces différents états d'équilibre entrelacés , les moyens de commande 5 étant en outre agencés pour ou programmés pour commander les moyens d'acquisition 6 pour effectuer une telle acquisition, et/ou
2) on émet séquentiellement plusieurs ensembles (dont un ou plusieurs peu(ven)t être du type d'ensemble de l'alinéa 1) du présent paragraphe) , avec (les moyens de commande 5 étant agencés pour ou programmés pour cela):

   ○ $\Delta$ dont la valeur diffère entre les différents ensembles, et/ou
   ○ l'amplitude de l'impulsion radiofréquence qui suit une suite périodique (constante ou pas) qui diffère entre les différents ensembles,

de manière à obtenir différents états d'équilibres de l'aimantation de l'échantillon séquentiels pour différentes valeurs de $\Delta$ et/ou de l'amplitude dont au moins un état d'équilibre par ensemble, et on acquiert le signal de résonance magnétique nucléaire à ces différents états d'équilibre séquentiels, les moyens de commande 5 étant en outre agencés pour ou programmés pour commander les moyens d'acquisition 6 pour effectuer une telle acquisition.

Au sein de chaque ensemble d'applications répétées de séquence, le nombre d'itérations de la séquence nécessaires pour atteindre une aimantation très proche de l'état d'équilibre dynamique est de l'ordre de $5\dfrac{T1}{TR}$ . T1 n'étant pas a priori connu, on pourra considérer typiquement une valeur de T1cible (par exemple de l'ordre de 1 seconde), et il faudra alors appliquer les répétitions pendant au moins un temps d'établissement de l'équilibre de l'ordre de 5*T1cible et s'assurer ainsi que l'équilibre dynamique est atteint pour tous les échantillons ayant un T1 plus petit. L'acquisition et le stockage des données ne débuteront de préférence qu'après ce temps d'établissement. On pourra néanmoins déclencher l'acquisition avant ce temps d'établissement, c'est-à-dire pendant la phase transitoire :

- soit en acquérant des fréquences spatiales élevées pendant la phase d'établissement de l'équilibre tout en s'assurant que les fréquences spatiales centrales (en particulier le centre du plan de Fourier) soient acquises au minimum à ou après ce temps d'établissement de l'équilibre,

- Soit, notamment pour raffiner la quantification dans la variante dite d' « imagerie multiparamétrique », en incluant la modélisation de l'état transitoire pendant la phase d'établissement de l'équilibre.

### Cas particulier de la décomposition de l'aimantation en états de configuration bi-dimensionnels

L'action d'impulsions RF répétées espacées d'un temps $TR$ est considérée ici (Figure 1). Comme dans la plupart des séquences SSFP un gradient est appliqué ce qui produit un déphasage spatial entre les impulsions caractérisé par une fréquence spatiale :

$$\Delta k_z = 1/a = \frac{\gamma}{2\pi}\int_0^{TR} G(t)\mathrm{d}t \, , \tag{1}$$

Où $\gamma$ est le rapport gyromagnétique, $\alpha$ est une distance caractéristique correspondant à l'inverse d'une fréquence spatiale $\Delta k_z$ et $G(t)$ est la forme du gradient. Sans perdre en généralité, le déphasage net est représenté selon une direction arbitraire qui sera noté z. La variable $Z = \exp(-i2\pi\Delta k_z z)$ représente la modulation spatiale résultante entre deux excitations, caractérisée par l'aire totale des gradients entre les impulsions RF. Pour décrire l'aimantation dans de telles séquences répétées, le formalisme des états de configuration en 1D peut être utilisé dans lequel les composantes longitudinale et transversale sont décomposées en polynômes en $Z^{-1}$. Ces polynômes seront notés P et Q respectivement pour les composantes longitudinales et transversales. Ce formalisme a été proposé dans de multiples études soit sans modulation de phase RF (9,10,24,27,29-31), soit directement en l'incluant dans une approche 1D du graphe étendu de phase ou en utilisant des solutions analytiques (8,33). L'incrément de phase RF entre l'excitation $n$ et l'excitation $n$-1 sera noté $\varphi_n = \theta_n - \theta_{n-1}$. Cet incrément entre deux TRs permet de définir une fréquence apparente instantanée $\varphi_n/2\pi TR$. On considérera ici que l'incrément de phase est un multiple d'une phase $\Delta$, telle que $\varphi_n = v_n \times \Delta$, où $v_n$ est une série arbitraire de nombres entiers. Ceci permet introduire la variable $Y = \exp(-i\Delta)$. Pour simplifier les expressions, on peut considérer que la composante transversale est démodulée en utilisant la phase de l'impulsion RF précédente (le référentiel tournant à la fréquence d'émission (4)). De manière similaire au formalisme des états de configuration (8,9,27), l'aimantation peut être ainsi décomposée en une série 2D en $Y^{-1}$ et $Z^{-1}$ :

$$
\begin{aligned}
P_n &= \sum_{k=-\infty}^{k=\infty}\sum_{j=-\infty}^{j=\infty} p_{j,k,n} Y^{-j} Z^{-k} \\
Q_n &= \sum_{k=-\infty}^{k=\infty}\sum_{j=-\infty}^{j=\infty} q_{j,k,n} Y^{-j} Z^{-k}
\end{aligned}
\tag{2}
$$

### Effets de la relaxation, de la diffusion et de l'angle de bascule

Dans une revue récente (9), il a été rappelé que la relaxation et la diffusion peuvent être pris en compte par des opérations de convolution dans le domaine spatial avec des filtres appropriés. Cette convolution est équivalente à la multiplication terme-à-terme des coefficients de la série polynomiale selon la direction $Z^{-1}$. Pour garder la dérivation aussi générale que possible, l'évolution des composantes longitudinales et transversales entre deux impulsions sera synthétisée en utilisant un polynôme de pondération en $Z^{-1}$ :

$$W_1 = \sum_{k=-\infty}^{k=\infty} w_{1,k} Z^{-k}$$
$$W_2 = \sum_{k=-\infty}^{k=\infty} w_{2,k} Z^{-k}$$

(3)

Pour simplifier, la relaxation et la diffusion libre seront considérées ici pour lesquels les coefficients des polynômes de pondération de l'aimantation longitudinale $W_1$ et transversale $W_2$ sont réels, produisant une atténuation des coefficients de, respectivement, $P$ et $Q$. L'extension à d'autres types de polynômes de pondération est discutée plus loin. Les variables suivantes sont introduites pour prendre en compte la relaxation et la diffusion libre: $E_1 = \exp(-TR/T_1)$, $E_2 = \exp(-TR/T_2)$, $E_d = \exp(D \times TR \times (2\pi/a)^2) = \exp(-b \times D)$. Les variables $E_1$ et $E_2$ correspondent à l'atténuation résultante de la relaxation respectivement longitudinale et transversale entre les deux impulsions. La variable $E_d$ est une atténuation résultante de la diffusion libre, où $D$ est le coefficient de diffusion libre, et où $b$ est définie comme $b = TR \times (2\pi/\alpha)^2$. Dans l'annexe 1, les deux polynômes $W_1$ et $W_2$ sont exprimés en fonction de $E_1$, $E_2$ et $E_d$. Comme rapporté dans (27) et dans l'annexe 1, $W_1$ est un filtre Gaussien symétrique ($w_{1,k} = w_{1,-k}$), alors que $W_2$ dépend de la forme exacte du gradient ce qui permet d'atténuer sélectivement différents états de configuration selon $Z^{-1}$. L'évolution de la composante longitudinale $P_n$ juste après l'impulsion RF numéro $n$-1 jusqu'à $P_n^+$ juste avant l'impulsion numéro $n$ est donnée par:

$$P_n^+ = 1 - E_1 + W_1 * P_n,$$

(4)

expression dans laquelle la récupération longitudinale et la pondération de diffusion sont prises en compte.

La notation * représente l'opération de convolution, calculée comme la multiplication de $p_{j,k,n}$ avec les coefficients de pondération $w_{1,k}$ pour tous $j$ et $k$. La composante transversale de l'aimantation évolue en :

$$Q_n^+ = Y^{-v_n} Z^{-1} \left( W_2 * Q_n \right).$$

(5)

En effet, les coefficients de la composante transversale sont atténués (convolution avec $W_2$), et un déphasage additionnel est pris en compte : déphasage spatial résultant de l'aire de gradient non nulle (multiplication par $Z^{-1}$) et en plaçant l'aimantation selon un axe prête à être basculée à l'aide de l'impulsion RF à suivre ( $Y^{-v_n}$ ). Les parties réelles et imaginaires de $Q_n^+$ sont :

$$R_n = 1/2 \left( Q_n^+ + \overline{Q_n^+} \right)$$
$$I_n = 1/2 \left( Q_n^+ - \overline{Q_n^+} \right),$$

(6)

expression dans laquelle la barre représente le complexe conjugué. Puisque la démodulation a été réalisée par rapport à la phase de l'impulsion RF, seule la partie réelle de la composante transversale est affectés à l'impulsion RF suivante. Après l'impulsion RF numéro $n$, l'aimantation est basculée d'un angle $\alpha_n$ Par rapport au référentiel de la RF. Cela se traduit sur les polynômes comme :

$$P_{n+1} = c_n \left( 1 - E_1 + W_1 * P_n \right) - s_n R_n$$
$$Q_{n+1} = s_n \left( 1 - E_1 + W_1 * P_n \right) + c_n R_n + I_n$$

(7)

où $c_n = \cos(\alpha_n)$ et $s_n = \sin(\alpha_n)$. Dans cette description 2D des états de configuration, en partant de l'équilibre thermique pour lequel $P_0 = 1$ et $Q_0 = 0$ , il peut être facilement montré par récurrence que les coefficients $p_{j,k,n}$ et $q_{j,k,n}$ sont des nombres réels, ce qui simplifie le calcul itératif des coefficients des polynômes. Néanmoins, l'équation Eq.7 rend la relation de récurrence difficile à analyser.

### Simplification de la récurrence en utilisant le décalage apparent de fréquence

Pour prendre en compte le cyclage de phase RF et simplifier la relation de récurrence, un opérateur peut être introduit basé sur le polynôme suivant:

$$S_v = \sum_{k=-\infty}^{k=\infty} Y^{-kv} Z^{-k} \,. \qquad (8)$$

Comme montré dans l'annexe 2, ce polynôme a des propriétés de combinaisons $S_u * S_v = S_{u+v}$ et de symétrie $\overline{S_v} = S_v$. Appliqué à U, représentant un polynôme arbitraire en $Y^{-1}$ et $Z^{-1}$, l'effet du cyclage de phase peut être simplifié en $Y^{-v}Z^{-1}$ $(S_v * U) = S_v * (Z^{-1} U)$. En exploitant ces propriétés, l'aimantation peut être décrite comme des polynômes déconvolués : $P_n^{\,s} = S_{-v_n} * P_n$, $Q_n^{\,s} = S_{-v_n} * Q_n$. Ceci est équivalent à effectuer une démodulation de l'aimantation par rapport à la fréquence instantanée apparente. Après l'introduction de ces expressions dans la relation de récurrence, on obtient des expressions simplifiées par rapport au cyclage de phase RF :

$$
\begin{aligned}
S_{u_{n+1}} * P_{n+1}^{\,s} &= c_n \left( 1 - E_1 + W_1 * P_n^{\,s} \right) - s_n R_n^{\,s} \\
S_{u_{n+1}} * Q_{n+1}^{\,s} &= s_n \left( 1 - E_1 + W_1 * P_n^{\,s} \right) + c_n R_n^{\,s} + I_n^{\,s} \\
R_n^{\,s} &= \frac{1}{2} \left[ Z^{-1}\left( W_2 * Q_n^{\,s} \right) + \overline{Z^{-1}\left( W_2 * Q_n^{\,s} \right)} \right] \\
I_n^{\,s} &= \frac{1}{2} \left[ Z^{-1}\left( W_2 * Q_n^{\,s} \right) - \overline{Z^{-1}\left( W_2 * Q_n^{\,s} \right)} \right]
\end{aligned}
\qquad (9)
$$

dans lesquelles $u_{n+1} = v_{n+1} - v_n$. Comme $v_n \times \Delta/2\pi TR$ représente une fréquence instantanée apparente, $u_{n+1} \times \Delta/2\pi TR^2$ représente un décalage apparent de fréquence entre deux TRs. Dans le cas général d'une modulation aussi bien en amplitude qu'en phase, en combinant l'équation Eq.9, on obtient :

$$S_{u_{n+1}} * \left( c_n Q_{n+1}^{\,s} - s_n P_{n+1}^{\,s} \right) = R_n^{\,s} + c_n I_n^{\,s} \qquad (10)$$

Ce qui permet d'exprimer le polynôme longitudinal $P_n^{\,s}$ en fonction du polynôme transversal :

$$S_{u_n} * s_{n-1} P_n^{\,s} = S_{u_n} * c_{n-1} Q_n^{\,s} - R_{n-1}^{\,s} - c_{n-1} I_{n-1}^{\,s} \,, \qquad (11)$$

et la relation de récurrence en fonction du polynôme transversal sur trois itérations consécutives :

$$s_{n-1} S_{u_{n+1}+u_n} * Q_{n+1}^{\,s} = s_{n-1} s_n \left( 1 - E_1 \right) + S_{u_n} * \left( s_n c_{n-1} W_1 * Q_n^{\,s} + c_n R_n^{\,s} + I_n^{\,s} \right) - s_n W_1 * \left( R_{n-1}^{\,s} + c_{n-1} I_{n-1}^{\,s} \right) \qquad (12)$$

Cette expression indique que, au lieu d'utiliser $P_n$ et $Q_n$ pour obtenir $P_{n+1}$ et $Q_{n+1}$, il est possible simplement d'étudier les deux polynômes transversaux correspondant aux itérations précédentes $Q_n$ et $Q_{n-1}$ pour obtenir $Q_{n+1}$, à partir duquel $P_{n+1}$ peut être déduit en utilisant l'équation Eq.11. En fonction du choix de la série d'amplitude $\alpha_n$, et de la série de décalage apparent de fréquence résumé par la série $u_n$, la relation de récurrence peut-être exploitée à volonté.

### Etats stationnaires

Les coefficient de l'équation Eq.12 ne dépend pas de $n$ si et seulement si l'opérateur $S_{u_n}$, est constant ainsi que l'amplitude de l'angle (soit $c_n = c$ et $s_n = s$). Dans ce cas $u_{n+1} = v_{n+1} - v_n = 1$ est une solution qui implique $v_n = n + v_0$ soit une évolution linéaire de l'incrément de phase $\varphi_n = (n + v_0)\Delta$, menant au cyclage quadratique standard pour $\theta_n$. C'est une version discrète, avec son repliement associé, d'une expérience de décalage progressif de la fréquence avec un taux constant. On notera au passage la présence de $v_0$ qui équivaut à une fréquence centrale différente de l'impulsion RF et qui indique donc que ce paramètre n'est pas déterminant pour atteindre un état stationnaire tant que les impulsions RF sont considérées comme instantanées. Il est connu, à partir de simulations et grâce aux effets d'atténuation, qu'un état stationnaire $Q_\infty^{\,s}$ est atteint pour lequel :

$$S_2 * Q_\infty^{\ s} = s\left(1 - E_1\right) + S_1 * \left(cW_1 * Q_\infty^{\ s} + cR_\infty^{\ s} + I_\infty^{\ s}\right) - W_1 * \left(R_\infty^{\ s} + cI_\infty^{\ s}\right) \tag{13}$$

Un autre avantage résultant de la discrétisation est la possibilité de jouer sur la relation de récurrence pour atteindre de multiples états stationnaires entrelacés avec des séries périodiques $\alpha_n$ et $u_n$. Par exemple, si on alterne l'amplitude de l'angle telle que $\alpha_{2n} = \alpha$ et $\alpha_{2n+1} = \alpha'$ ainsi que le décalage de fréquence apparente avec $u_{2n} = u$ et $u_{2n-1} = u'$, deux états stationnaires $Q_\infty^s$ et $Q_\infty^{s'}$ seront atteints tels que :

$$s'S_{u+u'} * Q_\infty^{\ s'} = s's\left(1 - E_1\right) + S_u * \left(sc'W_1 * Q_\infty^{\ s} + cR_\infty^{\ s} + I_\infty^{\ s}\right) - sW_1 * \left(R_\infty^{\ s'} + c'I_\infty^{\ s'}\right)$$

$$sS_{u+u'} * Q_\infty^{\ s} = ss'\left(1 - E_1\right) + S_{u'} * \left(s'cW_1 * Q_\infty^{\ s'} + c'R_\infty^{\ s'} + I_\infty^{\ s'}\right) - s'W_1 * \left(R_\infty^{\ s} + cI_\infty^{\ s}\right) \tag{14}$$

Cette périodisation de la série d'angle permet de sensibiliser différemment les états stationnaires en fonction des paramètres physiques et de séquences d'une manière entrelacée, permettant potentiellement d'introduire des procédés de quantification basées sur ces équilibres entrelacés.

### *Représentation graphique et implémentation*

Pour synthétiser l'action des différents opérateurs impliqués, une représentation graphique des décalages d'indice peut être utilisée à partir de la décomposition 2D en états de configuration définie en utilisant les fonctions de base $Y^{-1}$ et $Z^{-1}$. A partir de l'équation Eq.9, on peut voir que la relation de récurrence peut être décomposée en opérations élémentaires représentées sur la Figure 2. Si on considère un polynôme U (Figure 2a), l'action de la convolution avec un polynôme de pondération est équivalent à une multiplication terme à terme de tous les coefficients ayant le même indice k selon $Z^{-1}$ (Figure 2b). La relaxation longitudinale vers l'état d'équilibre thermique est également prise en compte en ajoutant le cosinus et le sinus de $(1-E_1)$ au centre ($j=0$, $k=0$), respectivement pour P et Q. La multiplication par $Z^{-1}$ correspond à un décalage d'indice ($k \to k+1$, Figure 2c), le complexe conjugué est une symétrie centrale $j \to -j$, $k \to -k$ (Figure 2d, les coefficients sont réels). La convolution avec $S_{-v}$ 'penche' les coefficients tel que $j \to j-k.v$ (Figure 2e).

Pour calculer les signaux transitoires et stationnaires pour $N_y \times N_z$ états de configuration et des séries d'amplitude et de phase arbitraires, un calcul par récurrence peut être réalisé à partir de l'équation Eq.9 sur des grilles 2D pour $P_n^s$ et $Q_n^s$ avec $j \in [-N_y/2+1, N_y/2]$ et $k \in [-N_z/2+1, N_z/2]$ initialisés à l'équilibre thermique ($P_0^s=1$, $Q_0^s=0$). Pour obtenir l'ordre k de l'aimantation effectivement mesuré, une transformée de Fourier de $Q_n^s$ peut être réalisée selon la direction $Y^{-1}$ ce qui fournit directement les valeurs pour tous les incréments $\Delta$. Notons que la discrétisation selon $Y^{-1}$ (le fait de ne prendre que $N_y$ pas) peut être traitée en implémentant le repliement dans l'opérateur de décalage $S_{-v}$. En revanche, la limitation du nombre de pas dans la direction $Z^{-1}$ nécessite d'estimer quand les coefficients des différents polynômes deviennent négligeables. Pour estimer cette valeur $N_z$ de pas nécessaire, on peut considérer la relaxation transversale et la diffusion car leur action tend à atténuer la composante transversale. Lors du transfert d'état avec le terme $Z^{-1}\left(W_2 * Q_n^{\ s}\right)$, en considérant $k>0$ avec un transfert vers l'état $k+1$, l'atténuation des coefficients est de l'ordre de $E_2 E_d^{\ k^2}$ $E_2 E_d^{k2}$, si bien que l'atténuation cumulée depuis l'ordre zéro jusqu'à k est de l'ordre de $E_2^{\ k} E_d^{\ k^3/3}$. On peut alors définir une limite sur l'atténuation cumulée $E_{\lim,2}$ des coefficients, ce qui permet d'estimer l'ordre k qui produirait cette atténuation via la relaxation : $k_2 = \ln(E_{\lim,2})/\ln(E_2)$, ou via la diffusion : $k_{diff} = \sqrt[3]{3\ln\left(E_{\lim,2}\right)/\ln\left(E_d\right)}$ (arrondis à l'entier le plus proche). Le minimum $N_z = 2 \times \min(k_2, k_{diff})$ fournit alors une estimation du nombre d'ordre à considérer dans le calcul. Si $k_{diff} > k_2$, cela implique également un effet limité de la diffusion par rapport à la relaxation transversale.

Bien qu'applicable à des séries d'impulsions arbitraires, le cas de séries périodiques permet d'atteindre un état stationnaire. Le calcul de cet état nécessite un nombre d'itérations suffisantes $n_{eq}$. Si l'on considère $T_1 > T_2$, la relaxation longitudinale apparaît comme le facteur limitant pour atteindre l'équilibre. De manière similaire, définir une limite pour l'atténuation cumulée à $E_{\lim,1}$ fournit un ordre de grandeur du nombre de répétitions nécessaires pour atteindre l'état stationnaire $n_{eq} = \ln(E_{\lim,1})/\ln(E_1)$. Numériquement, un critère tel que la variation relative peut être utilisé pour arrêter le calcul itératif. On notera que le cas particulier du signal SSFP atteint avec cyclage quadratique de la phase et angle constant ($\alpha_n = \alpha$, $u_n = 1$) peut être calculé plus efficacement. Cet aspect a été proposé par ailleurs avec de la relaxation (33). Pour prendre en compte des polynômes de pondération $W_1$ et $W_2$ quelconque, notamment incluant la diffusion, une dérivation similaire basée sur la formulation d'un système linéaire tridiagonal est donnée dans l'annexe 3 pour calculer efficacement l'état stationnaire avec cyclage quadratique de phase et angle constant.

### Effets hors-résonance et de flux

Le procédé de calcul proposé est de préférence mis en œuvre avec une fréquence de résonance qui est exactement celle de l'impulsion RF d'excitation. En pratique, le champ statique $B_0$ n'est pas parfaitement homogène ce qui produit des effets sur le signal mesuré. Les effets hors-résonance tout comme les déphasages induits par le mouvement produisent une modulation de phase supplémentaire $\varphi_0 = \gamma\Delta B_0 TR + \pi v/V_{enc}$ , où $\Delta B_0$ représente les inhomogénéités de champ ou éventuellement le décalage chimique, et ou $V_{enc}$ représente le codage de vitesse lié au moment d'ordre 1 de la forme du gradient. En introduisant l'exponentielle complexe $Z_0 = \exp(-i\varphi_0)$, l'action de ce déphasage supplémentaire selon $Z^{-1}$ dans la représentation 2D en état de configuration (9) est exprimée de manière similaire en considérant un polynôme déphasé en $Y^{-1}$ et $(Z_0 Z)^{-1}$ pour lequel tous les coefficients restent réels comme dans le cas précédemment considéré. Entre la fin de l'impulsion RF et le temps d'écho, le signal est atténué par les effets de la relaxation transversale apparente $E_2^* = \exp\left(-TE/T_2^*\right)$ et déphasé d'un facteur $Z_{TE} = \exp(\varphi_{TE})$ avec $\varphi_{TE} = \varphi_1 + \gamma\Delta B_0 TE + \varphi_v$ qui inclus un éventuel déphasage $\varphi_1$ entre l'émission et la réception, les effets de l'inhomogénéité du champ $B_0$ et de codage de vitesse éventuel $\varphi_v$ .

### Variante du premier mode de réalisation d'un procédé et d'un dispositif selon l'invention : imagerie multiparamétrique ; Implémentation d'un problème inverse basé sur l'acquisition de l'état k=0

Dans une variante (dite « d'imagerie multiparamétrique ») du premier mode de réalisation de procédé selon l'invention mis en œuvre par le premier mode de réalisation de dispositif selon l'invention (et décrite uniquement par rapport à ses différences ou particularités par rapport à ce premier mode de réalisation), le procédé selon l'invention comprend :

- une acquisition d'un signal (de préférence pour l'ordre de cohérence égal à zéro) pour des états d'équilibres correspondants à des amplitudes différentes de l'impulsion radiofréquence et/ou des $\Delta$ différents et/ou différentes valeurs de la suite $u_{n+1} = v_{n+1} - v_n$ périodique constante ou non, les moyens de commande 5 étant agencés pour ou programmés pour commander les moyens d'acquisition 6 pour effectuer une telle acquisition, et
- pour au moins un point dans l'échantillon, une détermination (par les moyens de calcul 7, qui sont agencés pour ou programmés pour cela) de plusieurs données (de préférence au moins 3, de préférence toutes) parmi une aimantation nucléaire, un angle de bascule de l'aimantation, un coefficient de diffusion, un taux ou temps de relaxation longitudinal R1 ou T1, et un taux ou temps de relaxation transversal R2 ou T2, à partir du signal acquis pour ces états d'équilibres.

Comme nous le verrons plus en détails par la suite, la détermination est de préférence effectuée, (par les moyens de calcul 7, qui sont agencés pour ou programmés pour cela) soit par comparaison avec un dictionnaire précalculé soit par estimation itérative, selon une minimisation d'une norme de la différence entre le signal acquis exprimé sous forme complexe avec une partie réelle et une partie imaginaire et un modèle du signal exprimé sous forme complexe avec une partie réelle et une partie imaginaire. Dans l'exemple, la minimisation comprend un algorithme de minimisation au sens des moindres carrés, de préférence en utilisant l'algorithme de Gauss-Newton appliqué aux problèmes non-linéaires.

On peut se placer, pour cette variante d'imagerie multiparamétrique, dans le cas dans lequel on exploite des états d'équilibre séquentiels tels que précédemment décrit avec plusieurs ensembles d'applications de séquence. Dans ce cas, cette variante d'imagerie multiparamétrique comprend une acquisition d'un signal (de préférence pour l'ordre de cohérence égal à zéro) pour des états d'équilibres (de préférence avec une suite $u_{n+1} = v_{n+1} - v_n$ constante pour chaque ensemble) correspondants à des $\Delta$ différents (les moyens de commande 5 étant agencés pour ou programmés pour commander les moyens d'acquisition 6 pour effectuer une telle acquisition), dont :

- plusieurs points pour une valeur absolue de $\Delta$ proches de 0°, entre $\Delta$=0° inclus et $\Delta$=32° inclus modulo 360°, et/ou
- plusieurs points pour une valeur absolue de $\Delta$ proches de 180°, entre $\Delta$=164° inclus et $\Delta$= 196° inclus modulo 360°, et/ou
- plusieurs points pour une valeur absolue de $\Delta$ proches de 120°, entre $\Delta$=112° inclus et $\Delta$=128° inclus modulo 360°, et/ou
- plusieurs points, pour une valeur absolue de $\Delta$ parmi 45°, 60°, 72°, 90°, et 144° modulo 360°

pour un total de préférence d'au moins cinq points.

On voit sur les figures 6 et 7 l'intérêt de ces points, en particulier proches de 0°, 120° et 180°.

Dans cette variante d'imagerie multiparamétrique, l'amplitude de l'impulsion radiofréquence correspond toujours à un angle de bascule de l'aimantation :

- supérieur à l'angle de Ernst pour un temps de relaxation longitudinal T1 égal à 2000 millisecondes (ce qui laisse la liberté sur le TR et sur le type de tissu ciblé), et
- inférieur ou égal à 90°

les moyens de commande 5 étant agencés pour ou programmés pour cela.

Dans cette variante d'imagerie multiparamétrique, la détermination peut comprendre une condition de continuité spatiale de chacune des données déterminées parmi l'aimantation nucléaire, de l'angle de bascule de l'aimantation, du coefficient de diffusion, du taux ou temps de relaxation longitudinal R1 ou T1, et du taux ou temps de relaxation transversal R2 ou T2 entre différents points de l'échantillon (les moyens de commande 5 étant agencés pour ou programmés pour cela), de préférence l'angle de bascule.

Nous allons à présent expliquer plus en détail cette variante d'imagerie multiparamétrique par un premier exemple détaillé. De multiples procédés d'imagerie paramétrique ont été proposées basées sur l'acquisition de plusieurs états k (28-31), mais beaucoup moins basées sur différents cyclage de phase (33-35). Pour illustrer le calcul direct selon la variante « d'imagerie multiparamétrique » selon l'invention et le valider en présence de relaxation et de diffusion, un problème inverse est proposé basé sur l'acquisition de l'état $k$=0. La description faite ici considère le cas du signal à l'état stationnaire pour un angle constant en amplitude $\alpha$ et avec des incréments quadratiques de phases différents, mais l'expression est générale et peut être étendue aux autres cas d'équilibres stationnaires, ou même au cas de phases transitoires (hors équilibre dynamique). Pour chaque voxel de l'espace image, les signaux mesurés sont placés dans un vecteur noté $Q_{0,mes}$. Le problème inverse est exprimé comme une minimisation au sens des moindres carrés :

$$\min_{M, E_1, E_2, E_d, \alpha} \left\| Q_{0,mes} - M \times Q_0 \left( E_1, E_2, E_d, \alpha \right) \right\|^2 . \qquad (15)$$

Dans cette expression, un certain nombre de paramètres sont inconnus : M qui représente l'amplitude du signal au temps d'écho, les atténuations par relaxation et par diffusion, ainsi que l'amplitude de l'angle effectivement réalisé. De multiples procédés peuvent être utilisés pour résoudre ce problème des moindres carrés non-linéaires. Une implémentation basée sur la combinaison d'une initialisation par comparaison à un dictionnaire, suivie par l'application de l'algorithme de Gauss-Newton est proposée ici. Tout d'abord, on peut noter que le problème est linéaire en $M$, de sorte que si le vecteur modèle $Q_0(E_1, E_2, E_d, \alpha)$ est connu, alors la meilleure solution pour M au sens des moindres carrés est :

$$M = Q_0^H Q_{0,mes} \big/ Q_0^H Q_0 . \qquad (16)$$

La notation en exposant $^H$ représente la transposée Hermitienne du vecteur $Q_0$.

Pour initialiser les paramètres à $(M_{init}, E_{1,init}, E_{2,init}, E_{d,init}, \alpha_{init})$, on peut calculer $E_{d,init}$ en considérant le coefficient de diffusion libre de l'eau et choisir $\alpha_{init}$ comme étant l'angle prescrit. Cela réduit le calcul de $Q_0$ à deux dimensions (selon $E_1$ et $E_2$) et différentes valeurs pour $E_1$ et $E_2$ peuvent être choisies dans la gamme de 0 à 1. L'estimation linéaire de $M$ pour chaque couple de valeurs $(E_1, E_2)$ en utilisant l'équation Eq.16 permet de choisir des valeurs $(M_{init}, E_{1,init}, E_{2,init})$ qui minimise la norme résiduelle donnée par l'équation Eq.15. Par la suite, dans le calcul non-linéaire itératif, le signal est normalisé par l'estimation de $M$, et, pour s'assurer que des valeurs physiques d'atténuation sont obtenues, on effectue un changement de variables avec $E_1 = \exp(-1/x_1^2)$, $E_2/E_1 = \exp(-1/x_{2/1}^2)$, $E_d = \exp(-1/x_d^2)$. La matrice Jacobienne est alors donnée par :

$$J = \begin{bmatrix} \mathrm{real}(Q_0) & \mathrm{real}\left(\dfrac{\partial Q_0}{\partial x_1}\right) & \mathrm{real}\left(\dfrac{\partial Q_0}{\partial x_{2/1}}\right) & \mathrm{real}\left(\dfrac{\partial Q_0}{\partial x_d}\right) & \mathrm{real}\left(\dfrac{\partial Q_0}{\partial \alpha}\right) \\ \mathrm{imag}(Q_0) & \mathrm{imag}\left(\dfrac{\partial Q_0}{\partial x_1}\right) & \mathrm{imag}\left(\dfrac{\partial Q_0}{\partial x_{2/1}}\right) & \mathrm{imag}\left(\dfrac{\partial Q_0}{\partial x_d}\right) & \mathrm{imag}\left(\dfrac{\partial Q_0}{\partial \alpha}\right) \end{bmatrix}, \qquad (17)$$

et peut être calculée numériquement au vecteur initial $[1, x_{1,init}, x_{2/1,init}, x_{d,init}, \alpha_{init}]^T$. Un vecteur de mise-à-jour est ensuite obtenu par :

$$\left[ dr, dx_1, dx_{2/1}, dx_d, d\alpha \right]^T = \left( J^H J \right)^{-1} J^H \begin{bmatrix} \text{real}(Q_0) - \text{real}(Q_{0,mes}/M) \\ \text{imag}(Q_0) - \text{imag}(Q_{0,mes}/M) \end{bmatrix}. \tag{18}$$

Les fonctions *real* et *imag* représentent respectivement les parties réelles et imaginaires. L'addition de ce vecteur mise-à-jour à l'estimation précédente affine la solution. M peut ensuite être réestimé comme $M \times (1 + dr)$ et utilisé pour normaliser le signal mesuré pour la prochaine itération. La procédure est répétée jusqu'à ce que la variation relative de la norme résiduelle donnée par l'équation Eq.15 soit suffisamment petite. La matrice $J^H J$ est supposée inversible. Si l'on considère la nature Gaussienne du bruit en IRM, caractérisé par sa variance $\sigma^2$ identique sur les parties réelles et imaginaires, la matrice d'information de Fisher (36) est égale à $F = (|M|/\sigma)^2 J^H J$. Si elle est inversible, son inverse $F^{-1} = (\sigma/|M|)^2 (J^H J)^{-1}$ représente la matrice de covariance du bruit à partir de laquelle les bornes inférieures de Cramer-Rao peuvent être extraites pour estimer la précision sur les paramètres ajustés si un estimateur non biaisé est obtenu à l'aide de l'algorithme proposé. Si la matrice de Fisher n'est pas inversible ou est mal conditionnée, la pseudo-inverse est calculé pour assurer la stabilité numérique. De plus, des contraintes peuvent être ajoutées sur les paramètres pour éviter d'obtenir des valeurs aberrantes et réduire les instabilités numériques : M est positif, l'angle de bascule reste dans une gamme déterminée (de 2° à 90° par exemple), les termes d'atténuation sont bornés entre exp(-1) et exp$(-10^{-4})$. Cette procédure d'ajustement générique peut-être adaptée aussi bien à l'ajustement du signal transitoire, qu'inclure des acquisitions obtenues de manière entrelacée ou séquentielle en faisant varier les séries d'impulsions RF.

Si l'exemple de cette variante d'imagerie multiparamétrique venant d'être détaillé se place dans le contexte d'équilibres séquentiels avec plusieurs ensembles n'ayant chacun qu'un seul équilibre dynamique, cette variante d'imagerie multiparamétrique peut aussi être mis en œuvre selon l'invention avec plusieurs ensembles en exploitant des états d'équilibres entrelacés (de préférence au moins 2 états d'équilibre entrelacés), ainsi :

- dans un second exemple, on utilisera plutôt une suite $u_{n+1} = v_{n+1} - v_n$ constante, $\Delta$ bien évidemment constant pour chaque ensemble, et l'amplitude de l'impulsion radiofréquence qui suit une suite périodique non constante (avec donc une période au moins égale à deux répétitions avec deux amplitudes différentes suffisamment différentes entre 0° et 90°, de manière à obtenir les au moins deux états d'équilibres entrelacés différents), comme montré sur les figures 6c et 6d. Pour chaque point d'intérêt de l'échantillon, les données (aimantation nucléaire, angle de bascule de l'aimantation, coefficient de diffusion, taux ou temps de relaxation longitudinal R1 ou T1, et taux ou temps de relaxation transversal R2 ou T2) sont alors déterminées avec l'ajustement proposé, comme montré sur les figures 7c et 7d. On notera que l'utilisation d'amplitudes différentes n'ajoute pas d'inconnue au problème inverse car, s'il peut y avoir une incertitude sur l'angle de basculement réalisé avec une amplitude donnée, les angles sont proportionnels à la série d'amplitude. On adaptera donc par exemple l'ajustement en considérant l'angle le plus grand de la série d'amplitude comme une inconnue à déterminer, les autres angles étant directement proportionnels à cet angle d'un facteur connu déduit de la suite d'amplitude imposée.

- Dans un troisième exemple, on utilisera plutôt une amplitude de l'angle constante et une série $u_{n+1} = v_{n+1} - v_n$ périodique non constante avec $\Delta$ constant pour chaque ensemble, mais prioritairement proche de 0° et/ou proche de 180°, comme montré sur la figure 6b. Pour chaque point d'intérêt de l'échantillon, les données (aimantation nucléaire, angle de bascule de l'aimantation, coefficient de diffusion, taux ou temps de relaxation longitudinal R1 ou T1, et taux ou temps de relaxation transversal R2 ou T2) sont alors déterminées avec l'ajustement proposé.

Evidemment, on peut imaginer cette variante « d'imagerie multiparamétrique » en mélangeant l'acquisition séquentielle d'états d'équilibres entrelacés générés par la périodicité de l'amplitude et de la suite $u_{n+1} = v_{n+1} - v_n$, par exemple en mélangeant le second exemple et le troisième exemple. Le cas extrême de l'acquisition d'un seul ensemble d'équilibres entrelacés avec des suites périodiques non constante d'amplitude et/ou $u_{n+1} = v_{n+1} - v_n$ non constante est également possible. Pour cela, on choisira de préférence :

- Dans le cas où l'amplitude est constante, $u_{n+1} = v_{n+1} - v_n$ non constante aura une périodicité de préférence d'au moins cinq points et $\Delta$ sera constant d'une valeur de préférence de 180°. La suite $u_{n+1} = v_{n+1} - v_n$ pourra être choisie arbitrairement.

- Dans le cas où la suite d'amplitude sera périodique non constante de préférence d'une période d'au moins cinq répétitions, la suite $u_{n+1} = v_{n+1} - v_n$ pourra être choisi soit constante soit non-constante avec la même période. On choisira $\Delta$, qui est alors unique et constant pour ce seul ensemble, de préférence d'une valeur de 0° ou de 180° ou proche de ces valeurs. La suite d'amplitude pourra être choisie arbitrairement entre -90° et 90° avec des valeurs suffisamment différentes entre elles, par exemple réparties uniformément entre 0° et 90°. La suite $u_{n+1} = v_{n+1} - v_n$ pourra être choisie arbitrairement, de préférence avec une moyenne nulle sur la période.

Pour chaque point d'intérêt de l'échantillon, les données (aimantation nucléaire, angle de bascule de l'aimantation, coefficient de diffusion, taux ou temps de relaxation longitudinal R1 ou T1, et taux ou temps de relaxation transversal R2 ou T2) sont alors déterminées avec l'ajustement proposé. De manière similaire, on adaptera l'ajustement dans le cas d'amplitude périodique non-constante par exemple en considérant l'angle le plus grand de la série d'amplitude comme une inconnue à déterminer, les autres angles étant directement proportionnels à cet angle d'un facteur connu déduit de la suite d'amplitude imposée.

### Choix des paramètres d'acquisition pour optimiser la mesure des paramètres physiques

Comme rappelé précédemment, la matrice d'information de Fisher $F = (|M|/\sigma)^2\, J^H J$ permet de caractériser la qualité de la détermination multiparamétrique à l'aide de son inverse la matrice de covariance $F^{-1} = (\sigma/|M|)^2 (J^H J)^{-1}$, en utilisant par exemple les bornes de Cramer-Rao. Ainsi, en utilisant des techniques d'optimisation connues de l'homme de l'art et listées de manière non-exhaustive plus loin, il est possible de prédéfinir les paramètres d'acquisition au regard de critère prédéfinis pour une détermination multiparamétrique de paramètres physiques cibles. Les paramètres d'acquisition à définir pour l'imagerie multiparamétrique sont :

- l'amplitude et/ou la série d'amplitude de l'impulsion radiofréquence pour l'ensemble ou pour les ensembles utilisés pour déterminer les paramètres, étant précisé que ces valeurs peuvent être différentes pour chaque ensemble, et/ou
- la valeur de la suite $u_{n+1} = v_{n+1} - v_n$ et de l'incrément de phase $\Delta$ pour l'ensemble ou pour les ensembles utilisés pour déterminer les paramètres, étant précisé que ces valeurs peuvent être différentes pour chaque ensemble, et/ou
- la valeur de A pour l'ensemble ou pour les ensembles utilisés pour déterminer les paramètres, étant précisé que ces valeurs peuvent être différentes pour chaque ensemble, et/ou
- la valeur de TR pour l'ensemble ou pour chaque ensemble utilisé pour déterminer les paramètres, étant précisé que ces valeurs peuvent être différentes pour chaque ensemble.
- le nombre d'ensemble(s).

Dans un deuxième temps, on peut définir les limites réalisables physiquement sur les paramètres d'acquisition de l'ensemble ou des différents ensembles :

- les valeurs possibles d'amplitude de l'angle de bascule, typiquement entre 0° et 90°, éventuellement discrétisé par pas de 1°, et/ou
- les valeurs possibles de la suite $u_{n+1} = v_{n+1} - v_n$, par exemple en se limitant à des séries périodiques constantes ou périodiques non-constantes en fixant la périodicité, et/ou
- les valeurs possible d'incrément de phase $\Delta$, typiquement discrétisé de 0° à 359° par pas de 1°, et/ou
- les valeurs possible de A, typiquement produisant une distance caractéristique $a$ comprise entre la taille du pixel selon la direction de la lecture (obtenu par une valeur $A_{min}$) et une fraction de cette distance (produisant une valeur $A_{max}$). Les valeurs possibles de A peuvent être de préférence discrétisées sous forme de multiples de $A_{min}$ inférieurs à $A_{max}$. La valeur de $A_{max}$ peut être déterminée à partir des limites physiques du système de gradient (gradient maximum autorisé, durée d'application maximum disponible, puissance dissipée), et/ou
- les valeurs possibles de TR, éventuellement données de manière discrétisées entre 5ms et 100ms, et/ou
- le nombre total d'ensemble(s) et/ou la période des séries d'amplitude et de phase de l'impulsion radiofréquence qui peut être fixé pour obtenir un temps total d'acquisition donné pour tous les ensembles.

Pour réaliser l'optimisation menant au choix optimaux de paramètres d'acquisition, on définit ensuite un critère exprimé sous forme d'une fonction de coût. La littérature propose une série de définitions de la fonction de coût qui peuvent exprimer le problème d'optimisation à partir de la matrice d'information de Fisher ou de son inverse, étant entendu que celles-ci peuvent être normalisées pour donner plus ou moins de poids à des paramètres prédéterminés. La normalisation peut classiquement être réalisée à l'aide d'un changement de variable du type Paramètre normalisé = Paramètre divisé par une valeur typique du paramètre. Dans un autre mode de réalisation, la fonction de coût peut prendre en compte la durée totale de l'acquisition. Il s'agit de diviser la matrice d'information de Fisher par le temps total d'acquisition ou de manière équivalent de multiplier son inverse par le temps total d'acquisition. Ceci est équivalent à baser l'optimisation sur l'information obtenue par unité de temps. On peut avoir ainsi de manière non-exhaustive les fonctions de coût suivantes :

- la minimisation du déterminant de l'inverse ou de l'inverse normalisée de la matrice de Fisher, et/ou

- la minimisation de la trace de l'inverse de la matrice de Fisher ou de la matrice de Fisher normalisée : on réalise ainsi une minimisation de la somme des variances, et/ou
- la minimisation de la variance d'un seul élément diagonal de l'inverse de la matrice de Fisher : on réalise ainsi une optimisation de la détermination d'un seul des paramètres indépendamment des autres, et/ou
- la minimisation d'une somme présélectionnée d'éléments diagonaux de l'inverse de la matrice de Fisher ou de l'inverse normalisée : on réalise ainsi une optimisation simultanée de la détermination de plusieurs paramètres présélectionnés.

Pour définir la fonction de coût à optimiser, on peut se baser sur l'évaluation de la matrice de Fisher pour des valeurs typiques de rapport $|M|/\sigma$, de temps de relaxation et de coefficients de diffusion. On peut donc dans un deuxième temps :

- pour un champ magnétique donné (de préférence 1.5T, 3T, 7T), obtenir de la littérature ou de mesures de pré-calibration les valeurs typiques des temps de relaxation et des coefficients de diffusion pour un ou plusieurs tissus cibles, et/ou
- calculer la fonction de coût pour chaque combinaison de paramètres de relaxation et de coefficient de diffusion pour chaque tissu cible. On possède à ce stade une fonction de coût pour chaque tissu cible. On peut définir une fonction de coût globale correspondant à la somme des fonctions de coût de chaque tissu cible considéré en donnant éventuellement un poids relatif à chaque tissu.

Une fois la fonction de coût globale définie pour les valeurs réalisables des paramètres d'acquisition, le problème de la définition optimale de ces paramètres est réduit à minimiser le coût. Différents algorithmes connus de l'homme de l'art peuvent être utilisés :

- les évaluations exhaustives sur tout le domaine des valeurs réalisables des paramètres d'acquisition. On retiendra le jeu de paramètre correspondant au minimum de la fonction de coût, et/ou
- les algorithmes de recherche plus avancés, par exemple du type algorithme par pression de sélection ou algorithmes génétiques.

Comme exemple de modes de réalisation, on liste les variantes suivantes :

Variante 1 : Le ou les ensembles sont au préalable contraints d'avoir :

- une suite $u_{n+1} = v_{n+1} - v_n$ fixée, de préférence constante
- des valeurs d'incrément de phase $\Delta$ fixées différentes entre les ensembles
- un nombre d'ensembles fixé
- une valeur de A fixé identique entre les ensembles
- un TR fixé identique entre les ensembles
- les ensembles ont tous le même angle de bascule qui est donc le seul paramètre restant à déterminer et qui est rapidement obtenu par une recherche exhaustive.

Variante 2 : Le ou les ensembles sont au préalable contraints d'avoir :

- une suite $u_{n+1} = v_{n+1} - v_n$ fixée, de préférence constante
- une valeur de A fixé identique entre les ensembles
- un TR fixé identique entre les ensembles
- un angle de bascule fixé identique entre les ensembles
- des valeurs d'incrément de phase $\Delta$ qui peuvent prendre n'importe quelle prédéfinie, de préférence dans la gamme de 0° à 359° par pas de 1°
- un nombre d'ensemble à déterminer.

L'algorithme d'optimisation peut alors par exemple utiliser la fonction de coût basée sur la matrice de Fisher normalisée par unité de temps. Le jeu de valeurs de $\Delta$ à acquérir peut être initialisé à toutes les mesures de $\Delta$ possibles dans la gamme prédéfinie. La fonction de coût est recalculée en retirant chaque valeur de $\Delta$ du jeu de valeurs courant. La valeur de $\Delta$ qui est ensuite effectivement éliminée du jeu courant correspond à celle qui réduit le plus la fonction de coût. Si la fonction de coût ne peut pas être réduite par l'élimination d'une valeur du jeu courant, l'algorithme s'arrête et la solution optimale est retenue fixant les valeurs de $\Delta$ à acquérir ainsi que le nombre d'ensemble.

Variante 3 : Le ou les ensembles sont au préalable contraints d'avoir :

- une suite $u_{n+1} = v_{n+1} - v_n$ fixée, de préférence constante
- un nombre d'ensemble(s) $N_{ensembles}$ à acquérir fixé, de préférence à partir du temps d'acquisition total disponible et de préférence supérieur à 4, typiquement entre 5 et 20.
- des valeurs de TR à déterminer parmi des valeurs discrètes prédéfinies qui peuvent être différentes entre les ensembles
- des valeurs de A à déterminer parmi des valeurs discrètes prédéfinies qui peuvent être différentes entre les ensembles
- des angles de bascule à déterminer parmi des valeurs discrètes prédéfinies qui peuvent être différentes entre les ensembles
- des valeurs d'incrément de phase $\Delta$ à déterminer parmi des valeurs discrètes prédéfinies qui peuvent être différentes entre les ensembles

L'algorithme d'optimisation peut alors par exemple utiliser la fonction de coût basée sur la matrice de Fisher normalisée par unité de temps. L'algorithme d'optimisation peut alors par exemple être initialisé en choisissant au hasard $N_{ensembles}$ jeux de paramètres parmi les valeurs possibles. Parmi les jeux de paramètres possibles, le jeu qui minimise le plus la fonction de coût, une fois ajouté aux $N_{ensembles}$ jeux, est ensuite ajouté à la liste des jeux retenus. Parmi les $N_{ensembles}+1$ jeux de paramètres retenus, le jeu qui minimise le plus la fonction de coût, une fois retiré, est ensuite éliminé de la liste des $N_{ensembles}$ jeux. L'algorithme s'arrête lorsque le même jeu est ajouté/retiré ou après un certain nombre d'itérations.

*Expériences sur fantôme*

Pour illustrer l'extension en 2D du formalisme des états de configuration, des expériences ont été réalisées avec différentes solutions d'agents de contraste dilués dans l'eau. L'imagerie a été faite à 1.5 T (Achieva; Philips Healthcare, Best, The Netherlands) en utilisant une antenne tête en quadrature pour la réception. Des chélates de Gadolinium (10, 5, 2.5, 1.25, 0 mM, Dotarem; Guerbet, Villepinte, France) et des nanoparticules d'oxydes de fer (0.32, 0.16, 0.08, 0.04, 0 mM, CL-30Q02-2, Molday ION, Biopal, Worcester, MA, USA) ont été préparés et placés dans des contenants cylindriques de 15 mL alignés au champ magnétique $B_0$. Une séquence en écho de gradient 3D non-sélective spatialement a été modifiée pour permettre de multiples valeurs de $Y^{-1}$ séquentiellement en commençant par $Y^{-1} = 1$ (pas de brouillage RF, $\Delta=0°$) jusqu'à couvrir tout le cercle unité. Des impulsions RF rectangulaires ont été utilisées (durée de 150 $\mu$s pour 45° d'angle prescrit). Un paramètre a également été ajouté pour permettre l'entrelacement de l'amplitude des angles tel que $\alpha_{2n} = \alpha$ et $\alpha_{2n+1} = \alpha/2$ (en divisant par deux en temps réel l'amplitude du champ B1 d'émission). Le gradient de brouillage a été placé sur la direction de la lecture tel que son aire corresponde à $a = 1/\Delta k_z$ égal à la taille du pixel d'imagerie. Les paramètres d'acquisition étaient soit *TR/TE=9.2/4* ms, matrice d'acquisition 168×84×9 et taille du voxel 0.5×1×8 mm, bande passante par pixel 217 Hz/pix, temps d'acquisition $T_{acq}$ = 7 s par volume (que l'on notera par la suite 'séquence 1', avec une sensibilité à la diffusion de *b*=1.45 s.mm$^{-2}$) ou *TR/TE=4.8/2.4* ms, matrice d'acquisition 84×84×9 et taille de voxel 1x1x8 mm, bande passante par pixel 434 Hz/pix, temps d'acquisition $T_{acq}$ = 3.5 s par volume (que l'on notera par la suite 'séquence 2', avec une sensibilité à la diffusion de *b*=0.19 s.mm$^{-2}$). La taille des voxels de reconstruction était de 0.47×0.47×8 mm. Plusieurs angles prescrits ont été testés séquentiellement (entre 7.5° to 75°), ainsi que de manière entrelacée. De multiples pas $N_y$ ont été effectués (par pas de 2° pour $\Delta$). Etant donné ces paramètres d'acquisition, pour chaque pas $\Delta$, le centre de l'espace de Fourier a été échantillonné après quelques secondes. Il n'y avait pas de délai entre les acquisitions des différents pas $\Delta$, et 2 à 4 volumes de préparation ont été réalisés avant de stocker le premier volume de données si bien qu'on peut considérer que l'état stationnaire était atteint. La reconstruction de chaque volume a été effectuée par le logiciel constructeur en retirant les corrections de phase présentes par défaut et en utilisant une échelle de stockage absolue du signal RMN dans les fichiers DICOM. Les images d'amplitude et de phase ont été sauvegardées.

*Analyse des données*

Les images DICOM ont été analysées hors ligne en utilisant Matlab (2011b version; The Mathworks, Natick, MA) sur un ordinateur portable récent (Intel core i7, RAM 16 Go, 2.7 GHz) exploité sous Microsoft Windows 8. Seule la coupe centrale du volume 3D a été analysée. Une région d'intérêt a été dessinée sur chaque tube pour réaliser l'analyse du signal moyen par tube. Une reconstruction pixel à pixel a également été réalisée. Les images ont été normalisées par l'écart type du bruit $\sigma$ qui a été estimé sur une région sans signal. Pour garantir que le signal ait une symétrie Hermitienne par rapport à $Y^{-1}$ ( $Q_{0,mes}(Y^{-1}) = \overline{Q_{0,mes}(Y)}$ ), la phase du premier pas $\Delta=0°$ a été utilisée pour estimer $Z_{TE}$ qui fut ensuite retiré des autres pas. Un léger décalage temporel a été remarqué lors de l'acquisition des différents pas, et corrigé. Ce décalage a été attribué à une dérive thermique des gradients et il a été considéré que cette dérive variait linéairement dans le temps. Pour estimer cette dérive, l'acquisition correspondant à $\Delta=0°$ a été répétée au début et à la fin de tous les autres pas, ou alors l'acquisition obtenue pour $\Delta=2°$ (au début) et pour $\Delta=358°$ (à la fin) ont été comparées. Ces différents pas sont supposés être complexes conjuguées si bien que leurs produits doivent être réels. La phase de ce produit est donc caractéristique à de la dérive de phase temporelle. Une fois la dérive caractérisée, le signal mesuré pour chaque pas a été rephasé pour fournir le signal $Q_{0,mes}$ sur lequel le problème inverse proposé a été appliqué. Lors de l'estimation itérative des paramètres dans le problème inverse, l'algorithme de calcul de l'état stationnaire proposée dans l'annexe 3 a été utilisé pour les cas où un angle constant en amplitude et en décalage apparent de fréquence a été appliqué. Le nombre d'ordre $N_z$ a été choisi en fixant $E_{lim,2}=0.01$. Dans tous les autres cas, le calcul itératif a été effectué en fixant le nombre maximum de répétitions à $\max(n_{eq}, n_0)$ où $n_0$ correspondait au nombre de répétitions appliquées pour atteindre le centre du plan de Fourier en imagerie, et $n_{eq}$ obtenu pour $E_{lim,1}=0.01$. L'initialisation a été effectuée sur 32 valeurs pour $E_1$ et $E_2/E_1$. Les itérations ont été arrêtées quand la norme du résidu normalisée par la norme du signal variait de moins de $10^{-6}$.

*Résultats*

*Simulations*

Le calcul de l'aimantation en utilisant l'extension en 2D du formalisme des états de configuration est illustré sur la Figure 3. Les coefficients de l'aimantation transversale $q_{j,k,n}$, qui ont été initialisés à l'équilibre thermique, sont affichés pour $n=1$ (avec seulement un coefficient central à $j=k=0$, Figure 3-a). Progressivement, des coefficients non-nuls apparaissent, jusqu'à atteindre un état stationnaire après un large nombre d'impulsions. Les coefficients de l'état stationnaire sont très fortement influencés par la diffusion (Figure 3-e et f). Chaque itération a duré ~1 ms avec $N_y$ = 360, et le nombre d'itérations nécessaires pour atteindre l'état stationnaire était de l'ordre de 5 $T_1$/TR, quelle que soit la série d'angle appliquée. En ce qui concerne le calcul de l'état stationnaire à la suite du cyclage quadratique de phase, les deux approches (itérative basée sur l'application successive d'impulsion et directe dérivée de l'algorithme tridiagonal) donnaient les mêmes états stationnaires. L'algorithme rapide prenait ~10 ms pour fournir l'état stationnaire sur le même nombre de points $N_y$ = 360. L'algorithme proposé fournissait les mêmes résultats que publiés précédemment lorsque les effets de la diffusion étaient négligés (Figure 4-a). L'état stationnaire est très fortement dépendant de $\Delta$ avec la création de multiples échos stimulés. Des pics spécifiques sont visibles lorsque $\Delta$ est un nombre rationnel de 360° (0°, 180°, 120°, 90°, ...). La relaxation transverse et la diffusion réduisent toutes deux la formation d'échos stimulés ce qui rapproche le signal d'un équilibre de Ernst pur (Figure 4-b-d). L'aimantation transversale varie entre des valeurs plus grandes et plus petites, et n'atteint jamais de l'équilibre de Ernst qui est purement réel, même s'il existe des valeurs de $\Delta$ pour lesquelles le module de l'aimantation lui est égal. La dépendance de l'état stationnaire obtenu à la suite d'une série constante en amplitude et en décalage apparent de fréquence est complexe et des contrastes mélangés en $T_1$, $T_2$ et diffusion sont obtenus. Néanmoins, des caractéristiques générales peuvent être extraites. En effet, les états stationnaires sont contenus dans un plan qui contient lui-même l'équilibre de Ernst et qui est basculé d'un angle effectif $\alpha_{eff}$ = arctan $((E_1-c)/s)$ (Figure 5) par rapport à l'axe du champ principal, et ce quel que soit $T_2$ ou le coefficient de diffusion. Ceci implique une dépendance particulière par rapport à l'angle de Ernst. Pour des angles d'amplitude plus petites que l'angle de Ernst (Figure 5-a-b), l'angle effectif est négatif et l'aimantation varie entre des 'pics' qui sont plus petits que l'équilibre de Ernst et des valeurs 'brouillées' qui sont plus grandes. Pour des angles plus grands que l'angle de Ernst (Figure 5-e-f), l'inverse est observé. Entre les deux, si l'angle est exactement égal à l'angle de Ernst (Figure 5-c-d), l'angle effectif est nul : seule la partie imaginaire de la composante transversale de l'aimantation varie avec $\Delta$ et la partie réelle est toujours égale à l'équilibre de Ernst. L'algorithme proposé est non seulement capable de simuler le cas du cyclage quadratique de phase standard (amplitude et décalage apparent de fréquence constants), mais aussi de calculer les états stationnaires entrelacés qui peuvent être obtenus avec des séries périodiques d'amplitude et de décalage apparent de fréquence. Ceci est démontré sur la Figure 6 sur laquelle un angle constant de 75° avec décalage apparent de fréquences constant est comparé à une série ayant un angle constant de 75° avec une oscillation du décalage apparent de fréquence $(+\Delta, -\Delta)$, ainsi qu'une série qui oscille en amplitude (75°/37.5°) et est constante en décalage apparent de fréquence. Les états stationnaires obtenus sont très différents. Le cas de l'amplitude alternée donne naissance à une dépendance très complexe avec $\Delta$. Le cas d'un angle d'amplitude constante mais avec une alternance du décalage apparent de fréquence $(u_{2n}=1, u_{2n+1}=-1)$ donne naissance à deux états stationnaires complexes conjugués. Pour ce dernier cas, une transition lente est obtenue entre $\Delta=0$ et $\Delta=\pi$ (ces deux états sont respectivement les mêmes que ceux obtenus pour un décalage apparent de fréquence constant avec Δ=0 et Δ=π). Cette alternance de décalage apparent de fréquence est obtenue par exemple avec une phase effective des impulsions RF $\theta_n$ qui alterne entre +Δ/2 et -Δ/2.

*Expériences sur fantôme*

Les signaux moyens sur les tubes ont pu être modélisés efficacement en utilisant les approches proposées sur la gamme des angles de basculement testés, aussi bien en utilisant une série constante d'amplitude et de décalage apparent de fréquence qu'avec des séries périodiques plus complexes. Après l'étape d'initialisation, le nombre moyen d'itérations de l'algorithme non linéaire de minimisation au sens des moindres carrés était de ~35. Pour toutes les séries d'angle testées, les valeurs de relaxivité $R_1$ et $R_2$ extraites de l'analyse sur le signal moyen des tubes étaient linéaires avec la concentration pour les solutions de Gd et d'ION, les angles ajustés ainsi que la valeur de l'atténuation $E_d$ étaient consistants avec respectivement l'angle prescrit et le coefficient de diffusion libre de l'eau. Pour le cas d'amplitude constant à 45° obtenu avec la séquence 1, les relaxivités molaires étaient $r_1/r_2$ = 3.9/4.6 mM$^{-1}$s$^{-1}$ pour l'agent à base de Gd et 86.4/12.7 mM$^{-1}$s$^{-1}$ pour l'agent à base d'ION, l'angle ajusté était de 44.3±0.3°, l'aimantation nucléaire $M_0$ était 471±54 (moyenne ± écart-type sur les tubes) et le coefficient d'atténuation par diffusion était $E_d$ = 0.9967±0.0003, correspondant à D = 2.29±0.17 10$^{-9}$ m$^2$s$^{-1}$, ce qui est en accord avec la théorie. Des signaux mesurés représentatifs ainsi que les paramètres ajustés correspondants sont présentés sur la Figure 7 pour les tubes de 1.25 mM Gd et de 160 μM ION dans les cas 45° et 45/22.5° entrelacés. Comme attendu, le cas de l'amplitude de l'angle entrelacé produit un équilibre complexe. Pour démontrer la possibilité de réaliser de l'imagerie multiparamétrique à partir de l'approche proposée, les signaux obtenus avec la séquence 1 avec 45° ont été ajustés pixel à pixel. Les cartes paramétriques d'aimantation, d'angle de basculement, de $R_1$, $R_2$ et de coefficient de diffusion sont présentées sur la Figure 8. Les valeurs moyennes ainsi que les écart-types calculés sur ces images reconstruites sont donnés dans la Table 1 ci-dessous, et associés à la valeur théorique calculée à partir de l'élément diagonal de la matrice de covariance du bruit. Tous les paramètres à ajuster sont en très bon accord avec les valeurs attendues. $R_1$ et $R_2$ sont linéaires avec la concentration (Figure 9) et permettent d'estimer des relaxivités molaires en accord avec celles mesurées sur les signaux moyens des tubes. L'amplitude de l'angle de bascule est très proche de la valeur prescrite, et le coefficient de diffusion indique une diffusion libre dans tous les tubes. Comme on peut le voir, l'estimation des paramètres est influencée par la propagation du bruit, et la précision dépend d'une manière complexe des paramètres. Les éléments diagonaux de la matrice de covariance du bruit, alors qu'ils n'incluent qu'une partie de la propagation du bruit, fournissent déjà une bonne estimation de la précision sur $R_1$, $R_2$ et D, mais sont moins efficaces pour prédire la propagation du bruit sur M et sur l'amplitude de l'angle, notamment parce que les estimations de ces deux paramètres sont plus fortement corrélées.

| | Eau | Gd 1.25 mM | Gd 2.5 mM | Gd 5 mM | Gd 10 mM | ION 40 μM | ION 80 μM | ION 160 μM | ION 320 μM |
|---|---|---|---|---|---|---|---|---|---|
| $M/\sigma$ | 797 ±217 (±115) | 588 ±114 (±6) | 570 ±113 (±4) | 548 ±112 (±3) | 511 ±117 (±4) | 620 ±107 (±36) | 623 ±89 (±33) | 635 ±89 (±29) | 604 ±84 (±22) |
| $\alpha$ (°) | 45.53 ±3.54 (±0.01) | 44.06 ±0.26 (±0.05) | 44.01 ±0.21 (±0.10) | 44.13 ±0.23 (±0.13) | 44.17 ±0.51 (±0.29) | 43.90 ±1.87 (±0.11) | 44.28 ±0.85 (±0.05) | 44.21 ±0.52 (±0.11) | 44.23 ±0.41 (0.24) |
| $R_1$ (s$^{-1}$) | 0.28 ±0.07 (±0.04) | 5.54 ±0.13 (±0.06) | 10.05 ±0.20 (±0.10) | 20.14 ±0.42 (±0.19) | 39.57 ±1.98 (±0.57) | 0.78 ±0.12 (±0.05) | 1.26 ±0.15 (±0.07) | 2.19 ±0.18 (±0.11) | 4.24 ±0.29 (±0.18) |
| $R_2$ (s$^{-1}$) | 0.73 ±0.27 (±0.17) | 6.47 ±0.20 (±0.10) | 11.69 ±0.28 (±0.14) | 23.82 ±0.55 (±0.25) | 46.78 ±1.79 (±0.67) | 3.10 ±0.39 (±0.16) | 6.43 ±0.49 (±0.22) | 13.47 ±0.56 (±0.33) | 27.90 ±0.88 (±0.55) |
| $D$ 10$^{-9}$ m$^2$s$^{-1}$ | 1.96 ±0.28 (±0.14) | 2.23 ±0.14 (±0.08) | 2.27 ±0.18 (±0.12) | 2.36 ±0.52 (±0.32) | 2.72 ±2.53 (±1.66) | 2.27 ±0.27 (±0.17) | 2.21 ±0.27 (±0.20) | 2.19 ±0.40 (±0.29) | 2.15 ±0.78 (±0.63) |

La Table 1 ci-dessus présente les résultats obtenus après analyse des images multiparamétriques reconstruites à partir des données obtenues avec la séquence 1 avec un angle prescrit de 45° et $N_y$=91 (Δ entre 0° to 180° par pas de 2°). Valeur moyenne ± écart-type mesurés sur les tubes pour les différents paramètres ajustés. Le nombre entre parenthèse correspond à la borne de Cramer-Rao issue des éléments diagonaux de l'inverse de la matrice de Fisher estimée aux valeurs moyennes ajustées. Bien que toutes les sources de bruit ne soient pas présentes dans les éléments diagonaux, ce nombre théorique fournit déjà une bonne estimation de l'écart-type, avec des valeurs proches de l'écart-type mesuré sur les tubes, pour $R_1$, $R_2$ et D.

**Discussion**

L'application répétée d'impulsions RF entrelacés d'une aire constante de gradient a été analysée à l'aide du formalisme des états de configuration étendu pour prendre en compte la modulation de la phase des impulsions RF. Des algorithmes efficaces de calcul de l'aimantation incluant la relaxation et la diffusion ont été déduits. L'imagerie multiparamétrique basée sur l'ajustement de signaux acquit à l'ordre k=0 avec plusieurs décalages de fréquence apparente ainsi que des angles alternés en amplitude a été démontré pour une large gamme de $R_1$, $R_2$ et rapport $R_2R_1$. L'aimantation nucléaire, l'angle de basculement, le coefficient de diffusion libre et les paramètres de relaxation ont pu être mesurés, validant les approches directe et inverse.

Le formalisme des états de configuration est équivalent à l'approche du graphe de phase étendue (6-9), dans laquelle l'aimantation est décomposée en coefficients de Fourier évoluant dans le temps, qui peut donc être étendu avec une représentation graphique similaire (8) de l'action d'un angle de basculement d'amplitude et de phase données, et d'atténuation par relaxation et diffusion. L'approche est également similaire à la décomposition en polynôme effectuée dans le cadre de la conception d'impulsions RF (10,11) étendue en 2D, suggérant la possibilité d'utiliser des techniques de filtrage numérique pour la conception d'impulsions RF potentiellement sensibles à la relaxation et à la diffusion. On notera que la dérivation proposée peut être adaptée à des TR et des aires de gradient variables (9) en adaptant les polynômes de pondération et les décalages selon $Y^{-1}$ et $Z^1$ pour calculer efficacement la réponse à de telles séquences. Dans le cas d'un TR et d'une aire de gradient constants comme traité ici, le cyclage quadratique de phase mène bien à l'état stationnaire très étudié (3-5). L'ordre $k = 0$ à l'état stationnaire dans ce cas est contenus dans un plan qui passe par l'équilibre de Ernst et qui est penché d'un angle effectif déterminé menant à une dépendance particulière qui pourrait être utilisée pour rapidement estimer si l'angle prescrit est plus grand ou plus petit que l'angle de Ernst. Ceci pourrait être fait en comparant les signaux de quelques valeurs de $\Delta$ (comme par exemple 0° et un autre incrément de phase). Une décroissance de la partie réelle indique un angle plus grand que l'angle de Ernst, et réciproquement. La dérivation d'un algorithme rapide basée sur l'expression d'un système linéaire tri-diagonal pour calculer l'état stationnaire dans ce cas, proposée précédemment avec une dérivation différente (33), inclut également ici les effets de la diffusion et peut être généralisée à des polynômes de pondérations plus complexes. De plus, la description selon les états de configuration permet de démontrer que des séries périodiques, modulées en amplitude et en phase, produisent des états stationnaires entrelacés, étendant donc les possibilités de manipulation du contraste dans ce type de séquences. Comme les paramètres physiques (taux de relaxation, coefficient de diffusion) et de séquences (TR, amplitude de l'angle) sont pris en compte dans le calcul du problème direct, le problème inverse est basé sur l'acquisition de différentes séries d'angles. Ce type de problème inverse a déjà été proposé en utilisant différents états k (28-31) ou en utilisant du brouillage partiel autour de 0° avec cyclage quadratique de la phase pour quantifier $T_2$ (33-35). Il a été choisi ici de n'utiliser que l'état k = 0 et de multiples décalages apparent de fréquence. Cela a permis de valider expérimentalement, sur un système clinique standard, le problème direct, ainsi que de démontrer la possibilité de réaliser de l'imagerie multiparamétrique. Le problème inverse peut être étendu pour inclure différents états k et de multiples séries d'angle. La détermination des états k et des séries optimaux à mesurer est un problème complexe qui nécessiterait l'étude approfondie de la matrice de covariance du bruit. Pour la question de la sélection d'un nombre minimum de mesures pour estimer de manière optimale un paramètre d'intérêt (relaxation, diffusion, ...) tout en maintenant une durée totale d'acquisition réalisable en pratique, des éléments peuvent être précisés. Dans un premier temps, l'aimantation à une symétrie Hermitienne de sorte qu'il n'y a pas besoin d'acquérir des valeurs d'incrément de —$\Delta$ (modulo 360°) si la valeur $\Delta$ est acquise. D'autre part, si on se restreint à l'acquisition de l'état $k = 0$ avec un décalage apparent de fréquence, comme proposé avec du brouillage partielle autour de 0° (33-35), les régions autour de fraction de 360° semblent être les plus informatives (0°, 180°, 120°, ...) de sorte que le brouillage partiel, définit comme un échantillonnage autour de ces valeurs, pourrait être suffisant. De plus, comme on peut voir sur la Fig. 7a-b, les deux premières ellipses correspondent au brouillage partiel autour de 0° et de 180°, et la vitesse de variation augmente autour de 180° par rapport à 0° (visible en comparant la position des signaux obtenus pour 0-2-4° et 180-182-184°, par exemple), ce qui suggère que 1) une évolution géométrique du type 0-2-4-8-16° autour de 0° par exemple, et 2) une réduction des pas telles que 180-181-182-184-188° autour de 180° peut être suffisant pour moduler l'état stationnaire suffisamment pour estimer les paramètres.

Le signal mesuré a été pré-traité pour retirer la phase au temps d'écho, ainsi qu'une dérive dans le temps. Ces paramètres ont été estimés et corrigés avant l'application du problème inverse mais auraient pu également être inclus comme paramètres à ajuster. La phase du signal, toujours disponible dans une séquence IRM, reste sensible aux inhomogeneités du champ $B_0$, permettant de les cartographier, ou de quantifier les déphasages dus au flux. Pour réduire les effets de phases dus au flux (9) qui ne restent pas constants pendant l'acquisition et donc n'atteignent pas forcément un état stationnaire, des formes de gradients compensées en flux peuvent être utilisées. En ce qui concerne la dérive attribuée à des effets thermiques des gradients, la réduction du nombre de pas échantillonnés limiterait ces effets. Une calibration est toujours possible en acquérant plusieurs fois des incréments de 0°, ou en comparant des images obtenues avec des incréments $\Delta$ et $-\Delta$ acquises à différents moments.

L'implémentation proposée pour résoudre le problème inverse possède la limite du temps de calcul important lorsqu'il est appliqué sur la base d'un ajustement pixel à pixel. Néanmoins, cet algorithme est fortement parallélélisable, et des processeurs de carte graphique peuvent être utilisés pour accélérer la reconstruction. L'angle de basculement a été considéré comme un paramètre ajustable fournissant une estimation moins précise des autres paramètres par propagation du bruit. Pour améliorer la précision sur les autres paramètres, on peut fixer l'angle de basculement à la valeur de l'angle prescrit ou ajouter de la régularité spatiale sur celui-ci. Les valeurs d'angle utilisées ici (entre 7.5 et 75°) semblent fournir une variation suffisante du signal mesuré pour ajuster les différents paramètres. Pour des petits angles (Fig. 5a-b), l'aimantation varie moins que pour des angles plus grand (Fig.5c-f). Pour des angles encore plus grand (non présenté ici), l'aimantation souffre de phénomènes de saturation ce qui indique qu'un angle maximisant les variations du signal en fonction de $\Delta$ se situe dans la gamme d'amplitude de 0° à 90°. Cet angle optimal dépend de la relaxation et de la diffusion. La possibilité de cartographier l'angle de basculement, la relaxation et la diffusion dans la gamme des petits angles <90° utilisés dans les séquences en écho de gradient, angles significativement inférieurs à ceux utilisés dans les séquences d'écho de spin, suggère que l'approche proposée pourrait être utilisée indépendamment de l'homogénéité spatiale du champ d'émission $B_1$ typiquement obtenue à plus haut champ magnétique $B_0$ ou avec des antennes de surface, et ce avec des taux d'absorption spécifique moins élevés. L'utilisation de séries d'amplitudes d'angle entrelacés ou séquentielles (techniques du type d'angles variables ou actuels (15-21)) améliorerait le conditionnement du problème inverse et par conséquent l'ajustement des paramètres. Le fait que l'équilibre de Ernst purement réel soit difficile à atteindre, même pour l'évolution quadratique de phase utilisée pour réaliser du brouillage avec des incréments de 117° ou d'autres valeurs adaptées (4,15,16) indique qu'il faut prendre en compte aussi bien la relaxation transversale que la diffusion pour décrire le signal, et qu'il y a une amélioration potentielle si les deux parties, réelle et imaginaire, sont utilisées. En effet, les analyses dans la plupart des travaux précédents n'exploitent que le module de l'aimantation transversale et perdent donc de l'information au passage (15-20).

De manière intéressante, l'action de la diffusion est très importante, même avec les faibles valeurs de $b$ utilisées ici. En effet, la valeur rapportée ici ne considère que la pondération de diffusion au premier ordre entre deux TR. D'une part la pondération des ordres supérieurs augmente à la puissance $k^2$, et ces ordres sont maintenus par cohérence sur les composantes longitudinale et transversale. Le temps de diffusion effectif est donc plus grand que TR. La pondération de diffusion effective est alors plus complexe à définir. Un temps de diffusion effectif T, qui dépend de $T_1$, $T_2$ et de l'angle de basculement, peut être défini; celui-ci est borné par $T_2 < T_1$. La séquence est alors équivalente à l'application d'un gradient constant pendant ce temps, et la pondération de diffusion augmente alors en $T^3$. Une augmentation très rapide est alors attendue : avec un TR de ~10 ms et en considérant T~ 100 ms, la valeur de $b$ effective est alors $(T/TR)^3=10^3$ fois plus grande que celle définie entre chaque TR. La contrepartie est que la pondération de diffusion est dépendante des paramètres de relaxation. On peut voir cet aspect de pondération de diffusion inhomogène comme une limite, ou comme une façon supplémentaire de filtrer les signaux de certains types de tissus à l'aide de l'application de différentes valeurs de $b$ en jouant sur le paramètre de séquence $\alpha$ ou de manière équivalente sur la forme du gradient et sur son aire totale. Cela peut permettre d'avoir un accès plus spécifique à des compartiments à une échelle plus petite que la taille du voxel d'imagerie. Jouer sur la direction du gradient pourrait également permettre d'accéder aux directions privilégiées de diffusion (37,38), avec l'avantage d'une séquence en écho de gradient (bonne résolution spatiale, temps d'écho court, bande passante élevée et déformations spatiales associées limitées). In vivo, la diffusion peut également être restreinte, des phénomènes de transfert d'aimantation ou des effets de volume partiels peuvent exister. Ces phénomènes pourraient être pris en compte en utilisant des polynômes de pondération plus complexes (37,38), en modélisant l'échange (39) ou la multi-compartimentalisation, et pourraient être caractérisés en utilisant les séquences rapides à l'état stationnaire décrites par le formalisme des états de configuration. Pour réduire le temps total d'acquisition, les modulations proposées des impulsions RF pourraient être combinées avec l'imagerie parallèle (40), le 'compressed sensing' (41) ou le 'fingerprinting' (42), approches pour lesquelles le formalisme des états de configuration étendu pourrait apporter un procédé pour sélectionner des motifs d'échantillonnages pseudo-aléatoires.

***Variante du premier mode de réalisation d'un procédé et d'un dispositif selon l'invention : estimation rapide de l'angle prescrit;***

Pour donner suite à ce qui a été dit aux précédents paragraphes dans la partie « discussion » concernant la possibilité d'estimer rapidement si l'angle prescrit est plus grand ou plus petit que l'angle de Ernst, une variante (dite « d'angle de Ernst ») du premier mode de réalisation de procédé selon l'invention mis en œuvre par le premier mode de réalisation de dispositif selon l'invention (et décrite uniquement par rapport à ses différences ou particularités par rapport à ce premier mode de réalisation) se situe dans le cadre d'états d'équilibres séquentiels et comprend :

- une acquisition d'un signal (nécessairement pour l'ordre de cohérence égal à zéro) pour deux états d'équilibres correspondants à deux amplitudes de l'impulsion radiofréquence identiques mais deux Δ différents, les moyens de commande 5 étant agencés pour ou programmés pour commander les moyens d'acquisition 6 pour effectuer une telle acquisition,
- une comparaison (par les moyens de calcul 7, qui sont agencés pour ou programmés pour cela) du signal pour ces deux états d'équilibres, et
- une déduction (par les moyens de calcul 7, qui sont agencés pour ou programmés pour cela), à partir de cette comparaison, de si l'amplitude de l'impulsion radiofréquence produit un angle de bascule effectif plus grand que ou plus petit que ou égal à l'angle de Ernst (égal à acos(exp(-TR/Tl))) pour l'échantillon.

Un des deux Δ différents, qui sera noté $\Delta_1$, est égal de manière préférentielle à zéro mais d'autres valeurs peuvent être prises comme 180°, ou 120°, ou 90°, ou toute autre valeur produisant un 'pic' visible sur la figure 5. La deuxième valeur, noté $\Delta_2$, sera choisie de manière préférentielle pour un 'creux' par exemple celui autour de zéro (environ entre 25° et 40°), ou autour de 180° (environ entre 192° et 202°), ou encore autour de 120° (environ entre 106° et 112° ou entre 128° et 134°). Comme on pourra le comprendre à la vue de la figure 5 sur laquelle la partie réelle (ligne numérotée 51) oscille autour de la valeur de l'équilibre de Ernst (ligne en pointillée ayant pour valeur s*(1-E1)/(1-c*E1):

- si la partie réelle du signal Sigl obtenu pour $\Delta_1$ est plus grande que la partie réelle du signal Sig2 obtenu pour $\Delta_2$, alors l'angle de bascule effectif est plus grand que l'angle de Ernst,
- si la partie réelle du signal Sigl obtenu pour $\Delta_1$ est égale à la partie réelle du signal Sig2 obtenu pour $\Delta_2$, alors l'angle de bascule effectif est égal à l'angle de Ernst,
- si la partie réelle du signal Sigl obtenu pour $\Delta_1$ est plus petite que la partie réelle du signal Sig2 obtenu pour $\Delta_2$, alors l'angle de bascule effectif est plus petit que l'angle de Ernst.

De manière préférentielle, $\Delta_1$ est égal à zéro et $\Delta_2$ correspond à un des creux donnés dans le paragraphe précédent. Si $\Delta_1$ est choisi égal à 0° ou 180°, on pourra par exemple effectuer le rapport des signaux complexes Sig2/Sigl et se baser directement sur la partie réelle de ce rapport : si celle-ci est supérieure à 1 alors l'angle est inférieur à l'angle de Ernst, si celle-ci est égale à 1 alors l'angle est égal à l'angle de Ernst, si celle-ci est inférieure à 1 alors l'angle est supérieur à l'angle de Ernst.

### *Variante du premier mode de réalisation d'un procédé et d'un dispositif selon l'invention : modulation des effets de la diffusion ;*

Pour donner suite à ce qui a été dit aux précédents paragraphes dans la partie « discussion » concernant l'importance de la diffusion, une variante (dite « de diffusion ») du premier mode de réalisation de procédé selon l'invention mis en œuvre par le premier mode de réalisation de dispositif selon l'invention (et décrite uniquement par rapport à ses différences ou particularités par rapport à ce premier mode de réalisation) se situe dans le cadre d'états d'équilibres séquentiels (éventuellement combinable avec des états d'équilibres entrelacés): on émet séquentiellement plusieurs ensembles, et (les moyens de commande 5 étant agencés pour ou programmés pour cela):

- la direction de codage diffère entre différents ensembles, et/ou
- la valeur de A diffère entre différents ensembles, et/ou
- la forme du gradient de champ magnétique selon la direction de codage diffère entre différents ensembles.

Cette variante « de diffusion » comprend en outre une quantification (par les moyens de calcul 7, qui sont agencés pour ou programmés pour cela) d'un coefficient de diffusion dans l'échantillon ou une détermination d'une direction privilégiée de diffusion dans l'échantillon ou une pondération de la diffusion dans l'échantillon par exploitation de la différence de A et/ou direction de codage et/ou de forme du gradient entre les différents ensembles. Cette quantification ou détermination ou pondération est typiquement mise en œuvre en appliquant plusieurs ensembles avec des valeurs de b (cf Annexe 1, notamment l'Equation 19 appliquée au gradient de codage pour calculer b) différentes et/ou des directions d'application du gradient de codage différentes. On s'arrangera donc pour définir une valeur $b_{max}$ de préférence entre 0.1 et 5000 mm$^2$.s$^{-1}$, à partir de laquelle l'aire A correspondante (notée $A_{max}$) et la forme du gradient de codage seront déterminées par calcul (de préférence pour un trapèze avec l'amplitude maximale des gradients applicable sur cet ou ces axe(s) et avec des rampes réalisables pour le système de gradient). A partir de la détermination de $A_{max}$ et de la forme, ainsi qu'en combinant aux contraintes imposées par les gradients d'imagerie, une valeur de TR minimum applicable TRmin sera déterminée. On choisira donc un TR au minimum égal à TRmin pour les différents ensembles. On définira également une valeur de bmin de préférence entre 0.1 et 5000 mm$^2$.s$^{-1}$ et inférieure à bmax. Cette valeur de bmin est alors réalisable avec le même TR, et sera de préférence réalisée en modifiant l'amplitude du gradient de codage plutôt que sa forme.

- La génération d'images pondérées en diffusion peut être faite avec deux ensembles réalisés pour une suite $u_n=1$ constante identique pour les ensembles, une valeur de $\Delta$ identique entre les ensembles, et une amplitude d'angle de basculement constante identique pour les ensembles, de préférence plus grand que l'angle de Ernst et de préférence inférieur à 90°. L'étude de la variation du signal en fonction de $b$ indique que la valeur de $\Delta$ à réaliser est soit proche de 0°, entre $\Delta=0°$ inclus et $\Delta=32°$ inclus modulo 360°, ou proche de 180°, entre $\Delta=164°$ inclus et $\Delta=196°$ inclus modulo 360°, ou, pour une valeur absolue de $\Delta$ proche de 120°, entre $\Delta=112°$ inclus et $\Delta=128°$ inclus modulo 360°, ou, pour une valeur absolue de $\Delta$ parmi 45°, 60°, 72°, 90°, et 144° modulo 360°. Les deux ensembles sont alors réalisés séquentiellement avec le gradient de codage possédant une valeur bmax (ensemble 1) et bmin (ensemble 2). La visualisation des images pondérées en diffusion peut alors se faire par la différence des signaux obtenus entre l'ensemble obtenu avec bmin moins l'ensemble obtenu avec bmax. Les signaux étant complexes, un module important (dits en hypersignal) correspond alors à une région ayant une diffusion importante, information visualisée de manière qualitative. Il faut noter ici que plus le coefficient de diffusion est grand, plus le signal à l'équilibre dynamique est atténué et se rapproche de l'équilibre de Ernst pour l'ensemble correspondant à bmax par rapport à l'ensemble correspondant à bmin.

- Ayant décrit la façon de pondérer les images en diffusion à partir de deux ensembles avec des valeurs de b différentes, il est possible d'étendre le procédé à la détermination d'une direction privilégiée de diffusion en utilisant le concept de tenseur de diffusion connu de l'art (Mori S, Zhang J. Principles of diffusion tensor imaging and its applications to basic neuroscience research. Neuron 2006;51(5):527-539). Dans ces techniques, plusieurs images sont réalisées avec des directions d'application d'un gradient de pondération de diffusion différentes. Les signaux sont ajustés à une matrice symétrique 3x3 ce qui permet d'extraire trois valeurs propres et trois vecteurs propres associés. De manière similaire ici, on utilisera par exemple les signaux de plusieurs ensembles acquis séquentiellement avec des valeurs de bmax identiques et des directions différentes, complété éventuellement d'une acquisition de référence avec une valeur de bmin faible. Avec ce signal qui dépend de la direction d'application du gradient de codage et qui est alors plus proche de l'équilibre de Ernst quand la diffusion est forte, il est alors possible par l'ajustement des composantes d'un tenseur sur les signaux mesurés de déterminer la direction privilégiée de diffusion, correspondant par exemple au vecteur propre ayant la valeur propre la plus grande, voire d'extraire d'autre paramètres tels que la fraction d'anisotropie comme rapporté dans l'état de l'art. D'un point de vue du procédé, la façon d'optimiser le nombre d'ensemble et de déterminer les orientations à appliquer sont donc des aspects disponibles dans l'art. Comme dans les techniques d'imagerie du tenseur de diffusion, pour cette variante, la valeur de bmax à retenir dépend des paramètres de relaxation et est à optimiser pour chaque tissu cible pour s'assurer que celle-ci atténue suffisamment le signal en fonction de l'orientation, mais pas trop pour ne pas être trop proche de l'équilibre de Ernst. Ces principes d'optimisation sont connus de l'homme de l'art. On notera ici l'intérêt du procédé selon l'invention proposé qui possède une sensibilité à la diffusion plus grande que les techniques courantes selon l'état de l'art, comme évoqué dans la partie 'discussion'.

- Ayant insisté sur la possibilité de sensibiliser le signal à la diffusion à l'aide de gradient de codage ayant des valeurs de b différentes, on notera que cet aspect peut être combiné à la variante dite « d'imagerie multiparamétrique ». Des ensembles avec des valeurs de b différentes peuvent être également acquis de manière séquentielle pour augmenter la sensibilité à la diffusion de certains ensembles et rendre la détermination de ce paramètre à l'aide du problème inverse plus précise. Le choix des différents ensembles sont dérivables du paragraphe précédent ainsi que de la description des points de mesure donnés dans la description de la variante dite « d'imagerie multiparamétrique ».

Dans la présente description de certains modes de réalisation et variantes de l'invention, le formalisme des états de configuration a été étendu pour prendre en compte la modulation de la phase des impulsions RF dans des séquences répétées incluant des impulsions radiofréquences entrelacées d'aire de gradient non nulle. Cette extension fournit un cadre pour calculer efficacement et mieux comprendre la formation d'échos stimulés à travers une représentation graphique. La relaxation et la diffusion ont été prises en compte, et les concepts sont généralisables à d'autres types de mécanismes d'atténuation. Par ailleurs, des états stationnaires périodiques peuvent être maintenus ce qui étend les possibilités de manipulation du contraste. Un problème inverse générique a été proposé pour ajuster l'aimantation, l'amplitude de l'angle de basculement, les taux de relaxation et le coefficient de diffusion basée sur l'acquisition de multiples séries modulées en amplitude et/ou en phase fournissant des outils quantitatifs d'imagerie basés sur les états de configuration ( ou QuICS pour « Quantitative Imaging using Configuration States » en anglais).

Bien sûr, l'invention n'est pas limitée aux exemples qui viennent d'être décrits et de nombreux aménagements peuvent être apportés à ces exemples sans sortir du cadre de l'invention.

Bien entendu, les différentes caractéristiques, formes, variantes et modes de réalisation de l'invention peuvent être associées les unes avec les autres selon diverses combinaisons dans la mesure où elles ne sont pas incompatibles ou exclusives les unes des autres. En particulier toutes les variantes et modes de réalisation décrits précédemment sont combinables entre eux.

**Annexe 1 : Effets de la diffusion sur les polynômes de pondération**

La valeur de b (b-value) est utilisée pour caractériser les gradients de diffusion et est défini pour un axe d'application :

$$b = -\gamma^2 \cdot I = -\int_0^{TR}\left(\int_0^{\tau}\gamma G(t)dt\right)^2 d\tau \ . \qquad (19)$$

L'effet de la diffusion diffère pour un ordre k donné (le déphasage dans le plan est $Z^{-k}$), car juste après l'impulsion RF, cet ordre a déjà une phase égale à $2\pi k/a$ :

$$b_k = -\gamma^2 \cdot I_k = -\int_0^{TR}\left(k\frac{2\pi}{a} + \int_0^{\tau}\gamma G(t)dt\right)^2 d\tau \ . \qquad (20)$$

Si le gradient est constant comme dans (31), l'intégration donne :

$$b_k = -\gamma^2 \cdot I_k = -\left(\frac{2\pi}{a}\right)^2 TR\left(k^2 + k + \frac{1}{3}\right), \qquad (21)$$

Ce qui permet de définir les coefficients du polynôme de pondération $W_2 : w_{2,k} = E_2 E_d^{k^2+k+\frac{1}{3}}$. Si le cas extrême dans lequel le gradient peut être approximé par un Dirac appliqué avant l'impulsion RF à venir est considéré, alors $w_{2,k} = E_2 E_d^{k^2}$ : le polynôme pondération correspond alors à un filtre Gaussien symétrique. Une prise en compte plus exacte de la forme des gradients est faisable, et il y a la possibilité de moduler le filtrage par diffusion au travers de la forme du gradient pour réduire les effets sur des ordres k prédéfinis. Par exemple, si le gradient est appliqué selon la direction de la lecture, comme ce qui est présenté expérimentalement dans la présente description, si on considère que $TE$ est au centre de la fenêtre d'acquisition (qui dure $T_{obs}$), les effets du gradient de préphasage (considéré comme étant appliqué pendant un temps $TE-T_{obs}/2$) suivi de la lecture et du gradients de brouillage (considéré comme étant appliqué pendant un temps $TR-TE-T_{obs}/2$), le calcul du polynôme de pondération donne $w_{2,k} = E_2 E_d^{k^2+\frac{1}{2}\left(4-5\frac{TE}{TR}-\frac{3}{2}\frac{T_{obs}}{TR}\right)k+\left(\frac{10}{12}-\frac{9}{12}\frac{TE}{TR}-\frac{9}{24}\frac{T_{obs}}{TR}\right)}$. Dans tous les cas, ces expressions peuvent être mises sous la forme $w_{2,k} = E_2 E_d^{(k-k_c)^2+cst}$ ce qui montre que, pour de la diffusion libre, un filtrage Gaussien est appliqué centré sur $k = k_c$ et avec une atténuation $E_2 E_d^{cst}$ appliquée sur tous les coefficients (où $cst$ est une constante). De manière similaire, les coefficients du polynôme de pondération $W_1$ qui atténue aimantation longitudinale correspond un filtre Gaussien centré sur zéro, $w_{1,k} = E_1 E_d^{k^2}$, car un ordre $k$ est maintenu entre deux TRs sans déphasage supplémentaire.

**Annexe 2 : L'opérateur de décalage**

L'action de changer l'incrément de phase d'une impulsion à l'autre est équivalente à un changement de fréquence apparente. Par conséquent, dans la description polynomiale utilisée ici, chaque coefficient doit être rephasé de manière appropriée. On peut décomposer l'aimantation en :

$$U = \sum_{k=-\infty}^{+\infty} U_k\left(Y^{-1}\right) Z^{-k}, \tag{22}$$

où $U_k(Y^{-1})$ sont des polynômes en $Y^{-1}$. La convolution avec $S_v$ a pour action de réaliser ce changement de fréquence apparente :

$$S_v * U = \sum_{k=-\infty}^{+\infty} U_k\left(Y^{-1}\right) Y^{-vk} Z^{-k}, \tag{23}$$

Avec l'extension en 2D du formalisme les états de configuration, l'action est de translater chaque polynôme $U_k(Y^{-1})$ dans la direction $Y$ d'un indice qui dépend de l'ordre $k$ comme illustré sur la Fig.2. Des relations avantageuses sont exploitables :

$$Y^{-v} Z^{-1}\left(S_v * U\right) = Y^{-v} \sum_{k=-\infty}^{+\infty} u_k Y^{-vk} Z^{-(k+1)} = \sum_{k=-\infty}^{+\infty} u_{k-1} Y^{-vk} Z^{-k} = S_v *\left(Z^{-1} U\right), \tag{24}$$

On peut noter que $S_v$ est égale à son complexe conjugué, et que les opérateurs peuvent être combinés :

$$\overline{S_v} = \sum_{k=-\infty}^{+\infty} Y^{vk} Z^k = \sum_{k=-\infty}^{+\infty} Y^{-vk} Z^{-k} = S_v, \tag{25}$$

$$S_u * S_v = S_{u+v}. \tag{26}$$

**Annexe 3 : Calcul rapide de l'état stationnaire à partir de l'algorithme des matrices tridiagonales**

Pour calculer l'état stationnaire dans le cas de cyclage quadratique de phase il est possible d'utiliser la relation de récurrence entre trois itérations successives. Pour cela, le polynôme représentant l'aimantation transversale est écrit comme une somme de polynôme en $Y^{-1}$:

$$Q_\infty^s = \sum_{k=-\infty}^{+\infty} q_k\left(Y^{-1}\right) Z^{-k} \tag{27}$$

Si cette expression est substituée dans la relation de récurrence à l'état stationnaire :

$$S_\Delta *\left(S_\Delta - cW_1\right) * Q_\infty^s = s\left(1 - E_1\right) + \frac{c+1}{2}\left(S_\Delta - W_1\right) *\left(Z^{-1} W_2 * Q_\infty^s\right) + \frac{c-1}{2}\left(S_\Delta + W_1\right) *\left(\overline{Z^{-1} W_2 * Q_\infty^s}\right) \tag{28}$$

$$S_\Delta *\left(Q_\infty^s - \overline{Q_\infty^s}\right) = Z^{-1} W_2 * Q_\infty^s - \overline{Z^{-1} W_2 * Q_\infty^s} \tag{29}$$

Les expressions suivantes sont obtenues :

$$q_k \alpha_k = s\left(1 - E_1\right) \delta_{k,0} + \left[\eta_k \chi_k q_{k-1} - \kappa_k \gamma_k \overline{q_{-k-1}}\right] \tag{30}$$

$$q_k - \chi_k q_{k-1} = \overline{q_{-k}} - \kappa_k \overline{q_{-k-1}} \tag{31}$$

Avec $\alpha_k = 1 - cY^k w_{1,k}, \beta_k = c - Y^k w_{1,k}$, $\gamma_k = \frac{1}{2}(\alpha_k - \beta_k)$ , $\eta_k = \frac{1}{2}(\alpha_k + \beta_k)$ , $\chi_k = w_{2,k-1} Y^k$, $\kappa_k = w_{2,-k-1} Y^k$, $\delta_{k,m} = 1$ if $m = k$, et 0 partout ailleurs (la distribution de Dirac).

L'opération de conjugaison est éliminée en combinant l'expression précédente et en décalant les indices :

$$q_k \frac{\alpha_k}{\gamma_k} - \chi_k \frac{\eta_k}{\gamma_k} q_{k-1} - s\frac{(1-E_1)}{\gamma_0}\delta_{k,0} = -\kappa_k \overline{q_{-k-1}} \qquad (32)$$

$$-q_{k-1}\frac{\alpha_{k-1}}{\kappa_{k-1}\gamma_{k-1}} + \frac{\chi_{k-1}}{\kappa_{k-1}}\frac{\eta_{k-1}}{\gamma_{k-1}} q_{k-2} + s\frac{(1-E_1)}{\kappa_0\gamma_0}\delta_{k-1,0} = \overline{q_{-k}} \qquad (33)$$

de sorte que l'expression suivante fournit une récurrence entre trois états k consécutifs :

$$-a_k q_{k-1} + b_k q_k - c_k q_{k+1} = r_{-1}\delta_{k+1,0} + r_0\delta_{k,0} \qquad (34)$$

Avec $a_k = \frac{\chi_k\eta_k}{\alpha_k}$ , $b_k = 1 + \kappa_k\chi_{k+1}\frac{\gamma_k}{\alpha_k}\frac{\beta_{k+1}}{\gamma_{k+1}}$ , $c_k = \frac{\eta_{k+1}}{\gamma_{k+1}}\frac{\kappa_k\gamma_k}{\alpha_k}$ , $r_0 = s\frac{1-E_1}{1-cE_1}$ , $r_{-1} = -s\frac{(1-E_1)}{\gamma_0}\frac{\kappa_{-1}\gamma_{-1}}{\alpha_{-1}}$ .

Ceci peut être réécrit comme un système linéaire tridiagonal :

$$\begin{bmatrix} b_{-n} & -c_{-n} & & & & & & \\ \cdots & \cdots & \cdots & & & & & \\ & -a_{-2} & b_{-2} & -c_{-2} & & & & \\ & & -a_{-1} & b_{-1} & -c_{-1} & & & \\ & & & -a_0 & b_0 & -c_0 & & \\ & & & & -a_1 & b_1 & -c_1 & \\ & & & & & \cdots & \cdots & \cdots \\ & & & & & & -a_{n-1} & b_{n-1} \end{bmatrix}\begin{bmatrix} q_{-n} \\ \cdots \\ q_{-2} \\ q_{-1} \\ q_0 \\ q_1 \\ \cdots \\ q_{n-1} \end{bmatrix} = \begin{bmatrix} 0 \\ \cdots \\ 0 \\ r_{-1} \\ r_0 \\ 0 \\ \cdots \\ 0 \end{bmatrix} \qquad (35)$$

Qui est de manière classique résolu par un algorithme des matrices tridiagonales :

$$\begin{bmatrix} 1 & -g_{-n} & & & & & & \\ & 1 & \cdots & & & & & \\ & & 1 & -g_{-2} & & & & \\ & & & 1 & -g_{-1} & & & \\ & & & -h_0 & 1 & & & \\ & & & & -h_1 & 1 & & \\ & & & & & \cdots & 1 & \\ & & & & & & -h_{n-1} & 1 \end{bmatrix}\begin{bmatrix} q_{-4} \\ \cdots \\ q_{-2} \\ q_{-1} \\ q_0 \\ q_1 \\ \cdots \\ q_3 \end{bmatrix} = \begin{bmatrix} 0 \\ 0 \\ 0 \\ \rho_{-1} \\ \rho_0 \\ 0 \\ 0 \\ 0 \end{bmatrix} \qquad (36)$$

Avec $g_{k+1} = \frac{c_{k+1}}{b_{k+1} - a_{k+1}g_k}$ Qui est calculé itérativement en considérant $g_{-n-1} = 0$, $h_k = \frac{a_k}{b_k - c_k h_{k+1}}$ calculé en considérant $h_n = 0$, $\rho_0 = \frac{r_0}{b_0 - c_0 h_1}$ et $\rho_{-1} = \frac{r_{-1}}{b_{-1} - a_{-1}g_{-2}}$ . La valeur finale pour $k = 0$, $q_0$ est ensuite obtenue en inversant la matrice 2×2 centrale :

$$q_0 = \frac{\rho_0 + h_0 \rho_{-1}}{1 - h_0 g_{-1}} \qquad (37)$$

Ainsi que le terme $q_{-1}$ :

$$q_{-1} = \frac{\rho_{-1} + g_{-1} \rho_0}{1 - h_0 g_{-1}} \qquad (38)$$

En utilisant cette approche, chaque ordre $k$ de l'état stationnaire peut être calculé en utilisant la relation à l'envers. La valeur de $p_0$ est déterminée par $p_0 = c \dfrac{1 - E_1}{1 - cE_1} - sw_{2,-1} \dfrac{q_{-1} + \overline{q_{-1}}}{2}$ . Le calcul peut être fait pour une série d'exponetielles complexes $Y^{-1}$ et suivi d'une transformée de Fourier pour obtenir les coefficients du polynôme en $Y^{-1}$. Cet algorithme est similaire à l'expansion de fractions continue (continuous fraction expansion) proposée par ailleurs (33), avec une dérivation et une expression différentes qui inclut notamment les effets de la diffusion, et par extension de n'importe quelle pondération.

**Références bibliographiques**

1. Ernst RR, Bodenhausen G, Wokaun A. Principles of nuclear magnetic resonance in one and two dimensions. In: Clarendon O, editor; 1987. p 125.

2. Darrasse L, Mao L, Saint-Jalmes H. Steady-State management in Fast Low-Angle Imaging. Proceedings of the International Society for Magnetic Resonance in Medicine 1986; Montreal, Quebec, Canada. p 944.

3. Zur Y, Bendel P. Elimination of the Steady State Transverse Magnetization in Short TR Imaging. Proceedings of the International Society for Magnetic Resonance in Medicine 1987; New York, NY, USA.

4. Zur Y, Wood ML, Neuringer LJ. Spoiling of transverse magnetization in steady-state sequences. Magnetic resonance in medicine : official journal of the Society of Magnetic Resonance in Medicine / Society of Magnetic Resonance in Medicine 1991;21(2):251-263.

5. Crawley AP, Wood ML, Henkelman RM. Elimination of transverse coherences in FLASH MRI. Magnetic resonance in medicine : official journal of the Society of Magnetic Resonance in Medicine / Society of Magnetic Resonance in Medicine 1988;8(3):248-260.

6. Hennig J. Echoes—how to generate, recognize, use or avoid them in MR-imaging sequences. Part I: Fundamental and not so fundamental properties of spin echoes. Concept Magnetic Res 1991;3(3):125-143.

7. Hennig J. Echoes—how to generate, recognize, use or avoid them in MR-imaging sequences. Part II: Echoes in imaging sequences. Concept Magnetic Res 1991;3(4):179-192.

8. Scheffler K. A pictorial description of steady-states in rapid magnetic resonance imaging. Concept Magnetic Res 1999;11(5):291-304.

9. Weigel M. Extended phase graphs: Dephasing, RF pulses, and echoes - pure and simple. Journal of magnetic resonance imaging : JMRI 2014.

10. Pauly J, Leroux P, Nishimura D, Macovski A. Parameter Relations for the Shinnar-Leroux Selective Excitation Pulse Design Algorithm. Ieee T Med Imaging 1991;10(1):53-65.

11. Le Roux P, Hinks RS. Stabilization of echo amplitudes in FSE sequences. Magnetic resonance in medicine : official journal of the Society of Magnetic Resonance in Medicine / Society of Magnetic Resonance in Medicine 1993;30(2):183-190.

12. Le Roux P. Simplified model and stabilization of SSFP sequences. Journal of magnetic resonance 2003;163(1):23-37.

13. Ganter C. Analytical solution to the transient phase of steady-state free precession sequences. Magnetic resonance in medicine : official journal of the Society of Magnetic Resonance in Medicine / Society of Magnetic Resonance in Medicine 2009;62(1):149-164.

14. Ganter C, Settles M, Dregely I, Santini F, Scheffler K, Bieri O. B1+-mapping with the transient phase of unbalanced steady-state free precession. Magnetic resonance in medicine : official journal of the Society of Magnetic Resonance in Medicine / Society of Magnetic Resonance in Medicine 2013.

15. Preibisch C, Deichmann R. Influence of RF spoiling on the stability and accuracy of T1 mapping based on spoiled FLASH with varying flip angles. Magnetic resonance in medicine : official journal of the Society of Magnetic Resonance in Medicine / Society of Magnetic Resonance in Medicine 2009;61(1):125-135.

16. Liberman G, Louzoun Y, Ben Bashat D. T(l) mapping using variable flip angle SPGR data with flip angle correction. Journal of magnetic resonance imaging : JMRI 2014;40(1):171-180.

17. Fram EK, Herfkens RJ, Johnson GA, Glover GH, Karis JP, Shimakawa A, Perkins TG, Pelc NJ. Rapid calculation of T1 using variable flip angle gradient refocused imaging. Magnetic resonance imaging 1987;5(3):201-208.

18. Lin W, Song HK. Improved signal spoiling in fast radial gradient-echo imaging: Applied to accurate T(l) mapping and flip angle correction. Magnetic resonance in medicine : official journal of the Society of Magnetic Resonance in Medicine / Society of Magnetic Resonance in Medicine 2009;62(5):1185-1194.

19. Schabel MC, Morrell GR. Uncertainty in T(l) mapping using the variable flip angle method with two flip angles. Physics in medicine and biology 2009;54(1):N1-8.

20. Hurley SA, Yarnykh VL, Johnson KM, Field AS, Alexander AL, Samsonov AA. Simultaneous variable flip angle-actual flip angle imaging method for improved accuracy and precision of three-dimensional T1 and B1 measurements. Magnetic resonance in medicine : official journal of the Society of Magnetic Resonance in Medicine / Society of Magnetic Resonance in Medicine 2012;68(1):54-64.

21. Nehrke K. On the steady-state properties of actual flip angle imaging (AFI). Magnetic resonance in medicine : official journal of the Society of Magnetic Resonance in Medicine / Society of Magnetic Resonance in Medicine 2009;61(1):84-92.

22. Hanicke W, Vogel HU. An analytical solution for the SSFP signal in MRI. Magnetic Resonance in Medicine 2003;49(4):771-775.

23. Bruder H, Fischer H, Graumann R, Deimling M. A new steady-state imaging sequence for simultaneous acquisition of two MR images with clearly different contrasts. Magnetic resonance in medicine : official journal of the Society of Magnetic Resonance in Medicine / Society of Magnetic Resonance in Medicine 1988;7(1):35-42.

24. Bieri O, Ganter C, Scheffler K. Quantitative in vivo diffusion imaging of cartilage using double echo steady-state free precession. Magnetic resonance in medicine : official journal of the Society of Magnetic Resonance in Medicine / Society of Magnetic Resonance in Medicine 2012;68(3):720-729.

25. Heule R, Ganter C, Bieri O. Rapid estimation of cartilage T with reduced T sensitivity using double echo steady state imaging. Magnetic resonance in medicine : official journal of the Society of Magnetic Resonance in Medicine / Society of Magnetic Resonance in Medicine 2013.

26. Heule R, Ganter C, Bieri O. Triple echo steady-state (TESS) relaxometry. Magnetic resonance in medicine : official journal of the Society of Magnetic Resonance in Medicine / Society of Magnetic Resonance in Medicine 2014;71(1):230-237.

27. Kaiser R, Bartholdi E, Ernst RR. Diffusion and field-gradient effects in NMR Fouirer spectroscipy. The Journal of Chemical Physics 1974;60(8):2966-2979.

28. Merboldt KD, Bruhn H, Frahm J, Gyngell ML, Hanicke W, Deimling M. MRI of "diffusion" in the human brain: new results using a modified CE-FAST sequence. Magnetic resonance in medicine : official journal of the Society of Magnetic Resonance in Medicine / Society of Magnetic Resonance in Medicine 1989;9(3):423-429.

29. Buxton RB. The diffusion sensitivity of fast steady-state free precession imaging. Magnetic resonance in medicine : official journal of the Society of Magnetic Resonance in Medicine / Society of Magnetic Resonance in Medicine 1993;29(2):235-243.

30. Zur Y, Bosak E, Kaplan N. A new diffusion SSFP imaging technique. Magnetic resonance in medicine : official journal of the Society of Magnetic Resonance in Medicine / Society of Magnetic Resonance in Medicine 1997;37(5):716-722.

31. Freed DE, Scheven UM, Zielinski LJ, Sen PN, Hurlimann MD. Steady-state free precession experiments and exact treatment of diffusion in a uniform gradient. J Chem Phys 2001;115(9):4249-4258.

32. Deimling M; Method to determine the ADC coefficients in diffusion-weighted magnetic resonance imaging given use of steady-state sequences2005.

33. Ganter C. Steady state of gradient echo sequences with radiofrequency phase cycling: analytical solution, contrast enhancement with partial spoiling. Magnetic resonance in medicine : official journal of the Society of Magnetic Resonance in Medicine / Society of Magnetic Resonance in Medicine 2006;55(1):98-107.

34. Bieri O, Scheffler K, Welsch GH, Trattnig S, Mamisch TC, Ganter C. Quantitative mapping of T2 using partial spoiling. Magnetic resonance in medicine : official journal of the Society of Magnetic Resonance in Medicine / Society of Magnetic Resonance in Medicine 2011;66(2):410-418.

35. de Sousa PL, Vignaud A, Caldas de Almeida Araujo E, Carlier PG. Factors controlling T2 mapping from partially spoiled SSFP sequence: optimization for skeletal muscle characterization. Magnetic resonance in medicine : official journal of the Society of Magnetic Resonance in Medicine / Society of Magnetic Resonance in Medicine 2012;67(5):1379-1390.

36. Liu WJ, Wang YL, Xie WC. Fisher information matrix, Rao test, and Wald test for complex-valued signals and their applications. Signal Process 2014;94:1-5.

37. Lori NF, Conturo TE, Le Bihan D. Definition of displacement probability and diffusion time in q-space magnetic resonance measurements that use finite-duration diffusion-encoding gradients. Journal of magnetic resonance 2003;165(2):185-195.

38. Weigel M, Schwenk S, Kiselev VG, Scheffler K, Hennig J. Extended phase graphs with anisotropic diffusion. Journal of magnetic resonance 2010;205(2):276-285.

39. Kuwata K, Brooks D, Yang H, Schleich T. Relaxation-matrix formalism for rotating-frame spin-lattice proton NMR relaxation and magnetization transfer in the presence of an off-resonance irradiation field. Journal of magnetic resonance Series B 1994;104(1):11-25.

40. Pruessmann KP, Weiger M, Scheidegger MB, Boesiger P. SENSE: sensitivity encoding for fast MRI. Magnetic resonance in medicine : official journal of the Society of Magnetic Resonance in Medicine / Society of Magnetic Resonance in Medicine 1999;42(5):952-962.

41. Lustig M, Donoho D, Pauly JM. Sparse MRI: The application of compressed sensing for rapid MR imaging. Magnetic resonance in medicine : official journal of the Society of Magnetic Resonance in Medicine / Society of Magnetic Resonance in Medicine 2007;58(6):1182-1195.

42. Ma D, Gulani V, Seiberlich N, Liu KC, Sunshine JL, Duerk JL, Griswold MA. Magnetic resonance fingerprinting. Nature 2013;495(7440):187-192.

**Revendications**

1. Procédé d'imagerie par résonance magnétique, comprenant :

    - une application continue d'un champ magnétique principal B0 selon un axe Z sur un échantillon, et
    - au moins un ensemble d'applications répétées, sur l'échantillon et selon une période TR, d'une séquence, ladite séquence comprenant :

        ◦ une impulsion radiofréquence d'amplitude et/ou de phase variable à chaque répétition, et
        ◦ après l'impulsion radiofréquence de la séquence, un gradient spatial de la composante selon l'axe Z du champ magnétique,

    le procédé étant tel qu' au cours des applications répétées de l'impulsion radiofréquence et du gradient spatial de champ magnétique de la séquence d'un même ensemble :

    - l'impulsion radiofréquence suit, entre ses différentes applications répétées, une suite périodique :

        ◦ pour son amplitude et
        ◦ pour $u_{n+1} = v_{n+1} — v_n$, où n est un entier supérieur ou égal à 1 représentant le numéro de la répétition de la séquence pour cet ensemble, et où $u_{n+1}$ est une suite de nombres entiers relatifs qui permet de définir la suite $v_n$ à une constante arbitraire près $v_1$ tel que $\varphi_n = v_n \times \Delta$ et $\varphi_n = \theta_n — \theta_{n—1}$ avec $\Delta$ qui est un nombre réel constant pour toutes les applications répétées de la séquence de cet ensemble et $\varphi_n$ qui est l'incrément entre la phase $\theta_n$ de l'impulsion radiofréquence à sa $n^{ième}$ répétition dans cet ensemble et la phase $\theta_{n—1}$ de l'impulsion radiofréquence à sa $(n-1)^{ième}$ répétition dans cet ensemble, avec $\theta_0$ une valeur arbitraire, et

    - chaque application répétée du gradient spatial de champ magnétique de la séquence a, selon une direction spatiale de gradient dite direction de codage identique pour chaque application de gradient de cet ensemble, une intégrale temporelle égale à A non nulle,

    le procédé comprenant en outre une acquisition, pendant au moins une des répétitions de la séquence, d'au moins un signal de résonance magnétique nucléaire
    **caractérisé en ce que** l'on acquiert le signal de résonance magnétique nucléaire à différents états d'équilibre dynamiques entrelacés et/ou séquentiels de l'aimantation de l'échantillon, et :

    - au cours des applications répétées de l'impulsion radiofréquence et du gradient spatial de champ magnétique de la séquence d'un même ensemble :

        ◦ la suite $u_{n+1} = v_{n+1} — v_n$ est une suite périodique non constante, et/ou
        ◦ l'amplitude de l'impulsion radiofréquence suit une suite périodique non constante,

    de manière à obtenir ces différents états d'équilibre de l'aimantation de l'échantillon entrelacés au sein de cet ensemble respectivement pour différentes valeurs périodiques de la suite $u_{n+1} = v_{n+1} — v_n$ et/ou de l'amplitude de l'impulsion radiofréquence, et **en ce que** l'on acquiert le signal de résonance magnétique nucléaire à ces différents états d'équilibre entrelacés, et/ou
    - on émet séquentiellement plusieurs ensembles, avec :

        ◦ $\Delta$ dont la valeur diffère entre les différents ensembles, et/ou
        ◦ l'amplitude de l'impulsion radiofréquence qui suit une suite périodique qui diffère entre les différents ensembles,

    de manière à obtenir ces différents états d'équilibres de l'aimantation de l'échantillon séquentiels pour différentes valeurs de $\Delta$ et/ou de l'amplitude dont au moins un état d'équilibre par ensemble, et **en ce que** l'on acquiert le signal de résonance magnétique nucléaire à ces différents états d'équilibre séquentiels.

**2.** Procédé selon la revendication 1, **caractérisé en ce que**, au cours des applications répétées de l'impulsion radiofréquence et du gradient spatial de champ magnétique de la séquence d'un même ensemble, la suite $u_{n+1} = v_{n+1} - v_n$ est une suite périodique non constante.

**3.** Procédé selon la revendication 1 ou 2, **caractérisé en ce que**, au cours des applications répétées de l'impulsion radiofréquence et du gradient spatial de champ magnétique de la séquence d'un même ensemble, l'amplitude de l'impulsion radiofréquence suit une suite périodique non constante.

**4.** Procédé selon la revendication 2 ou 3, **caractérisé en ce qu'**au cours des applications répétées de l'impulsion radiofréquence et du gradient spatial de champ magnétique de la séquence d'un même ensemble :

- la suite $u_{n+1} = v_{n+1} - v_n$ est une suite périodique non constante, et/ou
- l'amplitude de l'impulsion radiofréquence suit une suite périodique non constante,
de manière à obtenir différents états d'équilibre de l'aimantation de l'échantillon entrelacés au sein de cet ensemble respectivement pour différentes valeurs périodiques de la suite $u_{n+1} = v_{n+1} - v_n$ et/ou de l'amplitude de l'impulsion radiofréquence, et **en ce que** l'on acquiert le signal de résonance magnétique nucléaire à ces différents états d'équilibre entrelacés.

**5.** Procédé selon l'une quelconque des revendications précédentes, **caractérisé en ce que** l'on émet séquentiellement plusieurs ensembles, avec :

- Δ dont la valeur diffère entre les différents ensembles, et/ou
- l'amplitude de l'impulsion radiofréquence qui suit une suite périodique qui diffère entre les différents ensembles,
de manière à obtenir différents états d'équilibres de l'aimantation de l'échantillon séquentiels pour différentes valeurs de Δ et/ou de l'amplitude dont au moins un état d'équilibre par ensemble, et **en ce que** l'on acquiert le signal de résonance magnétique nucléaire à ces différents états d'équilibre séquentiels.

**6.** Procédé selon la revendication 5, **caractérisé en ce qu'**il comprend :

- une acquisition d'un signal pour deux états d'équilibres correspondants à deux amplitudes de l'impulsion radiofréquence identiques mais deux Δ différents,
- une comparaison du signal pour ces deux états d'équilibres, et
- une déduction, à partir de cette comparaison, de si l'amplitude de l'impulsion radiofréquence produit un angle de bascule effectif plus grand que ou plus petit que ou égal à l'angle de Ernst pour l'échantillon.

**7.** Procédé selon la revendication 76, **caractérisé en ce qu'**un des deux Δ différents est égal à zéro.

**8.** Procédé selon l'une quelconque des revendications 1 à 5, **caractérisé en ce qu'**il comprend :

- une acquisition d'un signal pour des états d'équilibres correspondants à des amplitudes différentes de l'impulsion radiofréquence et/ou des Δ différents de différents ensembles et/ou différentes valeurs de la suite $u_{n+1} = v_{n+1} - v_n$ périodique, et
- pour au moins un point dans l'échantillon, une détermination d'une aimantation nucléaire, d'un angle de bascule de l'aimantation, d'un coefficient de diffusion, d'un taux ou temps de relaxation longitudinal $R_1$ ou T1, et d'un taux ou temps de relaxation transversal R2 ou T2, à partir du signal acquis pour ces états d'équilibres.

**9.** Procédé selon la revendication 8, **caractérisé en ce que** la détermination est effectuée, soit par comparaison avec un dictionnaire pré-calculé soit par estimation itérative, selon une minimisation d'une norme de la différence entre le signal acquis exprimé sous forme complexe avec une partie réelle et une partie imaginaire et un modèle du signal exprimé sous forme complexe avec une partie réelle et une partie imaginaire.

**10.** Procédé selon la revendication 9, **caractérisé en ce que** la minimisation comprend un algorithme de minimisation au sens des moindres carrés, de préférence en utilisant l'algorithme de Gauss-Newton appliqué aux problèmes non-linéaires.

**11.** Procédé selon l'une quelconque des revendications 8 à 10, **caractérisé en ce qu'**il comprend une acquisition d'un signal pour des états d'équilibres correspondants à des Δ différents, dont :

- plusieurs points pour une valeur absolue de Δ entre Δ=0° inclus et Δ=32° inclus modulo 360°, et/ou
- plusieurs points pour une valeur absolue de Δ entre Δ=164° inclus et Δ= 196° inclus modulo 360°, et/ou
- plusieurs points pour une valeur absolue de Δ entre Δ=112° inclus et Δ=128° inclus modulo 360°, et/ou
- plusieurs points, pour une valeur absolue de Δ parmi 45°, 60°, 72°, 90°, et 144° modulo 360°.

12. Procédé selon l'une quelconque des revendications 8 à 11, **caractérisé en ce que** l'amplitude de l'impulsion radiofréquence correspond toujours à un angle de bascule de l'aimantation :

   - supérieur à l'angle de Ernst pour un temps de relaxation longitudinal T1 égal à 2000 millisecondes, et
   - inférieur ou égal à 90°.

13. Procédé selon l'une quelconque des revendications 8 à 12, **caractérisé en ce que** la détermination comprend une condition de continuité spatiale de l'aimantation nucléaire, de l'angle de bascule de l'aimantation, du coefficient de diffusion, du taux ou temps de relaxation longitudinal $R_1$ ou T1, et du taux ou temps de relaxation transversal R2 ou T2 entre différents points de l'échantillon.

14. Procédé selon l'une quelconque des revendications 1 à 13, **caractérisé en ce que** l'on émet séquentiellement plusieurs ensembles, et **en ce que** :

   - la direction de codage diffère entre différents ensembles, et/ou
   - la valeur de A diffère entre différents ensembles, et/ou
   - la forme du gradient de champ magnétique selon la direction de codage diffère entre différents ensembles.

15. Procédé selon la revendication 14, **caractérisé en ce qu'**il comprend en outre une quantification d'un coefficient de diffusion dans l'échantillon ou une détermination d'une direction privilégiée de diffusion dans l'échantillon ou une pondération de la diffusion dans l'échantillon par exploitation de la différence de A et/ou direction de codage et/ou de forme du gradient entre les différents ensembles.

16. Dispositif (1) d'imagerie par résonance magnétique, comprenant :

   - des moyens (2) pour appliquer, de manière continue, un champ magnétique principal B0 selon un axe Z sur une zone d'échantillon (8), et
   - des moyens (3) pour émettre un gradient de champ magnétique et des moyens (4) pour émettre une impulsion radiofréquence, et des moyens de commande (5) agencés pour commander les moyens pour émettre un gradient de champ magnétique et les moyens pour émettre une impulsion radiofréquence, les moyens de commande étant agencés pour ou programmés pour réaliser au moins un ensemble d'applications répétées, sur la zone d'échantillon et selon une période TR, d'une séquence, ladite séquence comprenant :

      ○ une impulsion radiofréquence d'amplitude et/ou de phase variable à chaque répétition, et
      ○ après l'impulsion radiofréquence de la séquence, un gradient spatial de la composante selon l'axe Z du champ magnétique, les moyens de commande étant agencés pour ou programmés pour que, au cours des

   applications répétées de l'impulsion radiofréquence et du gradient spatial de champ magnétique de la séquence d'un même ensemble :

   - l'impulsion radiofréquence suive, entre ses différentes applications répétées, une suite périodique :

      o pour son amplitude et
      ○ pour $u_{n+1} = v_{n+1} - v_n$, où n est un entier supérieur ou égal à 1 représentant le numéro de la répétition de la séquence pour cet ensemble, et où $u_{n+1}$ *est* une suite de nombres entiers relatifs qui permet de définir la suite $v_n$ à une constante arbitraire près $v_1$ tel que $\varphi_n = v_n \times \Delta$ et $\varphi_n = \theta_n - \theta_{n-1}$ avec Δ qui est un nombre réel constant pour toutes les applications répétées de la séquence de cet ensemble et $\varphi_n$ qui est l'incrément entre la phase $\theta_n$ de l'impulsion radiofréquence à sa $n^{\text{ième}}$ répétition dans cet ensemble et la phase $\theta_{n-1}$ de l'impulsion radiofréquence à sa $(n-1)^{\text{ième}}$ répétition dans cet ensemble, avec $\theta_0$. une valeur arbitraire, et

   - chaque application répétée du gradient spatial de champ magnétique de la séquence a, selon une direction spatiale de gradient dite direction de codage identique pour chaque application de gradient de cet ensemble, une intégrale temporelle égale à A non nulle,

le dispositif comprenant en outre des moyens (6) pour acquérir, pendant au moins une des répétitions de la séquence, au moins un signal de résonance magnétique nucléaire

**caractérisé en ce que** les moyens de commande sont en outre agencés pour ou programmés pour commander les moyens d'acquisition de manière à acquérir le signal de résonance magnétique nucléaire à différents états d'équilibre dynamiques entrelacés et/ou séquentiels de l'aimantation dans la zone d'échantillon, et :

- les moyens de commande sont agencés pour ou programmés pour que, au cours des applications répétées de l'impulsion radiofréquence et du gradient spatial de champ magnétique de la séquence d'un même ensemble :

  ◦ la suite $u_{n+1} = v_{n+1} - v_n$ soit une suite périodique non constante, et/ou
  ◦ l'amplitude de l'impulsion radiofréquence suive une suite périodique non constante,

de manière à obtenir ces différents états d'équilibre entrelacés de l'aimantation dans la zone d'échantillon au sein de cet ensemble respectivement pour différentes valeurs périodiques de la suite $u_{n+1} = v_{n+1} - v_n$ et/ou de l'amplitude de l'impulsion radiofréquence, les moyens de commande étant en outre agencés pour ou programmés pour commander les moyens d'acquisition de manière à acquérir le signal de résonance magnétique nucléaire à ces différents états d'équilibre entrelacés, et/ou

- les moyens de commande sont agencés pour ou programmés pour que l'on émette séquentiellement plusieurs ensembles, avec :

  ◦ Δ dont la valeur diffère entre les différents ensembles, et/ou
  ◦ l'amplitude de l'impulsion radiofréquence qui suit une suite périodique qui diffère entre les différents ensembles,

de manière à obtenir ces différents états d'équilibres séquentiels de l'aimantation dans la zone d'échantillon pour différentes valeurs de Δ et/ou de l'amplitude dont au moins un état d'équilibre par ensemble, les moyens de commande étant en outre agencés pour ou programmés pour commander les moyens d'acquisition de manière à acquérir le signal de résonance magnétique nucléaire à ces différents états d'équilibre séquentiels.

17. Dispositif selon la revendication 16, **caractérisé en ce que** les moyens de commande sont agencés pour ou programmés pour que, au cours des applications répétées de l'impulsion radiofréquence et du gradient spatial de champ magnétique de la séquence d'un même ensemble, la suite $u_{n+1} = v_{n+1} - v_n$ soit une suite périodique non constante.

18. Dispositif selon la revendication 16 ou 17, **caractérisé en ce que** les moyens de commande sont agencés pour ou programmés pour que, au cours des applications répétées de l'impulsion radiofréquence et du gradient spatial de champ magnétique de la séquence d'un même ensemble, l'amplitude de l'impulsion radiofréquence suive une suite périodique non constante.

19. Dispositif selon la revendication 17 ou 18, **caractérisé en ce que** les moyens de commande sont agencés pour ou programmés pour que, au cours des applications répétées de l'impulsion radiofréquence et du gradient spatial de champ magnétique de la séquence d'un même ensemble :

- la suite $u_{n+1} = v_{n+1} - v_n$ soit une suite périodique non constante, et/ou
- l'amplitude de l'impulsion radiofréquence suive une suite périodique non constante,

de manière à obtenir différents états d'équilibre entrelacés de l'aimantation dans la zone d'échantillon au sein de cet ensemble respectivement pour différentes valeurs périodiques de la suite $u_{n+1} = v_{n+1} - v_n$ et/ou de l'amplitude de l'impulsion radiofréquence, les moyens de commande étant en outre agencés pour ou programmés pour commander les moyens d'acquisition de manière à acquérir le signal de résonance magnétique nucléaire à ces différents états d'équilibre entrelacés.

20. Dispositif selon l'une quelconque des revendications 16 à 19, **caractérisé en ce que** les moyens de commande sont agencés pour ou programmés pour que l'on émette séquentiellement plusieurs ensembles, avec :

- Δ dont la valeur diffère entre les différents ensembles, et/ou
- l'amplitude de l'impulsion radiofréquence qui suit une suite périodique qui diffère entre les différents ensembles,

de manière à obtenir différents états d'équilibres séquentiels de l'aimantation dans la zone d'échantillon pour différentes valeurs de Δ et/ou de l'amplitude dont au moins un état d'équilibre par ensemble, les moyens de commande étant en outre agencés pour ou programmés pour commander les moyens d'acquisition de manière à acquérir le signal de résonance magnétique nucléaire à ces différents états d'équilibre séquentiels.

21. Dispositif selon la revendication 20, **caractérisé en ce que** les moyens de commande sont agencés pour ou programmés pour commander les moyens d'acquisition de manière à acquérir un signal pour deux états d'équilibres correspondants à deux amplitudes de l'impulsion radiofréquence identiques mais deux Δ différents, le dispositif comprenant en outre des moyens de calcul (7) agencés pour ou programmés pour :

   - comparer le signal pour ces deux états d'équilibres, et
   - déduire, à partir de cette comparaison, de si l'amplitude de l'impulsion radiofréquence produit un angle de bascule effectif plus grand que ou plus petit que ou égal à l'angle de Ernst dans la zone d'échantillon.

22. Dispositif selon la revendication 21, **caractérisé en ce qu'**un des deux Δ différents est égal à zéro.

23. Dispositif selon l'une quelconque des revendications 16 à 20, **caractérisé en ce que** les moyens de commande sont agencés pour ou programmés pour commander les moyens d'acquisition de manière à acquérir un signal pour des états d'équilibres correspondants à des amplitudes différentes de l'impulsion radiofréquence et/ou des Δ différents de différents ensembles et/ou différentes valeurs de la suite $u_{n+1} = v_{n+1} - v_n$ périodique, le dispositif comprenant en outre des moyens de calcul (7) agencés pour ou programmés pour, pour au moins un point dans la zone d'échantillon, déterminer une aimantation nucléaire, un angle de bascule de l'aimantation, un coefficient de diffusion, un taux ou temps de relaxation longitudinal R1 ou T1, et un taux ou temps de relaxation transversal R2 ou T2, à partir du signal acquis pour ces états d'équilibres.

24. Dispositif selon la revendication 23, **caractérisé en ce que** les moyens de calcul sont agencés pour ou programmés pour effectuer cette détermination, soit par comparaison avec un dictionnaire pré-calculé soit par estimation itérative, selon une minimisation d'une norme de la différence entre le signal acquis exprimé sous forme complexe avec une partie réelle et une partie imaginaire et un modèle du signal exprimé sous forme complexe avec une partie réelle et une partie imaginaire.

25. Dispositif selon la revendication 24, **caractérisé en ce que** la minimisation comprend un algorithme de minimisation au sens des moindres carrés, de préférence en utilisant l'algorithme de Gauss-Newton appliqué aux problèmes non-linéaires.

26. Dispositif selon l'une quelconque des revendications 23 à 25, **caractérisé en ce que** les moyens de commande sont agencés pour ou programmés pour commander les moyens d'acquisition de manière à acquérir un signal pour des états d'équilibres correspondants à des Δ différents, dont :

   - plusieurs points pour une valeur absolue de Δ entre Δ=0° inclus et Δ=32° inclus modulo 360°, et/ou
   - plusieurs points pour une valeur absolue de Δ entre Δ=164° inclus et Δ= 196° inclus modulo 360°, et/ou
   - plusieurs points pour une valeur absolue de Δ entre Δ=112° inclus et Δ=128° inclus modulo 360°, et/ou
   - plusieurs points, pour une valeur absolue de Δ parmi 45°, 60°, 72°, 90°, et 144° modulo 360°.

27. Dispositif selon l'une quelconque des revendications 23 à 26, **caractérisé en ce que** les moyens de commande sont agencés pour ou programmés pour que l'amplitude de l'impulsion radiofréquence corresponde toujours à un angle de bascule de l'aimantation :

   - supérieur à l'angle de Ernst pour un temps de relaxation longitudinal T1 égal à 2000 millisecondes, et
   - inférieur ou égal à 90°.

28. Dispositif selon l'une quelconque des revendications 23 à 27, **caractérisé en ce que** les moyens de calcul sont agencés pour ou programmés pour que la détermination comprenne une condition de continuité spatiale de l'aimantation nucléaire, de l'angle de bascule de l'aimantation, du coefficient de diffusion, du taux ou temps de relaxation longitudinal R1 ou T1, et du taux ou temps de relaxation transversal R2 ou T2 entre différents points de la zone d'échantillon.

29. Dispositif selon l'une quelconque des revendications 4-7-16 à 28, **caractérisé en ce que** les moyens de commande sont agencés pour ou programmés pour émettre séquentiellement plusieurs ensembles, de sorte que :

- la direction de codage diffère entre différents ensembles, et/ou
- la valeur de A diffère entre différents ensembles, et/ou
- la forme du gradient de champ magnétique selon la direction de codage diffère entre différents ensembles.

30. Dispositif selon la revendication 29, **caractérisé en ce qu'**il comprend en outre des moyens de calcul (7) agencés pour ou programmés pour:

- quantifier un coefficient de diffusion dans la zone d'échantillon ou
- déterminer une direction privilégiée de diffusion dans la zone d'échantillon ou
- pondérer la diffusion dans la zone d'échantillon,

par exploitation de la différence de A et/ou direction de codage et/ou de forme du gradient entre les différents ensembles.

**Patentansprüche**

1. Verfahren zur Bildgebung mittels Magnetresonanz, umfassend:

- ein kontinuierliches Anlegen eines Hauptmagnetfeldes B0 entlang einer Z-Achse an eine Probe, und
- mindestens einen Satz von wiederholten Anwendungen einer Sequenz auf die Probe und entsprechend eines Zeitraums TR, wobei die Sequenz umfasst:

  ◦ einen Hochfrequenzimpuls mit variabler Amplitude und/oder variabler Phase bei jeder Wiederholung, und
  ◦ nach dem Hochfrequenzimpuls der Sequenz einen räumlichen Gradienten der Komponente entlang der Z-Achse des Magnetfeldes,

wobei das Verfahren so gestaltet ist, dass bei wiederholten Anwendungen des Hochfrequenzimpulses und des räumlichen Gradienten des Magnetfeldes der Sequenz des gleichen Satzes:

- der Hochfrequenzimpuls bei seinen verschiedenen wiederholten Anwendungen einer periodischen Folge folgt:

  ◦ für seine Amplitude und
  ◦ für $u_{n+1} = \nu_{n+1} - \nu_n$, wobei n eine ganze Zahl größer oder gleich 1 ist, die die Anzahl der Wiederholungen der Sequenz für diesen Satz darstellt, und wobei $u_{n+1}$ eine Folge von Relativzahlen ist, die es erlaubt, die Folge $\nu_n$ bei einer beliebigen Konstante $\nu_1$ so zu definieren, dass $\varphi_n = \nu_n \times \Delta$ und $\varphi_n = \theta_n - \theta_{n-1}$ gilt, wobei $\Delta$ eine konstante reelle Zahl für alle wiederholten Anwendungen der Sequenz dieses Satzes ist und $\varphi_n$ das Inkrement zwischen der Phase $\theta_n$ des Hochfrequenzimpulses bei seiner n-ten Wiederholung in diesem Satz und der Phase $\theta_{n-1}$ des Hochfrequenzimpulses bei seiner (n-1)-ten Wiederholung in diesem Satz ist, wobei $\theta_0$ ein beliebiger Wert ist, und

- jede wiederholte Anwendung des räumlichen Gradienten des Magnetfeldes der Sequenz gemäß einer räumlichen Gradientenrichtung, genannt Kodierungsrichtung, die für jede Anwendung des Gradienten dieses Satzes identisch ist, ein Zeitintegral von A ungleich Null besitzt,

wobei das Verfahren ferner eine Erfassung mindestens eines kernmagnetischen Resonanzsignals während mindestens einer der Wiederholungen der Sequenz umfasst,
**dadurch gekennzeichnet, dass** das kernmagnetische Resonanzsignal bei verschiedenen verschachtelten und/oder aufeinanderfolgenden dynamischen Gleichgewichtszuständen der Magnetisierung der Probe erfasst wird, und:

- bei den wiederholten Anwendungen des Hochfrequenzimpulses und des räumlichen Gradienten des Magnetfeldes der Sequenz eines gleichen Satzes:

  ◦ die Folge $u_{n+1} = \nu_{n+1} - \nu_n$ eine nicht-konstante periodische Folge ist, und/oder
  ◦ die Amplitude des Hochfrequenzimpulses einer nicht-konstanten periodischen Folge folgt,

so dass diese verschiedenen Gleichgewichtszustände der Magnetisierung der Probe verschachtelt innerhalb dieses Satzes jeweils für unterschiedliche periodische Werte der Folge $u_{n+1} = v_{n+1} - v_n$ und/oder der Amplitude des Hochfrequenzimpulses erhalten werden, und dass das kernmagnetische Resonanzsignal bei diesen verschiedenen verschachtelten Gleichgewichtszuständen erfasst wird, und/oder

- nacheinander mehrere Sätze ausgesendet werden, wobei:

  ◦ der Wert von $\Delta$ sich zwischen den verschiedenen Sätzen unterscheidet, und/oder
  ◦ die Amplitude des Hochfrequenzimpulses, die einer periodischen Folge folgt, sich zwischen den verschiedenen Sätzen unterscheidet,

so dass diese verschiedenen sequentiellen Gleichgewichtszustände der Magnetisierung der Probe für unterschiedliche Werte von $\Delta$ und/oder der Amplitude erhalten werden, darunter mindestens ein Gleichgewichtszustand pro Satz, und dass das kernmagnetische Resonanzsignal bei diesen verschiedenen sequentiellen Gleichgewichtszuständen erfasst wird.

2.  Verfahren nach Anspruch 1, **dadurch gekennzeichnet, dass** bei den wiederholten Anwendungen des Hochfrequenzimpulses und des räumlichen Gradienten des Magnetfeldes der Sequenz eines gleichen Satzes die Folge $u_{n+1} = v_{n+1} - v_n$ eine nicht-konstante periodische Folge ist.

3.  Verfahren nach Anspruch 1 oder 2, **dadurch gekennzeichnet, dass** bei den wiederholten Anwendungen des Hochfrequenzimpulses und des räumlichen Gradienten des Magnetfeldes der Sequenz eines gleichen Satzes die Amplitude des Hochfrequenzimpulses einer nicht-konstanten periodischen Folge folgt.

4.  Verfahren nach Anspruch 2 oder 3, **dadurch gekennzeichnet, dass** bei den wiederholten Anwendungen des Hochfrequenzimpulses und des räumlichen Magnetfeldgradienten der Sequenz eines gleichen Satzes:

    - die Folge $u_{n+1} = v_{n+1} - v_n$ eine nicht-konstante periodische Folge ist, und/oder
    - die Amplitude des Hochfrequenzimpulses einer nicht-konstanten periodischen Folge folgt, so dass verschiedene Gleichgewichtszustände der Magnetisierung der Probe erhalten werden, die innerhalb dieses Satzes jeweils für unterschiedliche periodische Werte der Folge $u_{n+1} = v_{n+1} - v_n$ und/oder der Amplitude des Hochfrequenzimpulses verschachtelt sind, und dass das kernmagnetische Resonanzsignal bei diesen verschiedenen verschachtelten Gleichgewichtszuständen erfasst wird.

5.  Verfahren nach einem der vorhergehenden Ansprüche, **dadurch gekennzeichnet, dass** nacheinander mehrere Sätze ausgesendet werden, wobei:

    - der Wert von $\Delta$ sich zwischen den verschiedenen Sätzen unterscheidet, und/oder
    - die Amplitude des Hochfrequenzimpulses, die einer periodischen Folge folgt, sich zwischen den verschiedenen Sätzen unterscheidet,

so dass verschiedene sequentielle Gleichgewichtszustände der Magnetisierung der Probe für unterschiedliche Werte von $\Delta$ und/oder der Amplitude erhalten werden, darunter mindestens ein Gleichgewichtszustand pro Satz, und dass das kernmagnetische Resonanzsignal bei diesen verschiedenen sequentiellen Gleichgewichtszuständen erfasst wird.

6.  Verfahren nach Anspruch 5, **dadurch gekennzeichnet, dass** es umfasst:

    - eine Erfassung eines Signals für zwei Gleichgewichtszustände, die zwei identischen Amplituden des Hochfrequenzimpulses, aber zwei unterschiedlichen $\Delta$ entsprechen,
    - einen Vergleich des Signals für diese beiden Gleichgewichtszustände, und
    - eine Ableitung aus diesem Vergleich, ob die Amplitude des Hochfrequenzimpulses einen effektiven Kippwinkel erzeugt, der größer oder kleiner oder gleich dem Ernst-Winkel für die Probe ist.

7.  Verfahren nach Anspruch 6, **dadurch gekennzeichnet, dass** eines der beiden unterschiedlichen $\Delta$ Null ist.

8.  Verfahren nach einem der Ansprüche 1 bis 5, **dadurch gekennzeichnet, dass** es umfasst:

    - eine Signalerfassung für Gleichgewichtszustände, die unterschiedlichen Amplituden des Hochfrequenzimpul-

ses und/oder unterschiedlichen $\Delta$ verschiedener Sätze und/oder unterschiedlichen Werten der periodischen Folge $u_{n+1} = v_{n+1} - v_n$ entsprechen, und

- für mindestens einen Punkt in der Probe eine Bestimmung einer Kernmagnetisierung, eines Kippwinkels der Magnetisierung, eines Diffusionskoeffizienten, einer longitudinalen Relaxationsrate oder -zeit R1 oder T1 und einer transversalen Relaxationsrate oder -zeit R2 oder T2, basierend auf dem für diese Gleichgewichtszustände erfassten Signal.

9. Verfahren nach Anspruch 8, **dadurch gekennzeichnet, dass** die Bestimmung entweder durch Vergleich mit einem vorab berechneten Datenverzeichnis oder durch iterative Schätzung gemäß einer Minimierung einer Norm der Differenz zwischen dem in komplexer Form mit einem Realteil und einem Imaginärteil ausgedrückten erfassten Signal und einem Modell des in komplexer Form mit einem Realteil und einem Imaginärteil ausgedrückten Signals erfolgt.

10. Verfahren nach Anspruch 9, **dadurch gekennzeichnet, dass** die Minimierung einen Algorithmus zur Minimierung der kleinsten Quadrate umfasst, vorzugsweise unter Verwendung des auf nichtlineare Probleme angewandten Gauß-Newton-Verfahrens.

11. Verfahren nach einem der Ansprüche 8 bis 10, **dadurch gekennzeichnet, dass** es eine Erfassung eines Signals für Gleichgewichtszustände umfasst, die unterschiedlichen $\Delta$ entsprechen, darunter:

- mehrere Positionen für einen Absolutwert von $\Delta$ zwischen $\Delta=0°$ einschließlich und $\Delta=32°$ einschließlich modulo 360°, und/oder
- mehrere Positionen für einen Absolutwert von $\Delta$ zwischen $\Delta=164°$ einschließlich und $\Delta=196°$ einschließlich modulo 360°, und/oder
- mehrere Positionen für einen Absolutwert von $\Delta$ zwischen $\Delta=112°$ einschließlich und $\Delta=128°$ einschließlich modulo 360°, und/oder
- mehrere Positionen für einen Absolutwert von $\Delta$ in der Größenordnung von 45°, 60°, 72°, 90° und 144° modulo 360°.

12. Verfahren nach einem der Ansprüche 8 bis 11, **dadurch gekennzeichnet, dass** die Amplitude des Hochfrequenzimpulses stets einem Kippwinkel der Magnetisierung entspricht:

- größer als der Ernst-Winkel bei einer Längsrelaxationszeit T1 von 2000 Millisekunden, und
- kleiner als oder gleich 90°.

13. Verfahren nach einem der Ansprüche 8 bis 12, **dadurch gekennzeichnet, dass** die Bestimmung einen Zustand der räumlichen Kontinuität der Kernmagnetisierung, des Kippwinkels der Magnetisierung, des Diffusionskoeffizienten, der longitudinalen Relaxationsrate oder -zeit R1 oder T1 und der transversalen Relaxationsrate oder -zeit R2 oder T2 zwischen verschiedenen Punkten in der Probe umfasst.

14. Verfahren nach einem der Ansprüche 1 bis 13, **dadurch gekennzeichnet, dass** nacheinander mehrere Sätze ausgesendet werden, und dadurch, dass:

- die Kodierungsrichtung zwischen verschiedenen Sätzen unterschiedlich ist, und/oder
- der Wert von A zwischen verschiedenen Sätzen unterschiedlich ist, und/oder
- die Form des Gradienten des Magnetfeldes gemäß der Kodierungsrichtung zwischen verschiedenen Sätzen unterschiedlich ist.

15. Verfahren nach Anspruch 14, **dadurch gekennzeichnet, dass** es ferner eine Quantifizierung eines Diffusionskoeffizienten in der Probe oder eine Bestimmung einer bevorzugten Richtung der Diffusion in der Probe oder einer Verteilung der Diffusion in der Probe durch Ausnutzung des Unterschieds in A und/oder der Kodierungsrichtung und/oder der Form des Gradienten zwischen den verschiedenen Sätzen umfasst.

16. Vorrichtung (1) zur Bildgebung mittels Magnetresonanz, umfassend:

- Mittel (2) zum kontinuierlichen Anlegen eines Hauptmagnetfeldes B0 entlang einer Z-Achse an einen Probenbereich (8), und
- Mittel (3) zum Aussenden eines Gradienten eines magnetischen Feldes und Mittel (4) zum Aussenden eines Hochfrequenzimpulses, und Steuermittel (5), die zum Steuern der Mittel zum Aussenden eines Gradienten eines magnetischen Feldes und der Mittel zum Aussenden eines Hochfrequenzimpulses eingerichtet sind, wobei die Steuermittel dazu eingerichtet oder dazu programmiert sind, mindestens einen Satz von wiederholten Anwendungen einer Sequenz auf den Probenbereich und einer Periode TR entsprechend durchzuführen, wobei die Sequenz umfasst:

○ einen Hochfrequenzimpuls mit variabler Amplitude und/oder variabler Phase bei jeder Wiederholung, und
○ nach dem Hochfrequenzimpuls der Sequenz einen räumlichen Gradienten der Komponente entlang der Z-Achse des Magnetfelds,

wobei die Steuermittel dazu eingerichtet oder dazu programmiert sind, dass bei den wiederholten Anwendungen des Hochfrequenzimpulses und des räumlichen Gradienten des Magnetfeldes der Sequenz eines gleichen Satzes:

- der Hochfrequenzimpuls bei seinen verschiedenen wiederholten Anwendungen einer periodischen Folge folgt:

○ für seine Amplitude und
○ für $u_{n+1} = v_{n+1} - v_n$, wobei n eine ganze Zahl größer oder gleich 1 ist, die die Anzahl der Wiederholungen der Sequenz für diesen Satz darstellt, und wobei $u_{n+1}$ eine Folge von Relativzahlen ist, die es erlaubt, die Folge $v_n$ bei einer beliebigen Konstante $v_1$ so zu definieren, dass $\varphi_n = v_n \times \Delta$ und $\varphi_n = \theta_n - \theta_{n-1}$ gilt, wobei $\Delta$ eine konstante reelle Zahl für alle wiederholten Anwendungen der Sequenz dieses Satzes ist und $\varphi_n$ das Inkrement zwischen der Phase $\theta_n$ des Hochfrequenzimpulses bei seiner n-ten Wiederholung in diesem Satz und der Phase $\theta_{n-1}$ des Hochfrequenzimpulses bei seiner (n-1)-ten Wiederholung in diesem Satz ist, wobei $\theta_0$ ein beliebiger Wert ist, und

- jede wiederholte Anwendung des räumlichen Gradienten des Magnetfeldes der Sequenz gemäß einer räumlichen Gradientenrichtung, genannt Kodierungsrichtung, die für jede Anwendung des Gradienten dieses Satzes identisch ist, ein Zeitintegral von A ungleich Null besitzt,

wobei die Vorrichtung ferner Mittel (6) umfasst, um während mindestens einer der Wiederholungen der Sequenz mindestens ein kernmagnetisches Resonanzsignal zu erfassen, **dadurch gekennzeichnet, dass** die Steuermittel ferner dazu eingerichtet oder dazu programmiert sind, die Erfassungsmittel so zu steuern, dass sie das kernmagnetische Resonanzsignal bei verschiedenen verschachtelten und/oder aufeinanderfolgenden dynamischen Gleichgewichtszuständen der Magnetisierung in dem Probenbereich erfassen, und:

- die Steuermittel dazu eingerichtet oder dazu programmiert sind, dass bei den wiederholten Anwendungen des Hochfrequenzimpulses und des räumlichen Gradienten des Magnetfeldes der Sequenz eines gleichen Satzes:

○ die Folge $u_{n+1} = v_{n+1} - v_n$ eine nicht-konstante periodische Folge ist, und/oder
○ die Amplitude des Hochfrequenzimpulses einer nicht-konstanten periodischen Folge folgt,

so dass diese verschiedenen verschachtelten Gleichgewichtszustände der Magnetisierung in dem Probenbereich innerhalb dieses Satzes jeweils für unterschiedliche periodische Werte der Folge $u_{n+1} = v_{n+1} - v_n$ und/oder der Amplitude des Hochfrequenzimpulses erhalten werden, wobei die Steuermittel ferner dazu eingerichtet oder dazu programmiert sind, die Erfassungsmittel so zu steuern, dass das kernmagnetische Resonanzsignal bei diesen verschiedenen verschachtelten Gleichgewichtszuständen erfasst wird, und/oder

- die Steuermittel dazu eingerichtet oder dazu programmiert sind, mehrere Sätze nacheinander auszusenden, wobei:

○ der Wert von $\Delta$ sich zwischen den verschiedenen Sätzen unterscheidet, und/oder
○ die Amplitude des Hochfrequenzimpulses, die einer periodischen Folge folgt, sich zwischen den verschiedenen Sätzen unterscheidet,

so dass diese verschiedenen sequentiellen Gleichgewichtszustände der Magnetisierung im Probenbereich für unterschiedliche Werte von $\Delta$ und/oder der Amplitude erhalten werden, darunter mindestens ein Gleichgewichtszustand pro Satz, wobei die Steuermittel ferner dazu eingerichtet oder dazu programmiert sind, die Erfassungsmittel so zu steuern, dass das kernmagnetische Resonanzsignal bei diesen verschiedenen sequentiellen Gleichgewichtszuständen erfasst wird.

17. Vorrichtung nach Anspruch 16, **dadurch gekennzeichnet, dass** die Steuermittel dazu eingerichtet oder dazu programmiert sind, dass bei den wiederholten Anwendungen des Hochfrequenzimpulses und des räumlichen Gradienten des Magnetfeldes der Sequenz eines gleichen Satzes die Folge $u_{n+1} = v_{n+1} - v_n$ eine nicht-konstante periodische Folge ist.

18. Vorrichtung nach Anspruch 16 oder 17, **dadurch gekennzeichnet, dass** die Steuermittel dazu eingerichtet oder dazu programmiert sind, dass bei den wiederholten Anwendungen des Hochfrequenzimpulses und des räumlichen Gradienten des Magnetfeldes der Sequenz eines gleichen Satzes die Amplitude des Hochfrequenzimpulses einer nicht-konstanten periodischen Folge folgt.

19. Vorrichtung nach Anspruch 17 oder 18, **dadurch gekennzeichnet, dass** die Steuermittel dazu eingerichtet oder dazu programmiert sind, dass bei den wiederholten Anwendungen des Hochfrequenzimpulses und des räumlichen Gradienten des Magnetfeldes der Sequenz eines gleichen Satzes:

   - die Sequenz $u_{n+1} = v_{n+1} - v_n$ eine nicht-konstante periodische Sequenz ist, und/oder
   - die Amplitude des Hochfrequenzimpulses einer nicht-konstanten periodischen Folge folgt, so dass verschiedene verschachtelte Gleichgewichtszustände der Magnetisierung in dem Probenbereich innerhalb dieses Satzes jeweils für unterschiedliche periodische Werte der Folge $u_{n+1} = v_{n+1} - v_n$ und/oder der Amplitude des Hochfrequenzimpulses erhalten werden, wobei die Steuermittel ferner dazu eingerichtet oder dazu programmiert sind, die Erfassungsmittel so zu steuern, dass das kernmagnetische Resonanzsignal bei diesen verschiedenen verschachtelten Gleichgewichtszuständen erfasst wird.

20. Vorrichtung nach einem der Ansprüche 16 bis 19, **dadurch gekennzeichnet, dass** die Steuermittel dazu eingerichtet oder dazu programmiert sind, mehrere Sätze nacheinander auszusenden, wobei:

   - der Wert von $\Delta$ sich zwischen den verschiedenen Sätzen unterscheidet, und/oder
   - die Amplitude des Hochfrequenzimpulses, die einer periodischen Folge folgt, sich zwischen den verschiedenen Sätzen unterscheidet,

   so dass verschiedene sequentielle Gleichgewichtszustände der Magnetisierung im Probenbereich für unterschiedliche Werte von $\Delta$ und/oder der Amplitude erhalten werden, darunter mindestens ein Gleichgewichtszustand pro Satz, wobei die Steuermittel ferner dazu eingerichtet oder dazu programmiert sind, die Erfassungsmittel so zu steuern, dass das kernmagnetische Resonanzsignal bei diesen verschiedenen sequentiellen Gleichgewichtszuständen erfasst wird.

21. Vorrichtung nach Anspruch 20, **dadurch gekennzeichnet, dass** die Steuermittel dazu eingerichtet oder dazu programmiert sind, die Erfassungsmittel so zu steuern, dass sie ein Signal für zwei Gleichgewichtszustände erfassen, die zwei identischen Amplituden des Hochfrequenzimpulses, aber zwei unterschiedlichen $\Delta$ entsprechen, wobei die Vorrichtung ferner Rechenmittel (7) umfasst, die dazu eingerichtet oder dazu programmiert sind:

   - das Signal für diese beiden Gleichgewichtszustände zu vergleichen, und
   - aus diesem Vergleich abzuleiten, ob die Amplitude des Hochfrequenzimpulses einen effektiven Kippwinkel erzeugt, der größer oder kleiner oder gleich dem Ernst-Winkel im Probenbereich ist.

22. Vorrichtung nach Anspruch 21, **dadurch gekennzeichnet, dass** eines der beiden unterschiedlichen $\Delta$ gleich Null ist.

23. Vorrichtung nach einem der Ansprüche 16 bis 20, **dadurch gekennzeichnet, dass** die Steuermittel dazu eingerichtet oder dazu programmiert sind, die Erfassungsmittel so zu steuern, dass sie ein Signal für Gleichgewichtszustände erfassen, die unterschiedlichen Amplituden des Hochfrequenzimpulses und/oder unterschiedlichen $\Delta$ verschiedener Sätze und/oder unterschiedlichen Werten der periodischen Folge $u_{n+1} = v_{n+1} - v_n$ entsprechen, wobei die Vorrichtung ferner Rechenmittel (7) umfasst, die dazu eingerichtet oder dazu programmiert sind, für mindestens einen Punkt im Probenbereich eine Kernmagnetisierung, einen Kippwinkel der Magnetisierung, einen Diffusionskoeffizienten, eine longitudinale Relaxationsrate oder -zeit R1 oder T1 und eine transversale Relaxationsrate oder -zeit R2 oder T2 basierend auf dem für diese Gleichgewichtszustände erfassten Signal zu bestimmen.

**24.** Vorrichtung nach Anspruch 23, **dadurch gekennzeichnet, dass** die Rechenmittel dazu eingerichtet oder dazu programmiert sind, die Bestimmung entweder durch Vergleich mit einem vorab berechneten Datenverzeichnis oder durch iterative Schätzung gemäß einer Minimierung einer Norm der Differenz zwischen dem in komplexer Form mit einem Realteil und einem Imaginärteil ausgedrückten erfassten Signal und einem Modell des in komplexer Form mit einem Realteil und einem Imaginärteil ausgedrückten Signals durchzuführen.

**25.** Vorrichtung nach Anspruch 24, **dadurch gekennzeichnet, dass** die Minimierung einen Algorithmus zur Minimierung der kleinsten Quadrate umfasst, vorzugsweise unter Verwendung des auf nichtlineare Probleme angewandten Gauß-Newton-Verfahrens.

**26.** Vorrichtung nach einem der Ansprüche 23 bis 25, **dadurch gekennzeichnet, dass** die Steuermittel dazu eingerichtet oder dazu programmiert sind, die Erfassungsmittel so zu steuern, dass sie ein Signal für Gleichgewichtszustände erfassen, die unterschiedlichen $\Delta$ entsprechen, darunter:

- mehrere Positionen für einen Absolutwert von $\Delta$ zwischen $\Delta=0°$ einschließlich und $\Delta=32°$ einschließlich modulo 360°, und/oder
- mehrere Positionen für einen Absolutwert von $\Delta$ zwischen $\Delta=164°$ einschließlich und $\Delta=196°$ einschließlich modulo 360°, und/oder
- mehrere Positionen für einen Absolutwert von $\Delta$ zwischen $\Delta=112°$ einschließlich und $\Delta=128°$ einschließlich modulo 360°, und/oder
- mehrere Positionen für einen Absolutwert von $\Delta$ in der Größenordnung von 45°, 60°, 72°, 90° und 144° modulo 360°.

**27.** Vorrichtung nach einem der Ansprüche 23 bis 26, **dadurch gekennzeichnet, dass** die Steuermittel dazu eingerichtet oder dazu programmiert sind, dass die Amplitude des Hochfrequenzimpulses stets einem Kippwinkel der Magnetisierung entspricht:

- größer als der Ernst-Winkel bei einer Längsrelaxationszeit T1 von 2000 Millisekunden, und
- kleiner als oder gleich 90°.

**28.** Vorrichtung nach einem der Ansprüche 23 bis 27, **dadurch gekennzeichnet, dass** die Rechenmittel dazu eingerichtet oder dazu programmiert sind, dass die Bestimmung einen Zustand der räumlichen Kontinuität der Kernmagnetisierung, des Kippwinkels der Magnetisierung, des Diffusionskoeffizienten, der longitudinalen Relaxationsrate oder -zeit R1 oder T1 und der transversalen Relaxationsrate oder -zeit R2 oder T2 zwischen verschiedenen Punkten im Probenbereich umfasst.

**29.** Vorrichtung nach einem der Ansprüche 16 bis 28, **dadurch gekennzeichnet, dass** die Steuermittel dazu eingerichtet oder dazu programmiert sind, mehrere Sätze nacheinander auszusenden, so dass:

- die Kodierungsrichtung zwischen verschiedenen Sätzen unterschiedlich ist, und/oder
- der Wert von A zwischen verschiedenen Sätzen unterschiedlich ist, und/oder
- die Form des Gradienten des Magnetfeldes gemäß der Kodierungsrichtung zwischen verschiedenen Sätzen unterschiedlich ist.

**30.** Vorrichtung nach Anspruch 29, **dadurch gekennzeichnet, dass** diese ferner Rechenmittel (7) umfasst, die dazu eingerichtet oder dazu programmiert sind:

- den Diffusionskoeffizienten im Probenbereich zu quantifizieren oder
- eine bevorzugte Richtung der Diffusion im Probenbereich zu bestimmen oder
- die Diffusion im Probenbereich zu gewichten,

durch Ausnutzung des Unterschieds in A und/oder der Kodierungsrichtung und/oder der Form des Gradienten zwischen den verschiedenen Sätzen.

**Claims**

**1.** Method for magnetic resonance imaging, comprising:

- continuous application of a main magnetic field $B_0$ along a Z-axis on a sample, and
- at least one set of repeated applications, on the sample and according to a period TR, of a sequence, said sequence comprising:

  ○ a radiofrequency pulse of variable amplitude and/or of variable phase at each repetition, and
  ○ after the radiofrequency pulse of the sequence, a spatial gradient of the component along the Z-axis of the magnetic field,

the process being such that during the repeated applications of the radiofrequency pulse and of the magnetic field spatial gradient of the sequence of one and the same set:

- the radiofrequency pulse follows, between its different repeated applications, a periodic series:

  ○ for its amplitude, and
  ○ for $u_{n+1} = v_{n+1} - v_n$, where n is an integer greater than or equal to 1 representing the repetition number of the sequence for this set, and where $u_{n+1}$ is a relative integer series making it possible to define the series $v_n$ up to an arbitrary constant $v_1$ such that $\varphi_n = v_n \times \Delta$ and $\varphi_n = \theta_n - \theta_{n-1}$ with $\Delta$ which is a constant real number for all of the repeated applications of the sequence of this set and $\varphi_n$ which is the increment between the phase $\theta_n$ of the radiofrequency pulse at its $n^{th}$ repetition in this set and the phase $\theta_{n-1}$ of the radiofrequency pulse at its $(n-1)^{th}$ repetition in this set, with $\theta_0$ an arbitrary value, and

- each repeated application of the magnetic field spatial gradient of the sequence has, in a spatial gradient direction called encoding direction identical for each gradient application of this set, a non-zero temporal integral equal to A,

the method also comprising an acquisition, during at least one of the repetitions of the sequence, of at least one nuclear magnetic resonance signal
**characterized in that** the nuclear magnetic resonance signal is acquired at different sequential and/or interleaved dynamic steady state of the magnetization in the sample, and:

- during repeated applications of the radiofrequency pulse and of the magnetic field spatial gradient of the sequence of one and the same set:

  ○ the series $u_{n+1} = v_{n+1} - v_n$ is a non-constant periodic series, and/or
  ○ the amplitude of the radiofrequency pulse follows a non-constant periodic series

so as to obtain these different steady states of the magnetization in the sample interleaved within this set respectively for different periodic values of the series $u_{n+1} = v_{n+1} - v_n$ and/or of the amplitude of the radiofrequency pulse, and **in that** the nuclear magnetic resonance signal is acquired at these different interleaved steady states, and/or

- several sets are transmitted sequentially, with:

  ○ $\Delta$ the value of which differs between the different sets, and/or
  ○ the amplitude of the radiofrequency pulse that follows a periodic series that differs between the different sets,

so as to obtain these different sequential steady states of the magnetization in the sample for different values of $\Delta$ and/or of the amplitude, of which there is at least one steady state per set, and **in that** the nuclear magnetic resonance signal is acquired at these different sequential steady states.

2. Method according to claim 1, **characterized in that**, during repeated applications of the radiofrequency pulse and of the magnetic field spatial gradient of the sequence of one and the same set, the series $u_{n+1} = v_{n+1} - v_n$ is a non-constant periodic series.

3. Method according to claim 1 or 2, **characterized in that**, during repeated applications of the radiofrequency pulse and of the magnetic field spatial gradient of the sequence of one and the same set, the amplitude of the radiofrequency pulse follows a non-constant periodic series.

4. Method according to claim 2 or 3, **characterized in that** during repeated applications of the radiofrequency pulse and of the magnetic field spatial gradient of the sequence of one and the same set:

- the series $u_{n+1} = v_{n+1} - v_n$ is a non-constant periodic series, and/or
- the amplitude of the radiofrequency pulse follows a non-constant periodic series,

so as to obtain different steady states of the magnetization in the sample interleaved within this set respectively for different periodic values of the series $u_{n+1} = v_{n+1} - v_n$ and/or of the amplitude of the radiofrequency pulse, and **in that** the nuclear magnetic resonance signal is acquired at these different interleaved steady states.

5. Method according to any one of the previous claims , **characterized in that** several sets are transmitted sequentially, with:

- $\Delta$ the value of which differs between the different sets, and/or
- the amplitude of the radiofrequency pulse that follows a periodic series that differs between the different sets, so as to obtain different sequential steady states of the magnetization in the sample for different values of $\Delta$ and/or of the amplitude, of which there is at least one steady state per set, and **in that** the nuclear magnetic resonance signal is acquired at these different sequential steady states.

6. Device according to claim 5, **characterized in that** it comprises:

- an acquisition of a signal for two steady states corresponding to two identical amplitudes of the radiofrequency pulse but two different values of $\Delta$,
- a comparison of the signal for these two steady states, and
- deducing, from this comparison, whether the amplitude of the radiofrequency pulse produces an effective flip angle that is larger or smaller than or equal to the Ernst angle for the sample.

7. Method according to claim 6, **characterized in that** one of the two different values of $\Delta$ is equal to zero.

8. Method according to any one of claims 1 to 5, **characterized in that** it comprises:

- acquiring a signal for steady states corresponding to different amplitudes of the radiofrequency pulse and/or different values of $\Delta$ of different sets and/or different values of the periodic series $u_{n+1} = v_{n+1} - v_n$, and
- for at least one point in the sample, determining a nuclear magnetization, a magnetization flip angle, a diffusion coefficient, a longitudinal relaxation rate or time R1 or T1, and a transverse relaxation rate or time R2 or T2, based on a signal acquired for these steady states.

9. Method according to claim 8, **characterized in that** the determination is carried out either by comparison with a pre-calculated dictionary, or by iterative estimation, according to a minimization of a norm of the difference between the acquired signal expressed in complex form with a real part and an imaginary part, and a model of the signal expressed in complex form with a real part and an imaginary part.

10. Method according to claim 9, **characterized in that** the minimization comprises a least-square minimization, preferably using the Gauss-Newton algorithm applied to non-linear problems.

11. Method according to any one of claims 8 to 10, **characterized in that** it comprises acquiring a signal for steady states corresponding to different values of $\Delta$, including:

- several points, for an absolute value of $\Delta$ between $\Delta=0°$ inclusive and $\Delta=32°$ inclusive modulo 360°, and/or
- several points, for an absolute value of $\Delta$ between $\Delta=164°$ inclusive et $\Delta=196°$ inclusive modulo 360°, and/or
- several points, for an absolute value of $\Delta$ between $\Delta=112°$ inclusive et $\Delta=128°$ inclusive modulo 360°, and/or
- several points for an absolute value of $\Delta$ from 45°, 60°, 72°, 90°, and 144° inclusive modulo 360°.

12. Method according to any one of claims 8 to 11, **characterized in that** the amplitude of the radiofrequency pulse always corresponds to a magnetization flip angle:

- greater than the Ernst angle for a longitudinal relaxation time T1 equal to 2000 milliseconds, and
- less than or equal to 90°.

**13.** Method according to any one of claims 8 to 12, **characterized in that** the determination comprises a spatial continuity condition of the nuclear magnetization, the magnetization flip angle, the diffusion coefficient, the longitudinal relaxation rate or time R1 or T1, and the transverse relaxation rate or time R2 or T2, between different points of the sample.

**14.** Method according to any one of claims 1 to 13, **characterized in that** several sets are transmitted sequentially, and **in that**:

- the encoding direction differs between different sets, and/or
- the value of A differs between two sets, and/or
- the shape of the magnetic field gradient in the encoding direction differs between different sets.

**15.** Method according to claim 14, **characterized in that** it also comprises quantifying a diffusion coefficient in the sample or determining a predominant direction of diffusion in the sample or a weighting of the diffusion in the sample by making use of the difference in A and/or the encoding direction and/or gradient waveform between the different sets.

**16.** Device (1) for magnetic resonance imaging, comprising:

- means (2) for continuous application of a main magnetic field $B_0$ along a Z-axis on a sample area (8), and
- means (3) for transmitting a magnetic field gradient and means (4) for transmitting a radiofrequency pulse, and control means (5) arranged in order to control the means for transmitting a magnetic field gradient and the means for transmitting a radiofrequency pulse, the control means being arranged, or programmed, in order to carry out at least one set of repeated applications, on the sample area and according to a period TR, of a sequence, said sequence comprising:

  ◦ a radiofrequency pulse of variable amplitude and/or of variable phase at each repetition, and
  ◦ after the radiofrequency pulse of the sequence, a spatial gradient of the component along the Z-axis of the magnetic field,

the control means being arranged or programmed so that, during repeated applications of the radiofrequency pulse and of the magnetic field spatial gradient of the sequence of one and the same set:

- the radiofrequency pulse follows, between its different repeated applications, a periodic series:

  ◦ for its amplitude, and
  ◦ for $u_{n+1} = v_{n+1} - v_n$, where n is an integer greater than or equal to 1 representing the repetition number of the sequence for this set, and where $u_{n+1}$ is a relative integer series making it possible to define the series $v_n$ up to an arbitrary constant $v_1$ such that $\varphi_n = v_n \times \Delta$ and $\varphi_n = \theta_n - \theta_{n-1}$ with $\Delta$ which is a constant real number for all of the repeated applications of the sequence of this set and $\varphi_n$ which is the increment between the phase $\theta_n$ of the radiofrequency pulse at its nth repartition in this set and the phase $\theta_{n-1}$ of the radiofrequency pulse at its (n-1)th repartition in this set, with $\theta_0$ an arbitrary value, and

- each repeated application of the magnetic field spatial gradient of the sequence has, in a spatial gradient direction called encoding direction identical for each gradient application of this set, a non-zero temporal integral equal to A,

the device also comprising means (6) for acquiring, during at least one of the repetitions of the sequence, at least one nuclear magnetic resonance signal
**characterized in that** the control means are arranged or programmed to control the acquisition means (6) in order to acquire the nuclear magnetic resonance signal at different sequential and/or interleaved dynamic steady state of the magnetization in the sample area

- the control means being arranged or programmed so that, during repeated applications of the radiofrequency pulse and of the magnetic field spatial gradient of the sequence of one and the same set:

  ◦ the series $u_{n+1} = v_{n+1} - v_n$ is a non-constant periodic series, and/or
  ◦ the amplitude of the radiofrequency pulse follows a non-constant periodic series,

so as to obtain these different interleaved steady states of the magnetization in the sample area within this set respectively for different periodic values of the series $u_{n+1} = v_{n+1} - v_n$ and/or of the amplitude of the radiofrequency pulse, the control means also being arranged or programmed in order to control the acquisition means so as to acquire the nuclear magnetic resonance signal at these different interleaved steady states, and/or

- the control means are arranged or programmed so that several sets are transmitted sequentially, with:

  ∘ $\Delta$ the value of which differs between the different sets, and/or
  ∘ the amplitude of the radiofrequency pulse that follows a periodic series that differs between the different sets,

so as to obtain these different sequential steady states of the magnetization in the sample area for different periodic values of $\Delta$ and/or of the amplitude including at least one steady state per set, the control means also being arranged or programmed in order to control the acquisition means so as to acquire the nuclear magnetic resonance signal at these different sequential steady states.

17. Device according to claim 16, **characterized in that** the control means are arranged or programmed so that, during repeated applications of the radiofrequency pulse and of the magnetic field spatial gradient of the sequence of one and the same set, the series $u_{n+1} = v_{n+1} - v_n$ is a non-constant periodic series.

18. Device according to claim 16 or 17, **characterized in that** the control means are arranged or programmed so that, during repeated applications of the radiofrequency pulse and of the magnetic field spatial gradient of the sequence of one and the same set, the amplitude of the radiofrequency pulse follows a non-constant periodic series.

19. Device according to claim 17 or 18, **characterized in that** the control means are arranged or programmed so that, during repeated applications of the radiofrequency pulse and of the magnetic field spatial gradient of the sequence of one and the same set:

  - the series $u_{n+1} = v_{n+1} - v_n$ is a non-constant periodic series, and/or
  - the amplitude of the radiofrequency pulse follows a non-constant periodic series,

so as to obtain different interleaved steady states of the magnetization in the sample area within this set respectively for different periodic values of the series $u_{n+1} = v_{n+1} - v_n$ and/or of the amplitude of the radiofrequency pulse, the control means also being arranged or programmed in order to control the acquisition means so as to acquire the nuclear magnetic resonance signal at these different interleaved steady states.

20. Device according to any one of claims 16 to 19, **characterized in that** the control means are arranged or programmed so that several sets are transmitted sequentially, with:

  - $\Delta$ the value of which differs between the different sets, and/or
  - the amplitude of the radiofrequency pulse that follows a periodic series that differs between the different sets,

so as to obtain different sequential steady states of the magnetization in the sample area for different values of $\Delta$ and/or of the amplitude including at least one steady state per set, the control means also being arranged or programmed in order to control the acquisition means so as to acquire the nuclear magnetic resonance signal at these different sequential steady states.

21. Device according to claim 20, **characterized in that** the control means are arranged or programmed in order to control the acquisition means so as to acquire a signal for two steady states corresponding to two identical amplitudes of the radiofrequency pulses but two different values of $\Delta$,
the device also comprising calculation means (7) arranged or programmed in order to:

  - compare the signal for these two steady states, and
  - deduce, from this comparison, whether the amplitude of the radiofrequency pulse produces an effective flip angle that is larger or smaller than or equal to the Ernst angle in the sample area.

22. Device according to claim 21, **characterized in that** one of the two different values of $\Delta$ is equal to zero.

**23.** Device according to any one of claims 16 to 20, **characterized in that** the control means are arranged or programmed in order to control the acquisition means so as to acquire a signal for steady states corresponding to different amplitude of the radiofrequency pulses and/or two different values of $\Delta$ from different sets and/or different values of the periodic series $u_{n+1} = v_{n+1} - v_n$,

- the device also comprising calculation means (7) arranged or programmed in order to, for at least one point in the sample area, determine a nuclear magnetization, a magnetization flip angle, a diffusion coefficient, a longitudinal relaxation rate or time R1 or T1, and a transverse relaxation rate or time R2 or T2, based on a signal acquired for these steady states.

**24.** Device according to claim 23, **characterized in that** the calculation means are arranged or programmed in order to perform this determination, either by comparison with a pre-calculated dictionary, or by iterative estimation, according to a minimization of a norm of the difference between the acquired signal expressed in complex form with a real part and an imaginary part, and a model of the signal expressed in complex form with a real part and an imaginary part.

**25.** Device according to claim 24, **characterized in that** the minimization comprises a least-square minimization, preferably using the Gauss-Newton algorithm applied to non-linear problems.

**26.** Device according to any one of claims 23 to 25, **characterized in that** the control means are arranged or programmed in order to control the acquisition means so as to acquire a signal for steady states corresponding to two different values of $\Delta$ including:

- several points, for an absolute value of $\Delta$ between $\Delta=0°$ inclusive and $\Delta=32°$ inclusive modulo 360°, and/or
- several points, for an absolute value of $\Delta$ between $\Delta=164°$ inclusive et $\Delta=196°$ inclusive modulo 360°, and/or
- several points, for an absolute value of $\Delta$ between $\Delta=112°$ inclusive et $\Delta=128°$ inclusive modulo 360°, and/or
- several points for an absolute value of $\Delta$ from 45°, 60°, 72°, 90°, and 144° inclusive modulo 360°.

**27.** Device according to any one of claims 23 to 26, **characterized in that** the control means are arranged or programmed so that the amplitude of the radiofrequency pulse always corresponds to a magnetization flip angle:

- greater than the Ernst angle for a longitudinal relaxation time T1 equal to 2000 milliseconds, and
- less than or equal to 90°.

**28.** Device according to any one of claims 23 to 27, **characterized in that** the calculation means are arranged or programmed so that the determination comprises a spatial continuity condition of the nuclear magnetization, the magnetization flip angle, the diffusion coefficient, the longitudinal relaxation rate or time R1 or T1, and the transverse relaxation rate or time R2 or T2, between different points of the sample area.

**29.** Device according to any one of claims 16 to 28, **characterized in that** the control means are arranged or programmed in order to transmit several sets sequentially, so that:

- the encoding direction differs between different sets, and/or
- the value of A differs between two sets, and/or
- the shape of the magnetic field gradient in the encoding direction differs between different sets.

**30.** Device according to claim 29, **characterized in that** it also comprises calculation means (7) arranged or programmed for:

- quantifying a diffusion coefficient in the sample area or
- determining a predominant direction of diffusion in the sample area or
- weighting the diffusion in the sample area,

by exploiting the difference in A and/or the encoding direction and/or gradient waveform between the different sets.

FIG. 1

FIG. 10

FIG. 11a   FIG. 11b   FIG. 11c

FIG. 2a    FIG. 2b    FIG. 2c    FIG. 2d    FIG. 2e

FIG. 3

FIG. 4a

FIG. 4b

FIG. 4c

FIG. 4d

FIG. 5a

FIG. 5b

FIG. 5c

FIG. 5d

FIG. 5e

FIG. 5f

FIG. 6

FIG. 7

FIG. 8

FIG. 9a

FIG. 9b

EP 3 295 201 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2006152219 A1

**Littérature non-brevet citée dans la description**

- **MORI S ; ZHANG J.** rinciples of diffusion tensor imaging and its applications to basic neuroscience research. *Neuron,* 2006, vol. 51 (5), 527-539
- **ERNST RR ; BODENHAUSEN G ; WOKAUN A.** Principles of nuclear magnetic resonance in one and two dimensions. 1987, 125
- **DARRASSE L ; MAO L ; SAINT-JALMES H.** Steady-State management in Fast Low-Angle Imaging. *Proceedings of the International Society for Magnetic Resonance in Medicine,* 1986, 944
- **ZUR Y ; BENDEL P.** Elimination of the Steady State Transverse Magnetization in Short TR Imaging. *Proceedings of the International Society for Magnetic Resonance in Medicine,* 1987
- Spoiling of transverse magnetization in steady-state sequences. **ZUR Y ; WOOD ML ; NEURINGER LJ.** Magnetic resonance in medicine : official journal of the Society of Magnetic Resonance in Medicine. Society of Magnetic Resonance in Medicine, 1991, vol. 21, 251-263
- Elimination of transverse coherences in FLASH MRI. **CRAWLEY AP ; WOOD ML ; HENKELMAN RM.** Magnetic resonance in medicine : official journal of the Society of Magnetic Resonance in Medicine. Society of Magnetic Resonance in Medicine, 1988, vol. 8, 248-260
- **HENNIG J.** Echoes—how to generate, recognize, use or avoid them in MR-imaging sequences. Part I: Fundamental and not so fundamental properties of spin echoes. *Concept Magnetic Res,* 1991, vol. 3 (3), 125-143
- **HENNIG J.** Echoes—how to generate, recognize, use or avoid them in MR-imaging sequences. Part II: Echoes in imaging sequences. *Concept Magnetic Res,* 1991, vol. 3 (4), 179-192
- **SCHEFFLER K.** A pictorial description of steady-states in rapid magnetic resonance imaging. *Concept Magnetic Res,* 1999, vol. 11 (5), 291-304
- **WEIGEL M.** Extended phase graphs: Dephasing, RF pulses, and echoes - pure and simple. *Journal of magnetic resonance imaging : JMRI,* 2014

- **PAULY J ; LEROUX P ; NISHIMURA D ; MACOVSKI A.** Parameter Relations for the Shinnar-Leroux Selective Excitation Pulse Design Algorithm. *Ieee T Med Imaging,* 1991, vol. 10 (1), 53-65
- Stabilization of echo amplitudes in FSE sequences. **LE ROUX P ; HINKS RS.** Magnetic resonance in medicine : official journal of the Society of Magnetic Resonance in Medicine. Society of Magnetic Resonance in Medicine, 1993, vol. 30, 183-190
- **LE ROUX P.** Simplified model and stabilization of SSFP sequences. *Journal of magnetic resonance,* 2003, vol. 163 (1), 23-37
- Analytical solution to the transient phase of steady-state free precession sequences. **GANTER C.** Magnetic resonance in medicine : official journal of the Society of Magnetic Resonance in Medicine. Society of Magnetic Resonance in Medicine, 2009, vol. 62, 149-164
- B1+-mapping with the transient phase of unbalanced steady-state free precession. **GANTER C ; SETTLES M ; DREGELY I ; SANTINI F ; SCHEFFLER K ; BIERI O.** Magnetic resonance in medicine : official journal of the Society of Magnetic Resonance in Medicine. Society of Magnetic Resonance in Medicine, 2013
- Influence of RF spoiling on the stability and accuracy of T1 mapping based on spoiled FLASH with varying flip angles. **PREIBISCH C ; DEICHMANN R.** Magnetic resonance in medicine : official journal of the Society of Magnetic Resonance in Medicine. Society of Magnetic Resonance in Medicine, 2009, vol. 61, 125-135
- **LIBERMAN G ; LOUZOUN Y ; BEN BASHAT D.** T(l) mapping using variable flip angle SPGR data with flip angle correction. *Journal of magnetic resonance imaging : JMRI,* 2014, vol. 40 (1), 171-180
- **FRAM EK ; HERFKENS RJ ; JOHNSON GA ; GLOVER GH ; KARIS JP ; SHIMAKAWA A ; PERKINS TG ; PELC NJ.** Rapid calculation of T1 using variable flip angle gradient refocused imaging. *Magnetic resonance imaging,* 1987, vol. 5 (3), 201-208

- Improved signal spoiling in fast radial gradient-echo imaging: Applied to accurate T(l) mapping and flip angle correction. **LIN W ; SONG HK.** Magnetic resonance in medicine : official journal of the Society of Magnetic Resonance in Medicine. Society of Magnetic Resonance in Medicine, 2009, vol. 62, 1185-1194
- **SCHABEL MC ; MORRELL GR.** Uncertainty in T(l) mapping using the variable flip angle method with two flip angles. *Physics in medicine and biology,* 2009, vol. 54 (1), N1-8
- Simultaneous variable flip angle-actual flip angle imaging method for improved accuracy and precision of three-dimensional T1 and B1 measurements. **HURLEY SA ; YARNYKH VL ; JOHNSON KM ; FIELD AS ; ALEXANDER AL ; SAMSONOV AA.** Magnetic resonance in medicine : official journal of the Society of Magnetic Resonance in Medicine. Society of Magnetic Resonance in Medicine, 2012, vol. 68, 54-64
- On the steady-state properties of actual flip angle imaging (AFI). **NEHRKE K.** Magnetic resonance in medicine : official journal of the Society of Magnetic Resonance in Medicine. Society of Magnetic Resonance in Medicine, 2009, vol. 61, 84-92
- **HANICKE W ; VOGEL HU.** An analytical solution for the SSFP signal in MRI. *Magnetic Resonance in Medicine,* 2003, vol. 49 (4), 771-775
- A new steady-state imaging sequence for simultaneous acquisition of two MR images with clearly different contrasts. **BRUDER H ; FISCHER H ; GRAUMANN R ; DEIMLING M.** Magnetic resonance in medicine : official journal of the Society of Magnetic Resonance in Medicine. Society of Magnetic Resonance in Medicine, 1988, vol. 7, 35-42
- Quantitative in vivo diffusion imaging of cartilage using double echo steady-state free precession. **BIERI O ; GANTER C ; SCHEFFLER K.** Magnetic resonance in medicine : official journal of the Society of Magnetic Resonance in Medicine. Society of Magnetic Resonance in Medicine, 2012, vol. 68, 720-729
- Rapid estimation of cartilage T with reduced T sensitivity using double echo steady state imaging. **HEULE R ; GANTER C ; BIERI O.** Magnetic resonance in medicine : official journal of the Society of Magnetic Resonance in Medicine. Society of Magnetic Resonance in Medicine, 2013
- Triple echo steady-state (TESS) relaxometry. **HEULE R ; GANTER C ; BIERI O.** Magnetic resonance in medicine : official journal of the Society of Magnetic Resonance in Medicine. Society of Magnetic Resonance in Medicine, 2014, vol. 71, 230-237
- **KAISER R ; BARTHOLDI E ; ERNST RR.** Diffusion and field-gradient effects in NMR Fouirer spectroscipy. *The Journal of Chemical Physics,* 1974, vol. 60 (8), 2966-2979
- MRI of "diffusion" in the human brain: new results using a modified CE-FAST sequence. **MERBOLDT KD ; BRUHN H ; FRAHM J ; GYNGELL ML ; HANICKE W ; DEIMLING M.** Magnetic resonance in medicine : official journal of the Society of Magnetic Resonance in Medicine. Society of Magnetic Resonance in Medicine, 1989, vol. 9, 423-429
- The diffusion sensitivity of fast steady-state free precession imaging. **BUXTON RB.** Magnetic resonance in medicine : official journal of the Society of Magnetic Resonance in Medicine. Society of Magnetic Resonance in Medicine, 1993, vol. 29, 235-243
- A new diffusion SSFP imaging technique. **ZUR Y ; BOSAK E ; KAPLAN N.** Magnetic resonance in medicine : official journal of the Society of Magnetic Resonance in Medicine. Society of Magnetic Resonance in Medicine, 1997, vol. 37, 716-722
- **FREED DE ; SCHEVEN UM ; ZIELINSKI LJ ; SEN PN ; HURLIMANN MD.** Steady-state free precession experiments and exact treatment of diffusion in a uniform gradient. *J Chem Phys,* 2001, vol. 115 (9), 4249-4258
- **DEIMLING M.** *Method to determine the ADC coefficients in diffusion-weighted magnetic resonance imaging given use of steady-state sequences,* 2005
- Steady state of gradient echo sequences with radiofrequency phase cycling: analytical solution, contrast enhancement with partial spoiling. **GANTER C.** Magnetic resonance in medicine : official journal of the Society of Magnetic Resonance in Medicine. Society of Magnetic Resonance in Medicine, 2006, vol. 55, 98-107
- Quantitative mapping of T2 using partial spoiling. **BIERI O ; SCHEFFLER K ; WELSCH GH ; TRATTNIG S ; MAMISCH TC ; GANTER C.** Magnetic resonance in medicine : official journal of the Society of Magnetic Resonance in Medicine. Society of Magnetic Resonance in Medicine, 2011, vol. 66, 410-418
- Factors controlling T2 mapping from partially spoiled SSFP sequence: optimization for skeletal muscle characterization. **DE SOUSA PL ; VIGNAUD A ; CALDAS DE ALMEIDA ARAUJO E ; CARLIER PG.** Magnetic resonance in medicine : official journal of the Society of Magnetic Resonance in Medicine. Society of Magnetic Resonance in Medicine, 2012, vol. 67, 1379-1390
- **LIU WJ ; WANG YL ; XIE WC.** Fisher information matrix, Rao test, and Wald test for complex-valued signals and their applications. *Signal Process,* 2014, vol. 94, 1-5
- **LORI NF ; CONTURO TE ; LE BIHAN D.** Definition of displacement probability and diffusion time in q-space magnetic resonance measurements that use finite-duration diffusion-encoding gradients. *Journal of magnetic resonance,* 2003, vol. 165 (2), 185-195

- **WEIGEL M ; SCHWENK S ; KISELEV VG ; SCHEFFLER K ; HENNIG J.** Extended phase graphs with anisotropic diffusion. *Journal of magnetic resonance,* 2010, vol. 205 (2), 276-285
- **KUWATA K ; BROOKS D ; YANG H ; SCHLEICH T.** Relaxation-matrix formalism for rotating-frame spin-lattice proton NMR relaxation and magnetization transfer in the presence of an off-resonance irradiation field. *Journal of magnetic resonance Series B,* 1994, vol. 104 (1), 11-25
- SENSE: sensitivity encoding for fast MRI. **PRUESSMANN KP ; WEIGER M ; SCHEIDEGGER MB ; BOESIGER P.** Magnetic resonance in medicine : official journal of the Society of Magnetic Resonance in Medicine. Society of Magnetic Resonance in Medicine, 1999, vol. 42, 952-962
- Sparse MRI: The application of compressed sensing for rapid MR imaging. **LUSTIG M ; DONOHO D ; PAULY JM.** Magnetic resonance in medicine : official journal of the Society of Magnetic Resonance in Medicine. Society of Magnetic Resonance in Medicine, 2007, vol. 58, 1182-1195
- **MA D ; GULANI V ; SEIBERLICH N ; LIU KC ; SUNSHINE JL ; DUERK JL ; GRISWOLD MA.** Magnetic resonance fingerprinting. *Nature,* 2013, vol. 495 (7440), 187-192